(19) Europäisches Patentamt
European Patent Office
Office européen des brevets

(11) EP 3 323 159 B1

(12) # EUROPEAN PATENT SPECIFICATION

(45) Date of publication and mention of the grant of the patent:
**04.01.2023 Bulletin 2023/01**

(21) Application number: **16733298.0**

(22) Date of filing: **21.06.2016**

(51) International Patent Classification (IPC):
***H01L 51/54*** *(2006.01)* ***H01L 51/56*** *(2006.01)*
***H01L 51/30*** *(2006.01)* ***H01L 51/40*** *(2006.01)*
***H01L 51/46*** *(2006.01)* ***H01L 51/48*** *(2006.01)*

(52) Cooperative Patent Classification (CPC):
**C09K 11/06; H01L 51/0005; H01L 51/0007;**
H01L 51/0055; H01L 51/0085; H01L 51/0087;
H01L 51/0094; H01L 51/0512; H01L 51/42;
H01L 51/5016; H01L 51/5048; Y02E 10/549

(86) International application number:
**PCT/EP2016/001057**

(87) International publication number:
**WO 2017/008883 (19.01.2017 Gazette 2017/03)**

(54) **COMPOSITION COMPRISING ORGANIC SEMICONDUCTING COMPOUNDS**
ZUSAMMENSETZUNGEN MIT ORGANISCHEN HALBLEITERVERBINDUNGEN
COMPOSITION COMPRENANT DES COMPOSÉS SEMI-CONDUCTEURS ORGANIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.07.2015 EP 15002097**

(43) Date of publication of application:
**23.05.2018 Bulletin 2018/21**

(73) Proprietor: **Merck Patent GmbH**
**64293 Darmstadt (DE)**

(72) Inventors:
- **MAY, Philip Edward**
  **Sidcup DA15 9AS (GB)**
- **WALKER, Daniel**
  **Southampton SO16 3TZ (GB)**

(56) References cited:
**EP-A1- 1 894 976** **EP-A1- 2 843 015**
**EP-A2- 1 191 612** **JP-A- 2012 048 844**
**US-A1- 2013 216 724**

- **GARCIA B ET AL: "Densities and viscosities of mixing for the binary system of methyl benzoate with n-nonane at different temperatures", THERMOCHIMICA ACTA, ELSEVIER SCIENCE PUBLISHERS, AMSTERDAM, NL, vol. 186, no. 2, 25 September 1991 (1991-09-25), pages 285-292, XP026579150, ISSN: 0040-6031, DOI: 10.1016/0040-6031(91)87045-X [retrieved on 1991-09-25]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 323 159 B1

## Description

### Field of the Invention

The present invention relates to novel compositions comprising organic semiconducting compounds (OSC) and organic solvents, to their use as conducting inks for the preparation of organic electronic (OE) devices, especially organic photovoltaic (OPV) cells and OLED devices, to methods for preparing OE devices using the novel formulations, and to OE devices and OPV cells prepared from such methods and compositions.

### Background and Prior Art

When preparing OE devices like OLEDs, OFETs or OPV cells, having a high resolution, usually vapour techniques are used to apply the OSC layer. However, these techniques are expensive, wasteful of the OSC, limited in production size and thus prevent easy and cheap production of high quantities of these devices.

Using conventional ink-jet printing techniques for applying layers on substrates which have a high resolution leads to a low quality of the finished product. Although there are many documents disclosing ink jet printing for obtaining OE devices, in the knowledge of the present inventors no prior art concerns ink jet printing using a droplet size below 10 pl.

Therefore, it is an object of the present invention to solve the problems of the prior art as mentioned above.

It is an object to provide a composition for ink jet printing at high resolution (high number of pixels per inch).

Furthermore, a method for the production of OE devices is provided, said method having a high resolution matrix, especially a high resolution emitting layer in an economic manner. Furthermore, it is a permanent desire to improve the performance of the OE device, especially the OLED layer, such as efficiency, lifetime and sensitivity regarding oxidation or water.

In addition thereto, the formulation should enable a low-cost and easy printing process. The printing process should allow a high quality printing at high speed.

The formulations should be useful for producing small droplets, especially in the pico liter range in a continuous and reproducible manner for enabling printing process for achieving high resolution display devices.

It is therefore desirable to have improved formulations comprising an OSC that are suitable for the preparation of OE devices, especially thin film transistors, diodes, OLED displays and OPV cells, which allow the manufacture of highly efficient OE devices having a high performance, a long lifetime and a low sensitivity against water or oxidation. One aim of the present invention is to provide such improved formulations. Another aim is to provide improved methods of preparing an OE device from such formulations. Another aim is to provide improved OE devices obtained from such formulations and methods. Further aims are immediately evident to the person skilled in the art from the following description.

Surprisingly it has been found that these aims can be achieved, and the above-mentioned problems can be solved, by providing a formulation of the present invention.

### Summary of the Invention

The invention relates to a composition comprising one or more organic semiconducting compounds (OSC), and organic solvents, wherein said composition comprises a mixture of at least two different solvents wherein the first organic solvent has a boiling point in the range of 235 to 320°C and and a relative evaporation rate (RER; based on butyl acetate = 100) of at most 0.6 and the second organic solvent has a relative evaporation rate (RER; based on butyl acetate = 100) in the range of 0.65 to 10.0 and the solvent mixture comprises at least 50 % by weight of the first organic solvent, characterized in that the first organic solvent is an aromatic ether solvent and in that the second organic solvent is an aromatic ester compound.

The invention further relates to the use of a composition as described above and below as coating or printing ink for the preparation of OLED devices, in particular for rigid and flexible OLED devices.

Furthermore, there is provided a process of preparing an organic electronic (OE) device, comprising the steps of

a) depositing the composition as described above and below onto a substrate to form a film or layer, preferably by coating or printing, very preferably by ink jet printing,
b) removing the solvent(s).

The OE devices include, without limitation, organic field effect transistors (OFET), integrated circuits (IC), thin film transistors (TFT), Radio Frequency Identification (RFID) tags, organic light emitting diodes (OLED), organic light emitting transistors (OLET), electroluminescent displays, organic photovoltaic (OPV) cells, organic solar cells (O-SC), flexible OPVs and O-SCs, organic laserdiodes (O-laser), organic integrated circuits (O-IC), lighting devices, sensor

devices, electrode materials, photoconductors, photodetectors, electrophotographic recording devices, capacitors, charge injection layers, Schottky diodes, planarising layers, antistatic films, conducting substrates, conducting patterns, photoconductors, electrophotographic devices, organic memory devices, biosensors and biochips.

The OE device may be an organic light emitting diodes (OLED). OLED devices can for example be used for illumination, for medical illumination purposes, as signalling device, as signage devices, and in displays. Displays can be addressed using passive matrix driving, total matrix addressing or active matrix driving. Transparent OLEDs can be manufactured by using optically transparent electrodes. Flexible OLEDs are assessable through the use of flexible substrates.

Surprisingly, the present composition provides inks for preparing high resolution displays. The composition enables the printing with droplets having a volume of at most 5 pl (pico liter), more preferably at most of 2 pl and especially preferably at most 1 pl.

The formulations, methods and devices provide surprising improvements in the efficiency of the OE devices and the production thereof. Unexpectedly, the performance, the lifetime and the efficiency of the OE devices can be improved, if these devices are achieved by using a composition of the present invention. Furthermore, it was surprisingly found that these formulations are suitable for printing techniques, especially for ink jet printing. Furthermore, the composition of the present invention provides an astonishingly high level of film forming. Especially, the homogeneity and the quality of the films can be improved.

In addition thereto, the formulations enable a low-cost and easy printing process. The printing processes allow a high quality printing at high speed.

## Detailed Description of the Invention

The composition of the present invention comprises a mixture of at least two different solvents wherein the first organic solvent has a boiling point in the range of 235 to 320°C and and a relative evaporation rate (RER) of at most 0.6 and the second organic solvent has a relative evaporation rate (RER) in the range of 0.65 to 10.0 and the solvent mixture comprises at least 50 % by weight of the first organic solvent.

The relative evaporation rate (based on butyl acetate = 100) of the first organic solvent at most 0.6, more preferably at most 0.4, especially preferably in the range from 0.0001 to 0.4 and particularly preferably in the range from 0.0005 to 0.1. The relative evaporation rate can be determined according to DIN 53170:2009-08. For the purpose for making a rough estimate, the relative evaporation rate can be calculated using the Hansen Solubility Parameters with the HSPiP program as mentioned above and below.

In an embodiment of the present invention, the vapour pressure at 25°C of the first organic solvent is preferably in the range from 0.0001 to 0.07 mm Hg (1 mm Hg = 133.3 Pa), preferably in the range from 0.0005 to 0.050 mm Hg. The vapour pressure (VP) can be determined using a Knudsen-Cell as suggested in the OECD guideline 104. For the purpose for making a rough estimate, the relative evaporation rate can be calculated using the Hansen Solubility Parameters with the HSPiP program version 4 as mentioned above and below.

Preferred first organic solvents can exhibit Hansen Solubility parameters of $H_d$ in the range of 16.0 to 23.2 $MPa^{0.5}$, $H_p$ in the range of 0.0 to 12.5 $MPa^{0.5}$ and $H_h$ in the range of 0.0 to 14.2 $MPa^{0.5}$. More preferred first organic solvents exhibit Hansen Solubility parameters of $H_d$ in the range of 16.5 to 21.0 $MPa^{0.5}$, $H_p$ in the range of 0.0 to 6.0 $MPa^{0.5}$ and $H_h$ in the range of 0.0 to 6.0 $MPa^{0.5}$.

The first organic solvent has a boiling point in the range of 235 to 320°C, preferably in the range of 260 to 300°C, more preferably in the range of 270 to 290°C, at the pressure employed, very preferably at atmospheric pressure (1013 hPa). Evaporation can also be accelerated e.g. by applying heat and/or reduced pressure.

Preferably, the first organic solvent has a viscosity at 25°C in the range of 0.9 to 10 mPas, especially 1.0 to 8 mPas, more preferably in the range of 1.1 to 7 mPas and most preferably in the range of 1.2 to 6 mPas. In a further embodiment the first organic solvent has a viscosity at 25°C of at most 7 mPas, preferably at most 6 mPas. The viscosity is determined at a temperature of 25°C by measuring on AR-G2 rheometer manufactured by TA Instruments. This measurement can be done over a shear range of 10 to 1000 $s^{-1}$ using 40 mm parallel plate geometry. Viscosity is taken as an average reading between $200s^{-1}$ - $800s^{-1}$.

The following table presents the boiling points, viscosities and RER of some organic solvents.

| Solvent | Bpt (°C) | VP at 25°C (mm Hg) | RER |
|---|---|---|---|
| Bicyclohexyl | 239 | 0.068 | 0.592 |
| Cyclohexyl Benzene | 240 | 0.066 | 0.516 |

| Solvent | Bpt (°C) | VP at 25°C (mm Hg) | RER |
|---|---|---|---|
| 1,1,3,3,5-Pentamethylindan | 257 | 0.037 | 0.353 |
| Dicyclohexylmethane | 264 | 0.036 | 0.342 |
| 1,2,3,5-Tetraethylbenzene | 256 | 0.032 | 0.318 |
| Butyl Benzoate | 250 | 0.006 | 0.3 |
| 1-Ethylnaphthalene | 253 | 0.023 | 0.166 |
| 2,2,5,7-Tetramethyltetraline | 274 | 0.017 | 0.159 |
| Isopentyl Benzoate | 252 | 0.013 | 0.121 |
| 1-Butyl-[1,2,3,4-Tetrahydronaphthalene] | 267 | 0.01 | 0.094 |
| Octylbenzene | 265 | 0.007 | 0.076 |
| 1-Propylnaphthalene | 273 | 0.009 | 0.069 |
| Amyl Benzoate | 260 | 0.007 | 0.066 |
| 3-Benzyl-4-Heptanone | 282 | 0.007 | 0.066 |
| 1,2-Dimethylnaphthalene | 262 | 0.006 | 0.046 |
| Isopropyl Cinnamate | 265 | 0.004 | 0.037 |
| 1-Sec-Butylnaphthalene | 286 | 0.004 | 0.036 |
| Benzyl Valerate | 254 | 0.004 | 0.035 |
| 1-Butylnaphthalene | 292 | 0.003 | 0.025 |
| Nonylbenzene | 280 | 0.002 | 0.023 |
| Ethyl Cinnamate | 271 | 0.002 | 0.019 |
| Benzyl Hexanoate | 269 | 0.001 | 0.01 |
| Pentaethylbenzene | 293 | 0.001 | 0.01 |
| Decylbenzene | 294 | 0.001 | 0.009 |
| 2,6-Diethylnaphthalene | 299 | 0.001 | 0.008 |
| 3-Phenoxy toluene | 273 | 0.001 | 0.001 |
| Benzyl Heptanoate | 284 | 0.001 | 0.004 |
| Benzyl Octanoate | 299 | 0.001 | 0.001 |
| Octyl benzoate | 312 | 0.001 | 0.003 |

In a preferred embodiment of the present invention, the first organic solvent comprises two aryl groups being separated by a group being selected from -O-, -(C=O)-, or -(C=O)-O-.

The first organic solvent is an aromatic ether solvent, more preferably, the first organic solvent comprises a structure according to the following formula:

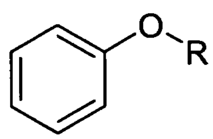

wherein R is selected from the group consisting of straight-chain alkyl or alkenyl groups having from 1 to 12 carbon atoms, branched-chain alkyl or alkenyl groups having from 3 to 12 carbon atoms and cyclic alkyl or alkenyl groups having from 3 to 12 carbon atoms, wherein one or more non-adjacent $CH_2$ groups may be optionally replaced by -O-, -(C=O)-, or - (C=O)-O-, or aryl, and aryl or heteroaryl groups having from 4 to 6 carbon atoms, wherein one or more hydrogen

atoms may be optionally replaced by a straight-chain alkyl group having from 1 to 12 carbon atoms or a branched-chain alkyl group having from 3 to 12 carbon atoms. Preferably, the group R of the formula describing a preferred first organic solvent comprises an aryl or heteroaryl group, more preferably an aryl group.

According to a very preferred embodiment of the present invention, the first solvent is 3-phenoxy toluene:

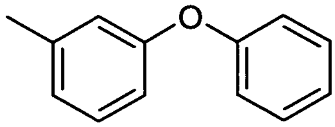

The composition comprises at least 50 % by weight of the first solvent, preferably at least 60 % by weight and especially at least 70 % by weight of the first organic solvent.

The first organic solvent can be used as mixture of 2, 3, 4 or more different solvents meeting the requirements as mentioned above in connection with the description of the first organic solvent.

In addition to the first organic solvent, the composition of the present invention comprises a second organic solvent.

The relative evaporation rate (based on butyl acetate = 100) of the second organic solvent is in the range from 0.65 to 10, preferably 0.7 to 8 and more preferably in the range from 1 to 7. The relative evaporation rate can be determined according to DIN 53170:2009-08. For the purpose for making a rough estimate, the relative evaporation rate can be calculated using the Hansen Solubility Parameters with the HSPiP program as mentioned above and below.

Preferably the second organic solvent has a boiling point in the range of 170 to 300°C, more preferably in the range of 180 to 270°C, especially preferably in the range of 200 to 250°C and most preferably in the range of 210 to 240°C, at the pressure employed, very preferably at atmospheric pressure (1013 hPa). Evaporation can also be accelerated e.g. by applying heat and/or reduced pressure.

Preferably, the boiling point of the first organic solvent is at least 10°C, more preferably at least 20°C and especially preferably at least 30°C higher than the boiling point of the second organic solvent.

In an embodiment of the present invention, the vapour pressure at 25°C of the second organic solvent is preferably in the range from 0.07 to 1.00 mm Hg, preferably in the range from 0.07 to 0.40 mm Hg. The vapour pressure can be determined using a Knudsen-Cell as suggested in the OECD guideline 104. For the purpose for making a rough estimate, the relative evaporation rate can be calculated using the Hansen Solubility Parameters with the HSPiP program as mentioned above and below.

Preferably, the composition comprises 1 to 40, more preferably 3 to 30 and especially preferably 10 to 25 % by weight of the second organic solvent.

Preferred second organic solvents can exhibit Hansen Solubility parameters of $H_d$ in the range of 14.0 to 23.2 $MPa^{0.5}$, $H_p$ in the range of 0.0 to 12.5 $MPa^{0.5}$ and $H_h$ in the range of 0.0 to 14.2 $MPa^{0.5}$. More preferred second organic solvents exhibit Hansen Solubility parameters of $H_d$ in the range of 15.0 to 23.0 $MPa^{0.5}$, $H_p$ in the range of 0.0 to 8.0 $MPa^{0.5}$ and $H_h$ in the range of 0.0 to 8.0 $MPa^{0.5}$.

Preferably, the second organic solvent has a viscosity at 25°C in the range of 0.9 to 10 mPas, especially 1.0 to 5 mPas, more preferably in the range of 1.1 to 4 mPas and most preferably in the range of 1.2 to 3 mPas. In a further embodiment the second organic solvent has preferably a viscosity at 25°C of at most 6 mPas, more preferably at most 5 mPas, even more preferably at most 4 mPas, especially preferably at most 3 mPas. The viscosity is determined at a temperature of 25°C by measuring on AR-G2 rheometer manufactured by TA Instruments. This measurement can be done over a shear range of 10 to 1000 $s^{-1}$ using 40 mm parallel plate geometry.

The following table presents the boiling points, viscosities and RER of some organic solvents.

| Solvent | Bpt (°C) | VP at 25°C (mm Hg) | RER |
|---|---|---|---|
| 1,2,3-Trimethyl-4-Ethylbenzene | 208 | 0.378 | 2.926 |
| 1-Methyl-2-Isobutylbenzene | 201 | 0.33 | 2.645 |
| 1-Ethyl-3-Propylbenzene | 204 | 0.35 | 2.433 |
| 1,2-Dimethyl-3-Propylbenzene | 204 | 0.302 | 2.381 |
| Pentylbenzene | 204 | 0.264 | 2.1 |
| Methyl Benzoate | 200 | 0.353 | 2.036 |
| Butyl Phenyl Ether | 209 | 0.213 | 1.604 |

(continued)

| Solvent | Bpt (°C) | VP at 25°C (mm Hg) | RER |
|---|---|---|---|
| p-n-Butyltoluene | 207 | 0.177 | 1.409 |
| 1,2,3-Triethylbenzene | 220 | 0.136 | 1.174 |
| Ethyl Benzoate | 213 | 0.168 | 1.117 |
| Hexylbenzene | 224 | 0.087 | 0.756 |
| Benzylacetone | 234 | 0.106 | 0.741 |

According to the present invention, the second organic solvent is an aromatic ester compound. More preferably, the second organic solvent is selected from the list consisting of: methyl benzoate, ethyl benzoate, butyl phenylether.

The second organic solvent can be used as mixture of 2, 3, 4 or more different solvents meeting the requirements as mentioned above in connection with the description of the second organic solvent.

Surprisingly, the inventors have found that the combination of two solvents having different RER values enable the ink jet printing of highly defined structures as mentioned above and below. The first solvents mentioned above, preferably 3-phenoxy toluene, are known to be good ink-jetting solvents, however they have conventionally a high viscosity (~5 mPas) such that these solvents are not able to provide a good ink jet printing result as a single solvent. Addition of solvents having a lower viscosity, such as anisole do not resolve that problem. The inventors assume that the high volatility of anisole compared to the 3-phenoxy toluene causes an increased vapour pressure very close to the nozzle plate and it is this that effects the jetting performance. Surprisingly, the inventors found that using a second solvent having a RER value in the range of 0.65 to 10.0 (based on butyl acetate = 100) provide an astonishingly good printing result.

For comparative purposes

| Solvent (2nd solvent) | Bpt (°C) | VP at 25°C (mm HG) | RER |
|---|---|---|---|
| Anisole | 154 | 3.4 | 17.1 |

Usually, the organic solvent blend can comprise a surface tension in the range of 15 to 80 mN/m, especially in the range of 20 to 60 mN/m and preferably in the range of 25 to 40 mN/m. The surface tension can be measured using a FTA (First Ten Angstrom) 1000 contact angle goniometer at 25°C. Details of the method are available from First Ten Angstrom as published by Roger P. Woodward, Ph.D. "Surface Tension Measurements Using the Drop Shape Method". Preferably, the pendant drop method can be used to determine the surface tension.

The composition of the present invention can particularly comprise at least 70 % by weight, especially at least 80 % by weight and preferably at least 90 % by weight of organic solvents.

The present formulation comprises at least one organic semiconducting compound (OSC). The OSC compounds can be selected from standard materials known to the skilled person and described in the literature.

The OSC may be a monomeric compound (also referred to as "small molecule", as compared to a polymer or macromolecule), or a mixture, dispersion or blend containing one or more compounds selected from monomeric compounds. Furthermore the OSC may be a polymeric material as mentioned below. In addition thereto, the OSC may be a mixture, dispersion or blend containing one or more compounds selected from polymeric compounds. Furthermore, the OSC may be a mixture, dispersion or blend containing at least one monomeric OSC compound and at least one polymeric compound.

According to an aspect of the present invention, the OSC is preferably a conjugated aromatic molecule, and contains preferably at least three aromatic rings, which can be fused or unfused. Unfused rings are connected e.g. via a linkage group, a single bond or a spiro-linkage. Preferred monomeric OSC compounds contain one or more rings selected from the group consisting of 5-, 6- or 7-membered aromatic rings, and more preferably contain only 5- or 6-membered aromatic rings.

Each of the aromatic rings optionally contains one or more hetero atoms selected from Se, Te, P, Si, B, As, N, O or S, preferably from N, O or S.

The aromatic rings may be optionally substituted with alkyl, alkoxy, polyalkoxy, thioalkyl, acyl, aryl or substituted aryl groups, halogen, particularly fluorine, cyano, nitro or an optionally substituted secondary or tertiary alkylamine or aryl-amine represented by -N($R^x$)($R^y$), where $R^x$ and $R^y$ independently of each other denote H, optionally substituted alkyl, optionally substituted aryl, alkoxy or polyalkoxy groups. Where $R^x$ and/or $R^y$ denote alkyl or aryl these may be optionally fluorinated.

Preferred rings are optionally fused, or are optionally linked with a conjugated linking group such as $-C(T^1)=C(T^2)-$, -C=C- $-N(R^z)-$, -N=N-, $-(R^z)C=N-$, $-N=C(R^z)-$, wherein $T^1$ and $T^2$ independently of each other denote H, Cl, F, -C=N- or a lower alkyl group, preferably a $C_{1-4}$ alkyl group, and $R^z$ denotes H, optionally substituted alkyl or optionally substituted aryl. Where $R^z$ is alkyl or aryl these may be optionally fluorinated.

Preferred OSC compounds include small molecules (i.e. monomeric compounds), selected from condensed aromatic hydrocarbons such as tetracene, chrysene, pentacene, pyrene, perylene, coronene, or soluble substituted derivatives of the aforementioned; oligomeric para substituted phenylenes such as p-quaterphenyl (p-4P), p-quinquephenyl (p-5P), p-sexiphenyl (p-6P), or soluble substituted derivatives of the aforementioned; pyrazoline compounds; benzidine compounds; stilbene compounds; triazines; substituted metallo- or metal-free porphines, phthalocyanines, fluorophthalocyanines, naphthalocyanines or fluoronaphthalocyanines; $C_{60}$ and $C_{70}$ fullerenes or derivatives thereof; *N,N'*-dialkyl, substituted dialkyl, diaryl or substituted diaryl-1,4,5,8-naphthalenetetracarboxylic diimide and fluoro derivatives; *N,N'*-dialkyl, substituted dialkyl, diaryl or substituted diaryl 3,4,9,10-perylenetetracarboxylic diimide; bathophenanthroline; diphenoquinones; 1,3,4-oxadiazoles; 11,11,12,12-tetracyanonaptho-2,6-quinodimethane; $\alpha,\alpha'$-bis(dithieno[3,2-b:2',3'-d]thiophene); 2,8-dialkyl, substituted dialkyl, diaryl or substituted diaryl anthradithiophene; 2,2'-bibenzo[1,2-b:4,5-b']dithiophene. Preferred compounds are those from the above list and derivatives thereof which are soluble.

Especially preferred OSC materials are substituted polyacenes, such as 6,13-bis(trialkylsilylethynyl)pentacene or derivatives thereof, such as 5,11-bis(trialkylsilylethynyl)anthradithiophenes, as described for example in US 6,690,029, WO 2005/055248 A1, or WO 2008/107089 A1. A further preferred OSC material is poly(3-substituted thiophene), very preferably poly(3-alkylthiophenes) (P3AT) wherein the alkyl group is preferably straight-chain and preferably has 1 to 12, most preferably 4 to 10 C-atoms, like e.g. poly(3-hexylthiophene).

The OSC materials useful for performing the present invention as mentioned above and below may comprise a curable group. A curable group means a functional group being able to react irreversible in order to form a cross-linked material being insoluble. The cross-linking can be sustained by heating or UV-, microwave, x-ray or electron beam irradiation. Preferably, only a small amount of by-products is formed. Furthermore, the curable groups enable an easy cross-linking such that only small amounts of energy is needed in order to obtain cross-linking (e.g. < 200°C for thermic crosslinking).

Examples for curable groups are units comprising a double bond, a triple bond, precursors for forming double and/or triple bonds, units comprising a heterocyclic residue being able for addition polymerization.

Curable groups include e.g. vinyl, alkenyl, preferably ethenyl and propenyl, $C_{4-20}$-cycloalkenyl, azid, oxirane, oxetane, di(hydrocarbyl)amino, cyanat ester, hydroxy, glycidyl ether, $C_{1-10}$-alkylacrylat, $C_{1-10}$-alkylmeth acrylat, alkenyloxy, preferably ethenyloxy, perfluoro alkenyloxy, preferably perfluorethenyloxy, alkinyl, preferably ethinyl, maleic imid, tri($C_{1-4}$)-alkylsiloxy and tri($C_{1-4}$)-alkylsilyl. Especially preferred are vinyl und alkenyl.

The composition according to the present invention can comprise between 0.01 and 20% by weight, preferably between 0.1 and 15% by weight, more preferably between 0.2 and 10% by weight, especially preferably 0.5 to 7 % by weight, particularly preferably 1 to 6 % by weight and most preferably 2 to 5% by weight of the organic semiconducting compound, preferably having a molecular weight of at most 5000 g/mol. The percent data relate to 100% of the solvent or solvent mixture. The composition may comprise one or more than one, preferably 1, 2, 3 or more than three OSC compounds.

Furthermore, the composition of the present invention may preferably comprise at least 1.0, preferably 2.5, more preferably at least 3.0 and most preferably at least 4.0 % by weight of the organic semiconducting compound, preferably having a molecular weight of at most 5,000 g/mol.

The organic semiconductor compound used here is either a pure component or a mixture of two or more components, at least one of which must have semiconducting properties. In the case of the use of mixtures, however, it is not necessary for each component to have semiconducting properties. Thus, for example, inert low-molecular-weight compounds can be used together with semiconducting low-molecular-weight compounds. It is likewise possible to use non-conducting polymers, which serve as inert matrix or binder, together with one or more low-molecular-weight compounds or polymers having semiconducting properties. For the purposes of this application, the potentially admixed non-conducting component is taken to mean an electro-optically inactive, inert, passive compound.

The organic semiconducting compound of the present invention preferably has a molecular weight of 5,000 g/mol or less, more preferably a molecular weight of 4,000 g/mol or less and especially preferably a molecular weight of 2,000 g/mol or less.

According to a special aspect of the present invention, the organic semiconducting compound may preferably have a molecular weight of at least 550 g/mol, especially at least 800 g/mol, particularly at least 900 g/mol and more preferably at least 950 g/mol.

According to a further embodiment, the organic semiconducting compound preferably can have a molecular weight of at least 10,000 g/mol, preferably at least 20,000 g/mol, more preferably at least 50,000 g/mol and most preferably at least 100,000 g/mol. Organic semiconducting compounds having a molecular weight of at least 5,000, preferably at least 10,000 g/mol are considered as polymeric organic semiconducting compound. According to an embodiment of the

present invention, polymeric organic semiconducting compound may preferably have a molecular weight of at most 20,000,000 g/mol, preferably of at most 10,000,000 g/mol and especially preferably of at most 5,000,000 g/mol. Perferably, the polymeric organic semiconducting compound may have a molecular weight of at most 1,000,000 g/mol, more preferably of at most 500,000 g/mol and especially preferably of at most 300,000 g/mol. Surprising effects can be achieved with organic semiconducting compounds having a molecular weight in the range of 10,000 to 1,000,000 g/mol, preferably in the range of 20,000 to 500,000 g/mol, more preferably in the range of 50,000 to 300,000 g/mol and most preferably in the range of 100,000 to 300,000 g/mol. The molecular weight of the organic semiconducting compound relates to the weight average. The weight average molecular weight $M_w$ can be measured by standard methods such as gel permeation chromatography (GPC) against polystyrene standards.

In the present application, the term "polymer" is taken to mean both polymeric compounds and dendrimers. The polymeric compounds according to the invention preferably have 10 to 10,000, more preferably 20 to 5,000 and in most preferably 50 to 2,000 structural units. The branching factor of the polymers here is between 0 (linear polymer, no branching sites) and 1 (fully branched dendrimer).

OLEDs which comprise polymers as organic materials are frequently also known as PLEDs (PLED = polymeric light emitting diodes). Their simple production holds the promise of inexpensive production of corresponding electroluminescent devices.

PLEDs consist either only of one layer, which is able to combine as far as possible all functions (charge injection, charge transport, recombination) of an OLED in itself, or they consist of a plurality of layers which comprise the respective functions individually or partially combined. For the preparation of polymers having the corresponding properties, the polymerisation is carried out using different monomers which take on the corresponding functions.

Astonishing improvements can be achieved with one or more organic semiconducting compounds having a high solubility. Preferred organic semiconducting compounds can comprise Hansen Solubility parameters of $H_d$ in the range of 17.0 to 20.0 $MPa^{0.5}$, $H_p$ in the range of 2 to 10.0 $MPa^{0.5}$ and $H_h$ in the range of 0.0 to 15.0 $MPa^{0.5}$. More preferred organic semiconducting compounds comprise Hansen Solubility parameters of $H_d$ in the range of 17.5 to 19.0 $MPa^{0.5}$, $H_p$ in the range of 3.5 to 8.0 $MPa^{0.5}$ and $H_h$ in the range of 3.0 to 10.0 $MPa^{0.5}$.

Surprising effects can be achieved with organic semiconducting compounds having a radius of at least 3.0 $MPa^{0.5}$, preferably at least 4.5 $MPa^{0.5}$and more preferably at least 5.0 $MPa^{0.5}$ determined according to Hansen Solubility parameters.

The Hansen Solubility Parameters can be determined according to the Hansen Solubility Parameters in Practice HSPiP 4th edition, (Software version 4.0.7) with reference to the Hansen Solubility Parameters: A User's Handbook, Second Edition, C. M. Hansen (2007), Taylor and Francis Group, LLC) as supplied by Hanson and Abbot et al.

The positions $H_d$, $H_p$ and $H_h$ are the coordinates in 3 dimensional space for the centre of the organic semiconducting compound, whilst the radius, gives the distance that the solubility extends, i.e. if the radius is large it will encompass more solvents that would dissolve the material and conversely if it was small then a restricted number of solvents would solubilise the organic semiconducting compound.

According to a special aspect of the present invention the organic semiconducting compound may comprise a high glass transition temperature. Preferably, the organic semiconducting compound may have a glass transition temperature of at least 70°C, especially at least 100°C and more preferably at least 125°C determined according to DIN 51005 (Version 2005-08).

According to a special embodiment of the present invention, the OSC can be used for example as the active channel material in the semiconducting channel of an OFET, or as a layer element of an organic rectifying diode.

In case of OFET devices, where the OFET layer contains an OSC as the active channel material, it may be an n- or p-type OSC. The semiconducting channel may also be a composite of two or more OSC compounds of the same type, i.e. either n- or p-type. Furthermore, a p-type channel OSC compound may for example be mixed with an n-type OSC compound for the effect of doping the OSC layer. Multilayer semiconductors may also be used. For example, the OSC may be intrinsic near the insulator interface and a highly doped region can additionally be coated next to the intrinsic layer.

Preferred OSC compounds have a FET mobility of greater than $1\times10^{-5}$ $cm^2V^{-1}s^{-1}$, very preferably greater than $1\times10^{-2}$ $cm^2$ $V^{-1}s^{-1}$.

Especially preferred monomeric OSC compounds are selected from the group consisting of substituted oligoacenes such as pentacene, tetracene or anthracene, or heterocyclic derivatives thereof, like bis(trialkylsilyl-ethynyl) oligoacenes or bis(trialkylsilylethynyl) heteroacenes, as disclosed for example in US 6,690,029, WO 2005/055248 A1 or US 7,385,221.

Particularly preferred monomeric OSC compounds are selected from formula M1 (polyacenes):

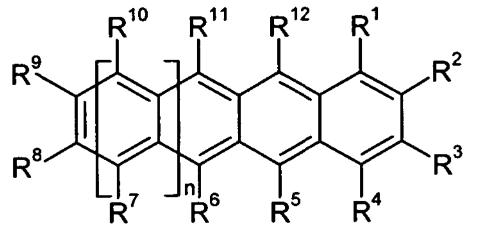

M1

wherein each of $R^1$, $R^2$, $R^3$, $R^4$, $R^5$, $R^6$, $R^7$, $R^8$, $R^9$, $R^{10}$, $R^{11}$ and $R^{12}$, which may be the same or different, independently represents: hydrogen; an optionally substituted $C_1$-$C_{40}$ carbyl or hydrocarbyl group; an optionally substituted $C_1$-$C_{40}$ alkoxy group; an optionally substituted $C_6$-$C_{40}$ aryloxy group; an optionally substituted $C_7$-$C_{40}$ alkylaryloxy group; an optionally substituted $C_2$-$C_{40}$ alkoxycarbonyl group; an optionally substituted $C_7$-$C_{40}$ aryloxycarbonyl group; a cyano group (-CN); a carbamoyl group (-C(=O)$NH_2$); a haloformyl group (-C(=O)-X, wherein X represents a halogen atom); a formyl group (-C(=O)-H); an isocyano group; an isocyanate group; a thiocyanate group or a thioisocyanate group; an optionally substituted amino group; a hydroxy group; a nitro group; a $CF_3$ group; a halo group (Cl, Br, F); or an optionally substituted silyl or alkynylsilyl group; and

wherein independently each pair of $R^1$ and $R^2$, $R^2$ and $R^3$, $R^3$ and $R^4$, $R^7$ and $R^8$, $R^8$ and $R^9$, $R^9$ and $R^{10}$, is optionally cross-bridged to form a $C_4$-$C_{40}$ saturated or unsaturated ring, which saturated or unsaturated ring may be intervened by an oxygen atom, a sulphur atom or a group of the formula - N($R^a$)-, wherein $R^a$ is a hydrogen atom or an optionally substituted hydrocarbon group, or may optionally be substituted; and

wherein one or more of the carbon atoms of the polyacene skeleton may optionally be substituted by a heteroatom selected from N, P, As, O, S, Se and Te; and

wherein independently any two or more of the substituents $R^1$-$R^{12}$ which are located on adjacent ring positions of the polyacene may, together, optionally constitute a further $C_4$-$C_{40}$ saturated or unsaturated ring optionally intervened by O, S or -N($R^a$), where $R^a$ is as defined above, or an aromatic ring system, fused to the polyacene; and

wherein n is 0, 1, 2, 3 or 4 preferably n is 0, 1 or 2, most preferably n is 0 or 2, meaning that the polyacene compound is a pentacene compound (if n=2) or a "pseudo pentacene" compound (if n=0).

Preferably, the compound according to formula M1 may comprise a solubilizing structure element as described, e. g. in document WO 2011/076325 referring to formulae (L-I), (L-II) and (L-III), respectively. The document WO 2011/076325 is included in the present patent application by referring thereto.

Very preferred are compounds of formula M1a (substituted pentacenes):

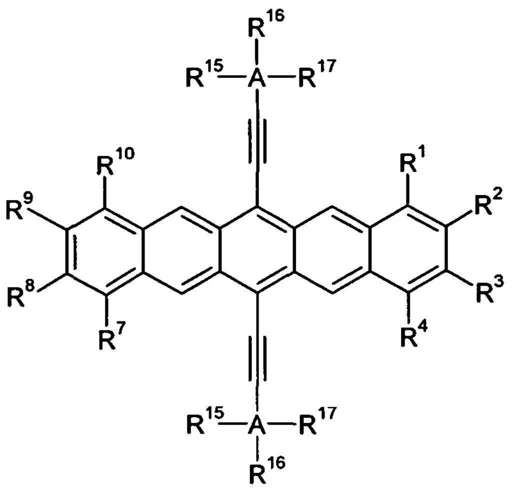

M1a

wherein $R^1$, $R^2$, $R^3$, $R^4$,$R^7$, $R^8$, $R^9$, $R^{10}$, $R^{15}$, $R^{16}$, $R^{17}$ each independently are the same or different and each independently represents: H; an optionally substituted $C_1$-$C_{40}$ carbyl or hydrocarbyl group; an optionally substituted $C_1$-$C_{40}$ alkoxy group; an optionally substituted $C_6$-$C_{40}$ aryloxy group; an optionally substituted $C_7$-$C_{40}$ alkylaryloxy

group; an optionally substituted $C_2$-$C_{40}$ alkoxycarbonyl group; an optionally substituted $C_7$-$C_{40}$ aryloxycarbonyl group; a cyano group (-CN); a carbamoyl group (-C(=O)$NH_2$); a haloformyl group (-C(=O)-X, wherein X represents a halogen atom); a formyl group (-C(=O)-H); an isocyano group; an isocyanate group; a thiocyanate group or a thioisocyanate group; an optionally substituted amino group; a hydroxy group; a nitro group; a $CF_3$ group; a halo group (Cl, Br, F); or an optionally substituted silyl group; and A represents Silicon or Germanium; and

wherein independently each pair of $R^1$ and $R^2$, $R^2$ and $R^3$, $R^3$ and $R^4$, $R^7$ and $R^8$, $R^8$ and $R^9$, $R^9$ and $R^{10}$, $R^{15}$ and $R^{16}$, and $R^{16}$ and $R^{17}$ is optionally cross-bridged with each other to form a $C_4$-$C_{40}$ saturated or unsaturated ring, which saturated or unsaturated ring is optionally intervened by an oxygen atom, a sulphur atom or a group of the formula -N($R^a$)-, wherein $R^a$ is a hydrogen atom or a hydrocarbon group, or is optionally substituted; and wherein one or more of the carbon atoms of the polyacene skeleton is optionally substituted by a heteroatom selected from N, P, As, O, S, Se and Te.

Preferably, the compound according to formula M1a may comprise a solubilizing structure element as described, e. g. in document WO 2011/076325 referring to formulae (L-I), (L-II) and (L-III), respectively.

Further preferred are compounds of formula M1b (substituted heteroacenes):

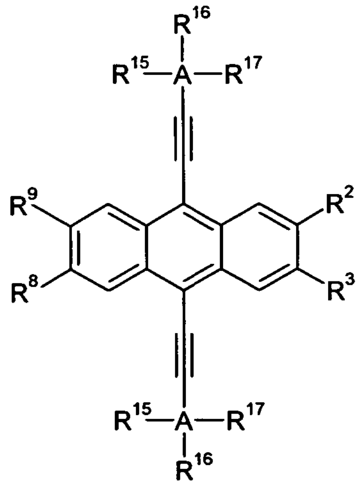

M1b

wherein $R^2$, $R^3$, $R^8$, $R^9$, $R^{15}$, $R^{16}$, $R^{17}$ each independently are the same or different and each independently represents: H; an optionally substituted $C_1$-$C_{40}$ carbyl or hydrocarbyl group; an optionally substituted $C_1$-$C_{40}$ alkoxy group; an optionally substituted $C_6$-$C_{40}$ aryloxy group; an optionally substituted $C_7$-$C_{40}$ alkylaryloxy group; an optionally substituted $C_2$-$C_{40}$ alkoxycarbonyl group; an optionally substituted $C_7$-$C_{40}$ aryloxycarbonyl group; a cyano group (-CN); a carbamoyl group (-C(=O)$NH_2$); a haloformyl group (-C(=O)-X, wherein X represents a halogen atom); a formyl group (-C(=O)-H); an isocyano group; an isocyanate group; a thiocyanate group or a thioisocyanate group; an optionally substituted amino group; a hydroxy group; a nitro group; a $CF_3$ group; a halo group (Cl, Br, F); or an optionally substituted silyl group; and A represents Silicon or Germanium; and
wherein independently each pair of $R^2$ and $R^3$, $R^8$ and $R^9$, $R^{15}$ and $R^{16}$, and $R^{16}$ and $R^{17}$ is optionally cross-bridged with each other to form a $C_4$-$C_{40}$ saturated or unsaturated ring, which saturated or unsaturated ring is optionally intervened by an oxygen atom, a sulphur atom or a group of the formula -N($R^a$)-, wherein $R^a$ is a hydrogen atom or a hydrocarbon group, and is optionally substituted; and
wherein one or more of the carbon atoms of the polyacene skeleton is optionally substituted by a heteroatom selected from N, P, As, O, S, Se and Te.

Especially preferred are compounds of subformula M1b, wherein at least one pair of $R^2$ and $R^3$, and $R^8$ and $R^9$ is cross-bridged with each other to form a $C_4$-$C_{40}$ saturated or unsaturated ring, which is intervened by an oxygen atom, a sulphur atom or a group of the formula -N($R^a$)-, wherein $R^a$ is a hydrogen atom or a hydrocarbon group, and which is optionally substituted.

Preferably, the compound according to formula M1b may comprise a solubilizing structure element as described, e. g. in document WO 2011/076325 referring to formulae (L-I), (L-II) and (L-III), respectively.

Especially preferred are compounds of subformula M1b1 (silylethynylated heteroacenes):

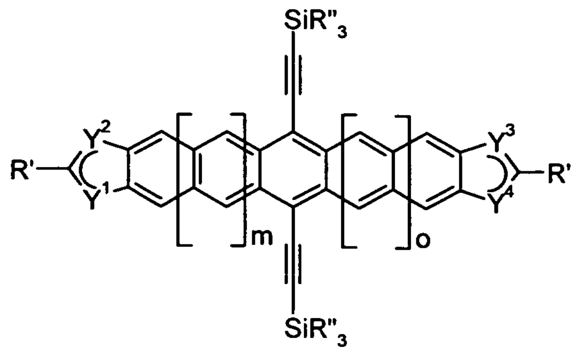

M1b1

wherein

one of $Y^1$ and $Y^2$ denotes -CH= or =CH- and the other denotes -X-, one of $Y^3$ and $Y^4$ denotes -CH= or =CH- and the other denotes -X-,

- X is -O-, -S-, -Se- or -NR‴-,
- R' is H, F, Cl, Br, I, CN, straight-chain or branched alkyl or alkoxy that have 1 to 20, preferably 1 to 8 C-atoms and are optionally fluorinated or perfluorinated, optionally fluorinated or perfluorinated aryl having 6 to 30 C-atoms, preferably $C_6F_5$, or $CO_2R''''$, with R'''' being H, optionally fluorinated alkyl having 1 to 20 C-atoms or optionally fluorinated aryl having 2 to 30, preferably 5 to 20 C-atoms,
- R" is, in case of multiple occurrence independently of one another, cyclic, straight-chain or branched alkyl or alkoxy that have 1 to 20, preferably 1 to 8 C-atoms, or aryl having 2 to 30 C-atoms, all of which are optionally fluorinated or perfluorinated, with $SiR''_3$ preferably being trialkylsilyl,
- R‴ is H or cyclic, straight-chain or branched alkyl with 1 to 10 C-atoms, preferably H,
- m is 0 or 1,
- o is 0 or 1.

Especially preferred are compounds of formula M1b1 wherein m and o are 0, and/or X is S, and/or R' is F.

In a preferred embodiment the compound of subformula M1b1 is provided and used as a mixture of the anti- and syn-isomers of the following formulae

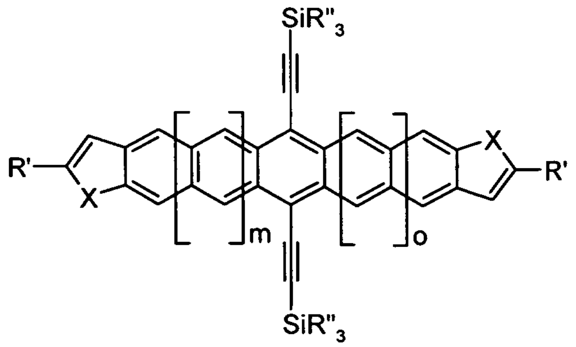

M1b1a

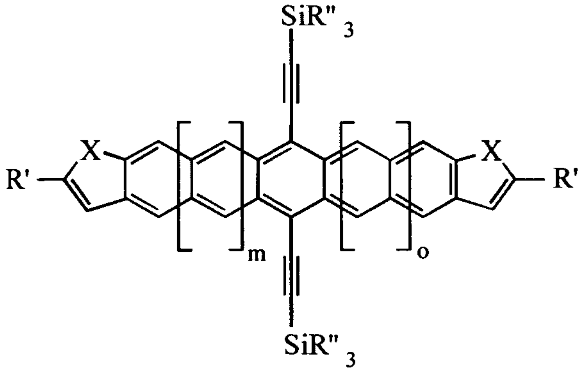

M1b1b

wherein X, R, R', R" m and o have independently of each other one of the meanings given in formula M1b1 or one of the preferred meanings given above and below, X is preferably S, and m and o are preferably 0.

The term "carbyl group" as used above and below denotes any monovalent or multivalent organic radical moiety which comprises at least one carbon atom either without any non-carbon atoms (like for example -C≡C-), or optionally combined with at least one non-carbon atom such as N, O, S, P, Si, Se, As, Te or Ge (for example carbonyl etc.). The term "hydrocarbyl group" denotes a carbyl group that does additionally contain one or more H atoms and optionally contains one or more hetero atoms like for example N, O, S, P, Si, Se, As, Te or Ge.

A carbyl or hydrocarbyl group comprising a chain of 3 or more C atoms may also be straight-chain, branched and/or cyclic, including spiro and/or fused rings.

Preferred carbyl and hydrocarbyl groups include alkyl, alkoxy, alkylcarbonyl, alkoxycarbonyl, alkylcarbonyloxy and alkoxycarbonyloxy, each of which is optionally substituted and has 1 to 40, preferably 1 to 25, very preferably 1 to 18 C atoms, furthermore optionally substituted aryl or aryloxy having 6 to 40, preferably 6 to 25 C atoms, furthermore alkylaryloxy, arylcarbonyl, aryloxycarbonyl, arylcarbonyloxy and aryloxycarbonyloxy, each of which is optionally substituted and has 6 to 40, preferably 7 to 40 C atoms, wherein all these groups optionally contain one or more hetero atoms, especially selected from N, O, S, P, Si, Se, As, Te and Ge.

The carbyl or hydrocarbyl group may be a saturated or unsaturated acyclic group, or a saturated or unsaturated cyclic group. Unsaturated acyclic or cyclic groups are preferred, especially aryl, alkenyl and alkynyl groups (especially ethynyl). Where the $C_1$-$C_{40}$ carbyl or hydrocarbyl group is acyclic, the group may be straight-chain or branched. The $C_1$-$C_{40}$ carbyl or hydrocarbyl group includes for example: a $C_1$-$C_{40}$ alkyl group, a $C_2$-$C_{40}$ alkenyl group, a $C_2$-$C_{40}$ alkynyl group, a $C_3$-$C_{40}$ allyl group, a $C_4$-$C_{40}$ alkyldienyl group, a $C_4$-$C_{40}$ polyenyl group, a $C_6$-$C_{18}$ aryl group, a $C_6$-$C_{40}$ alkylaryl group, a $C_6$-$C_{40}$ arylalkyl group, a $C_4$-$C_{40}$ cycloalkyl group, a $C_4$-$C_{40}$ cycloalkenyl group, and the like. Preferred among the foregoing groups are a $C_1$-$C_{20}$ alkyl group, a $C_2$-$C_{20}$ alkenyl group, a $C_2$-$C_{20}$ alkynyl group, a $C_3$-$C_{20}$ allyl group, a $C_4$-$C_{20}$ alkyldienyl group, a $C_6$-$C_{12}$ aryl group and a $C_4$-$C_{20}$ polyenyl group, respectively. Also included are combinations of groups having carbon atoms and groups having hetero atoms, like e.g. an alkynyl group, preferably ethynyl, that is substituted with a silyl group, preferably a trialkylsilyl group.

Aryl and heteroaryl preferably denote a mono-, bi- or tricyclic aromatic or heteroaromatic group with up to 25 C atoms that may also comprise condensed rings and is optionally substituted with one or more groups L, wherein L is halogen or an alkyl, alkoxy, alkylcarbonyl or alkoxycarbonyl group with 1 to 12 C atoms, wherein one or more H atoms may be replaced by F or Cl.

Especially preferred aryl and heteroaryl groups are phenyl in which, in addition, one or more CH groups may be replaced by N, naphthalene, thiophene, selenophene, thienothiophene, dithienothiophene, fluorene and oxazole, all of which can be unsubstituted, mono- or polysubstituted with L as defined above.

Especially preferred substituents R, $R^s$ and $R^{1-17}$ in the above formulae and subformulae are selected from straight chain, branched or cyclic alkyl having from 1 to 20 C atoms, which is unsubstituted or mono- or polysubstituted by F, Cl, Br or I, and wherein one or more non-adjacent $CH_2$ groups are optionally replaced, in each case independently from one another, by -O-, -S-, -$NR^b$-, -$SiR^bR^c$-, -$CX^1$=$CX^2$- or -C≡C- in such a manner that O and/or S atoms are not linked directly to one another, or denotes optionally substituted aryl or heteroaryl preferably having from 1 to 30 C-atoms, with $R^b$ and $R^c$ being independently of each other H or alkyl having from 1 to 12 C-atoms, and $X^1$ and $X^2$ being independently of each other H, F, Cl or CN.

$R^{15-17}$ and R" are preferably identical or different groups selected from a $C_1$-$C_{40}$-alkyl group, preferably $C_1$-$C_4$-alkyl, most preferably methyl, ethyl, n-propyl or isopropyl, a $C_6$-$C_{40}$-aryl group, preferably phenyl, a $C_6$-$C_{40}$-arylalkyl group, a $C_1$-$C_{40}$-alkoxy group, or a $C_6$-$C_{40}$-arylalkyloxy group, wherein all these groups are optionally substituted for example with one or more halogen atoms. Preferably, $R^{15-17}$ and R" are each independently selected from optionally substituted $C_{1-12}$-alkyl, more preferably $C_{1-4}$-alkyl, most preferably $C_{1-3}$-alkyl, for example isopropyl, and optionally substituted $C_{6-10}$-aryl, preferably phenyl. Further preferred is a silyl group of formula - $SiR^{15}R^{16}$ wherein $R^{15}$ is as defined above and $R^{16}$ forms a cyclic silyl alkyl group together with the Si atom, preferably having 1 to 8 C atoms.

In one preferred embodiment all of $R^{15-17}$, or all of R", are identical groups, for example identical, optionally substituted, alkyl groups, as in triisopropylsilyl. Very preferably all of $R^{15-17}$, or all of R", are identical, optionally substituted $C_{1-10}$, more preferably $C_{1-4}$, most preferably $C_{1-3}$ alkyl groups. A preferred alkyl group in this case is isopropyl.

Preferred groups -$SiR^{15}R^{16}R^{17}$ and $SiR''_3$ include, without limitation, trimethylsilyl, triethylsilyl, tripropylsilyl, dimethylethylsilyl, diethylmethylsilyl, dimethylpropylsilyl, dimethylisopropylsilyl, dipropylmethylsilyl, diisopropylmethylsilyl, dipropylethylsilyl, diisopropylethylsilyl, diethylisopropylsilyl, triisopropylsilyl, trimethoxysilyl, triethoxysilyl, triphenylsilyl, diphenylisopropylsilyl, diisopropylphenylsilyl, diphenylethylsilyl, diethylphenylsilyl, diphenylmethylsilyl, triphenoxysilyl, dimethylmethoxysilyl, dimethylphenoxysilyl, methylmethoxyphenylsilyl, etc., wherein the alkyl, aryl or alkoxy group is optionally substituted.

According to a preferred embodiment of the present invention the OSC material is an organic light emitting material and/or charge transporting material. The organic light emitting materials and charge transporting materials can be selected from standard materials known to the skilled person and described in the literature. Organic light emitting

material according to the present application means a material which emits light having a $\lambda_{max}$ in the range from 400 to 700 nm.

Suitable phosphorescent compounds are, in particular, compounds which emit light, preferably in the visible region, on suitable excitation and in addition contain at least one atom having an atomic number greater than 20, preferably greater than 38 and less than 84, more preferably greater than 56 and less than 80. The phosphorescence emitters used are preferably compounds which contain copper, molybdenum, tungsten, rhenium, ruthenium, osmium, rhodium, iridium, palladium, platinum, silver, gold or europium, in particular compounds which contain iridium or platinum.

Particularly preferred organic phosphorescent compounds are compounds of formulae (1) to (4):

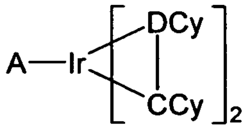

formula (1)

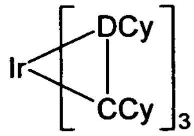

formula (2)

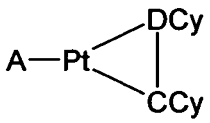

formula (3)

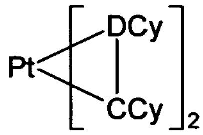

formula (4)

where

- DCy is, identically or differently on each occurrence, a cyclic group which contains at least one donor atom, preferably nitrogen, carbon in the form of a carbene or phosphorus, via which the cyclic group is bonded to the metal, and which may in turn carry one or more substituents $R^{18}$; the groups DCy and CCy are connected to one another via a covalent bond;
- CCy is, identically or differently on each occurrence, a cyclic group which contains a carbon atom via which the cyclic group is bonded to the metal and which may in turn carry one or more substituents $R^{18}$;
- A is, identically or differently on each occurrence, a monoanionic, bidentate chelating ligand, preferably a diketonate ligand;
- $R^{18}$ are identically or differently at each instance, and are F, Cl, Br, I, $NO_2$, CN, a straight-chain, branched or cyclic alkyl or alkoxy group having from 1 to 20 carbon atoms, in which one or more nonadjacent $CH_2$ groups may be replaced by -O-, -S-, -$NR^{19}$-, -$CONR^{19}$-, -CO-O-, -C=O-, -CH=CH- or -C≡C-, and in which one or more hydrogen atoms may be replaced by F, or an aryl or heteroaryl group which has from 4 to 14 carbon atoms and may be substituted by one or more nonaromatic $R^{18}$ radicals, and a plurality of substituents $R^{18}$, either on the same ring or on two different rings, may together in turn form a mono- or polycyclic, aliphatic or aromatic ring system; and
- $R^{19}$ are identically or differently at each instance, and are a straight-chain, branched or cyclic alkyl or alkoxy group having from 1 to 20 carbon atoms, in which one or more nonadjacent $CH_2$ groups may be replaced by -O-, -S-, -CO-O-, -C=O-, -CH=CH- or -C≡C-, and in which one or more hydrogen atoms may be replaced by F, or an aryl or heteroaryl group which has from 4 to 14 carbon atoms and may be substituted by one or more nonaromatic $R^{18}$ radicals.

Formation of ring systems between a plurality of radicals $R^{18}$ means that a bridge may also be present between the groups DCy and CCy.

Furthermore, formation of ring systems between a plurality of radicals $R^{18}$ means that a bridge may also be present between two or three ligands CCy-DCy or between one or two ligands CCy-DCy and the ligand A, giving a polydentate or polypodal ligand system.

For the purposes of this invention, an aryl group contains at least 6 C atoms; for the purposes of this invention, a heteroaryl group contains at least 2 C atoms and at least one heteroatom, with the proviso that the sum of C atoms and heteroatoms is at least 5. The heteroatoms are preferably selected from N, O and/or S. An aryl group or heteroaryl group here is taken to mean either a simple aromatic ring, i.e. benzene, or a simple heteroaromatic ring, for example pyridine, pyrimidine, thiophene, etc., or a condensed aryl or heteroaryl group, for example naphthalene, anthracene, pyrene, quinoline, isoquinoline, etc.

For the purposes of this invention, an aromatic ring system contains at least 6 C atoms in the ring system. For the purposes of this invention, a heteroaromatic ring system contains at least 2 C atoms and at least one heteroatom in the ring system, with the proviso that the sum of C atoms and heteroatoms is at least 5. The heteroatoms are preferably selected from N, O and/or S. For the purposes of this invention, an aromatic or heteroaromatic ring system is intended to be taken to mean a system which does not necessarily contain only aryl or hetero-aryl groups, but instead in which, in addition, a plurality of aryl or heteroaryl groups may be interrupted by a short non-aromatic unit (preferably less than 10% of the atoms other than H), such as, for example, an $sp^3$-hybridised C, N or O atom or a carbonyl group. Thus, for example, systems such as 9,9'-spirobifluorene, 9,9-diaryl-fluorene, triarylamine, diaryl ether, stilbene, benzophenone, etc., are also intended to be taken to be aromatic ring systems for the purposes of this invention. An aromatic or heteroaromatic ring system is likewise taken to mean systems in which a plurality of aryl or heteroaryl groups are linked to one another by single bonds, for example biphenyl, terphenyl or bipyridine.

For the purposes of the present invention, a $C_1$- to $C_{40}$-alkyl group, in which, in addition, individual H atoms or $CH_2$ groups may be substituted by the above-mentioned groups, is particularly preferably taken to mean the radicals methyl, ethyl, n-propyl, i-propyl, n-butyl, i-butyl, s-butyl, t-butyl, 2-methylbutyl, n-pentyl, s-pentyl, t-pentyl, 2-pentyl, neopentyl, cyclopentyl, n-hexyl, s-hexyl, t-hexyl, 2-hexyl, 3-hexyl, neohexyl, cyclohexyl, 2-methylpentyl, n-heptyl, 2-heptyl, 3-heptyl, 4-heptyl, cycloheptyl, 1-methylcyclohexyl, n-octyl, 2-ethylhexyl, cyclooctyl, 1-bicyclo[2.2.2]octyl, 2-bicyclo-[2.2.2]octyl, 2-(2,6-dimethyl)octyl, 3-(3,7-dimethyl)octyl, trifluoromethyl, pentafluoroethyl and 2,2,2-trifluoroethyl. A $C_2$- to $C_{40}$-alkenyl group is preferably taken to mean ethenyl, propenyl, butenyl, pentenyl, cyclopentenyl, hexenyl, cyclohexenyl, heptenyl, cycloheptenyl, octenyl or cyclooctenyl. A $C_2$- to $C_{40}$-alkynyl group is preferably taken to mean ethynyl, propynyl, butynyl, pentynyl, hexynyl, heptynyl or octynyl. A $C_1$- to $C_{40}$-alkoxy group is preferably taken to mean methoxy, trifluoromethoxy, ethoxy, n-propoxy, i-propoxy, n-butoxy, i-butoxy, s-butoxy, t-butoxy or 2-methylbutoxy. An aromatic or heteroaromatic ring system having 5 - 60 aromatic ring atoms, which may also in each case be substituted by the above-mentioned radicals R and which may be linked to the aromatic or heteroaromatic ring system via any desired positions, is taken to mean, in particular, groups derived from benzene, naphthalene, anthracene, phenanthrene, benzanthracene, benzophenanthrene, pyrene, chrysene, perylene, fluoranthene, benzofluoranthene, naphthacene, pentacene, benzopyrene, biphenyl, biphenylene, terphenyl, terphenylene, fluorene, benzofluorene, dibenzofluorene, spirobifluorene, dihydrophenanthrene, dihydropyrene, tetrahydropyrene, cis- or trans-indenofluorene, cis- or trans-monobenzo-indenofluorene, cis- or trans-dibenzoindenofluorene, truxene, isotruxene, spirotruxene, spiroisotruxene, furan, benzofuran, isobenzofuran, dibenzofuran, thiophene, benzothiophene, isobenzothiophene, dibenzothiophene, pyrrole, indole, isoindole, carbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthimidazole, phenanthrimidazole, pyridimidazole, pyrazinimidazole, quinoxalinimidazole, oxazole, benzoxazole, naphthoxazole, anthroxazole, phenanthroxazole, isoxazole, 1,2-thiazole, 1,3-thiazole, benzothiazole, pyridazine, benzopyridazine, pyrimidine, benzopyrimidine, quinoxaline, 1,5-diazaanthracene, 2,7-diazapyrene, 2,3-diazapyrene, 1,6-diazapyrene, 1,8-diazapyrene, 4,5-diazapyrene, 4,5,9,10-tetraazaperylene, pyrazine, phenazine, phenoxazine, phenothiazine, fluorubin, naphthyridine, azacarbazole, benzocarboline, phenanthroline, 1,2,3-triazole, 1,2,4-triazole, benzotriazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 1,3,5-triazine, 1,2,4-triazine, 1,2,3-triazine, tetrazole, 1,2,4,5-tetrazine, 1,2,3,4-tetrazine, 1,2,3,5-tetrazine, purine, pteridine, indolizine and benzothiadiazole.

Preferably, the semiconducting compounds according to formulae (1), (2), (3) and (4) may comprise a solubilizing structure element as described, e. g. in document WO 2011/076325 referring to formulae (L-I), (L-II) and (L-III), respectively.

Examples of the emitters described above are revealed by the applications WO 00/70655, WO 01/41512, WO 02/02714, WO 02/15645, EP 1191613, EP 1191612, EP 1191614, WO 04/081017, WO 05/033244,

WO 05/042550, WO 05/113563, WO 06/008069, WO 06/061182,

WO 06/081973 and DE 102008027005. In general, all phosphorescent complexes as are used in accordance with the prior art for phosphorescent OLEDs and as are known to the person skilled in the art in the area of organic electroluminescence are suitable, and the person skilled in the art will be able to use further phosphorescent compounds without inventive step. In particular, it is known to the person skilled in the art which phosphorescent complexes emit with which emission colour.

Examples of preferred phosphorescent compounds are shown in the following table.

| | |
|---|---|
| 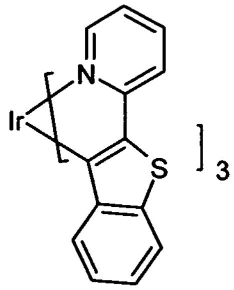 | 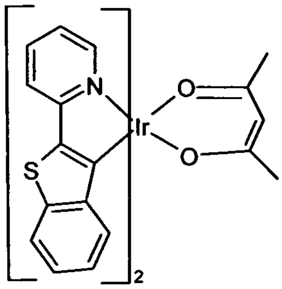 |
| | |

| | |
|---|---|
| 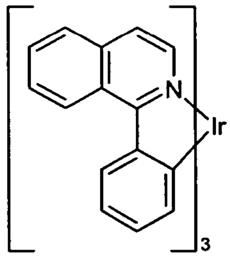 | 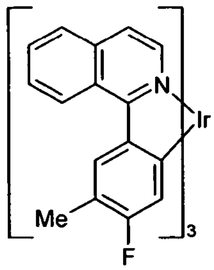 |
| | |
| 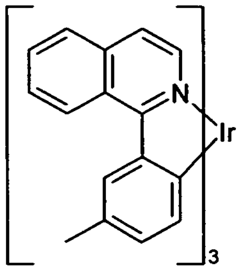 | 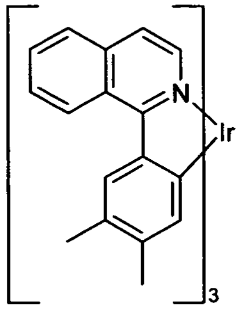 |
| | |
| 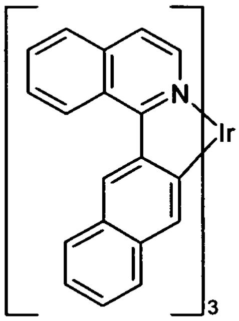 | 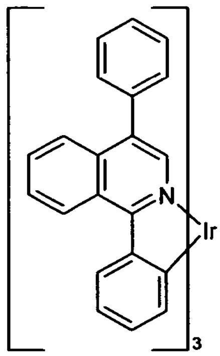 |
| | |
| 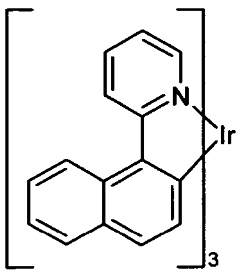 | 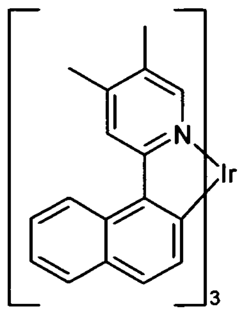 |
| | |

| | |
|---|---|
| 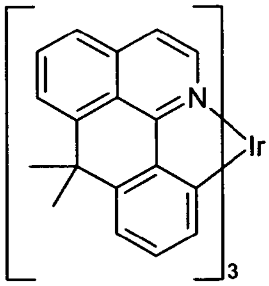 | 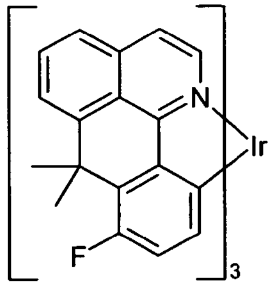 |
| | |
| 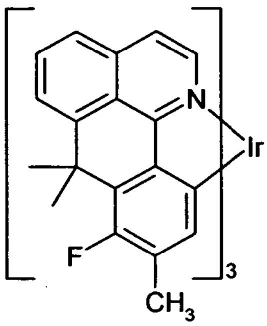 | 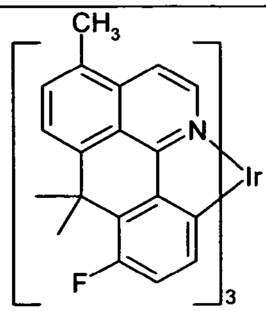 |
| | |
| 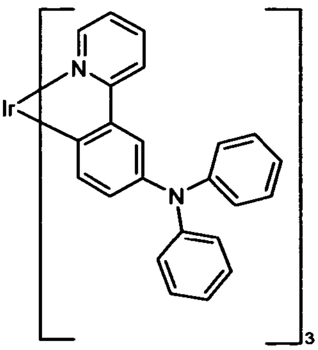 | 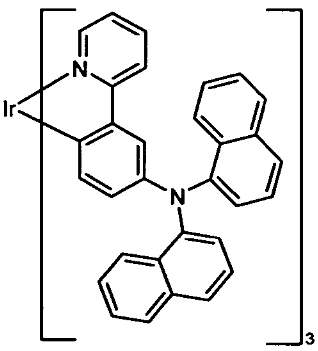 |
| | |
| 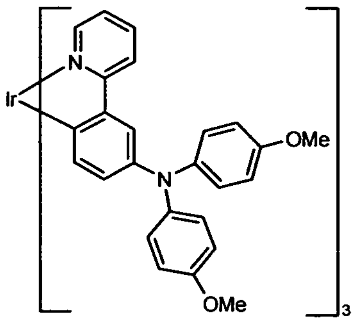 | 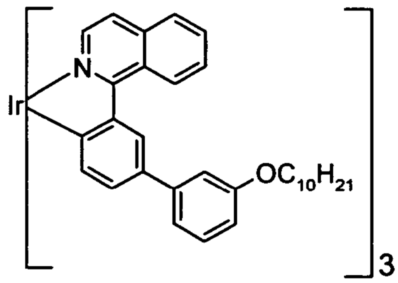 |
| | |

| | |
|---|---|
| 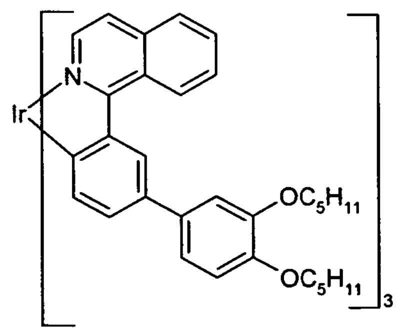 | 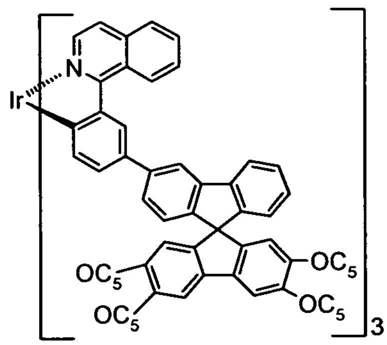 |
| | |
| 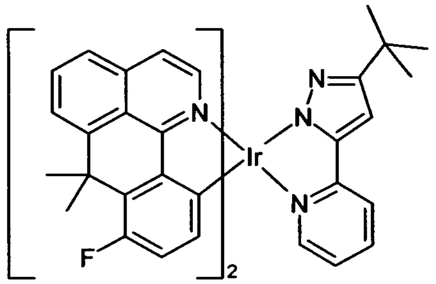 | 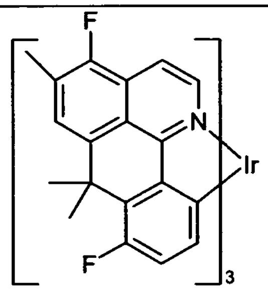 |
| | |
| 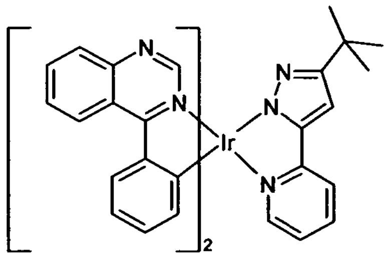 | 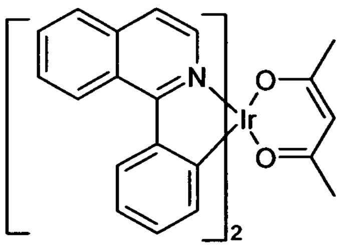 |
| | |
| 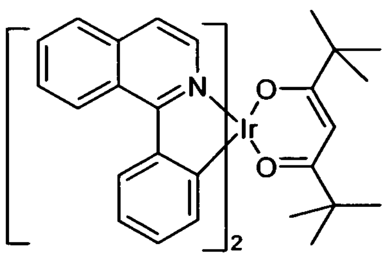 | 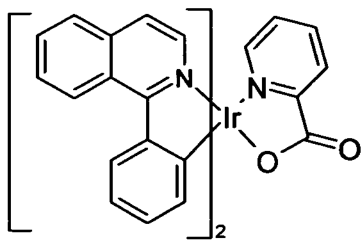 |
| | |

| | |
|---|---|
| 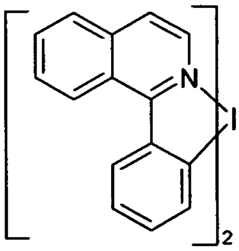 | 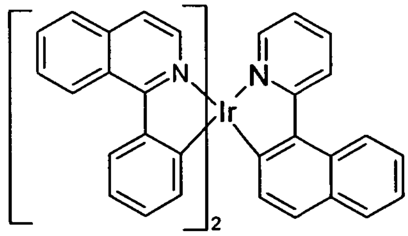 |
| | |
| 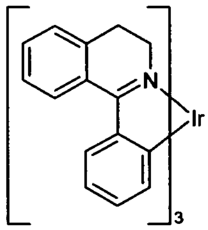 | 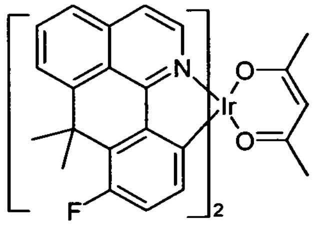 |
| | |
| 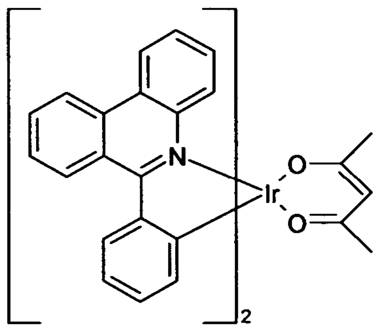 | 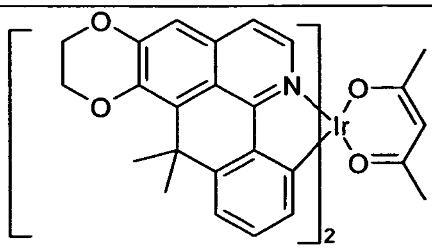 |
| | |
| 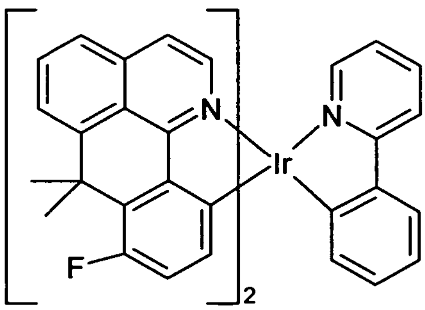 | 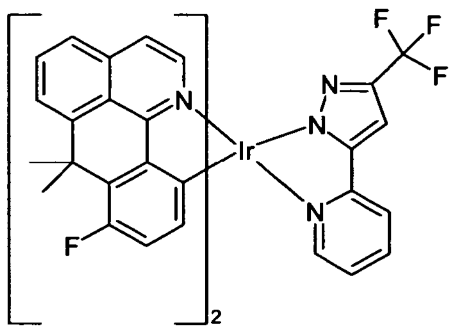 |
| | |

| | |
|---|---|
| 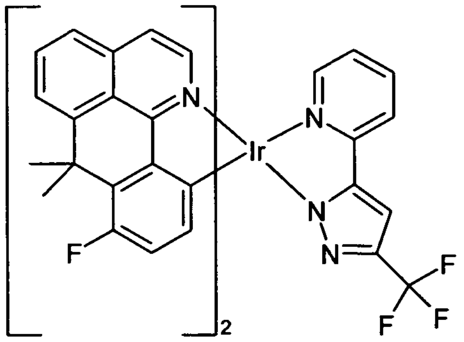 | 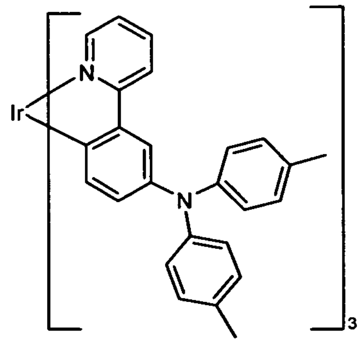 |
| | |
| 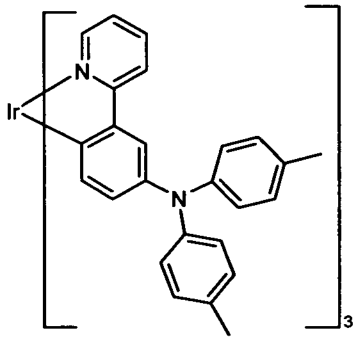 | 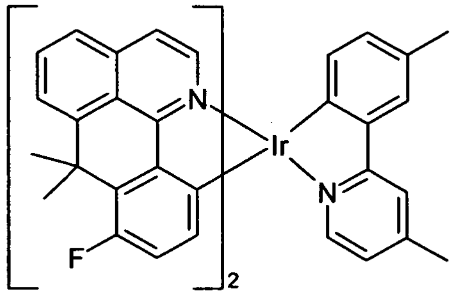 |
| | |
| 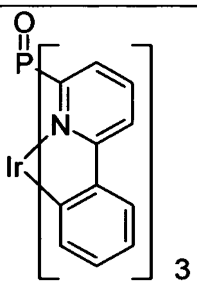 | 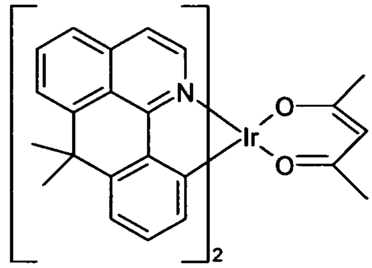 |
| | |
| 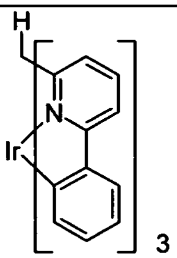 | 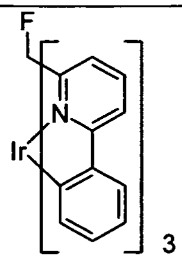 |
| | |

| | |
|---|---|
| 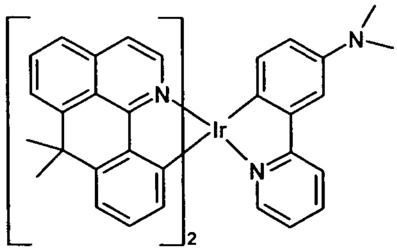 | 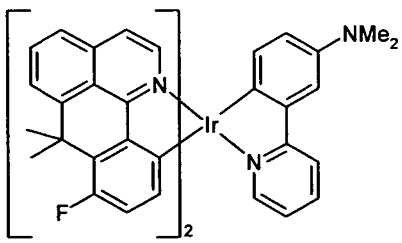 |
| | |
| 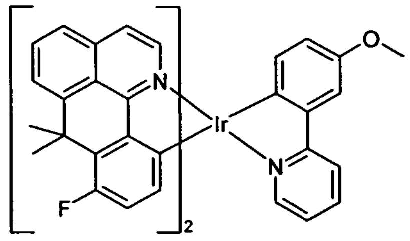 | 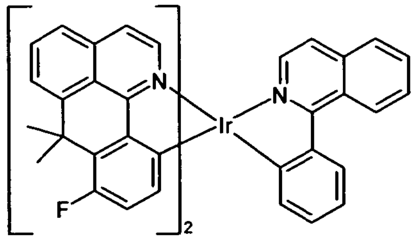 |
| | |
| 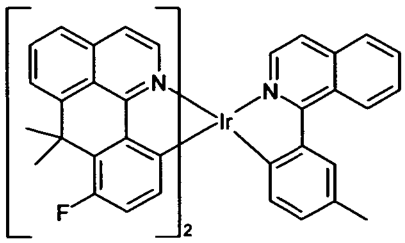 | 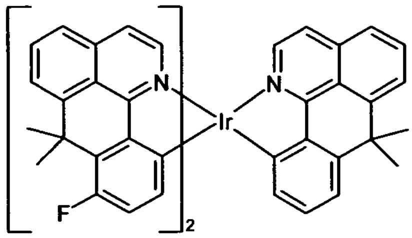 |
| | |
| 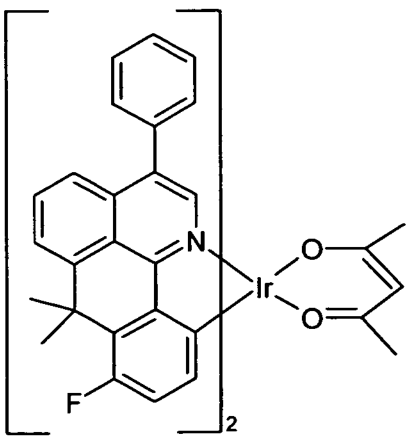 | 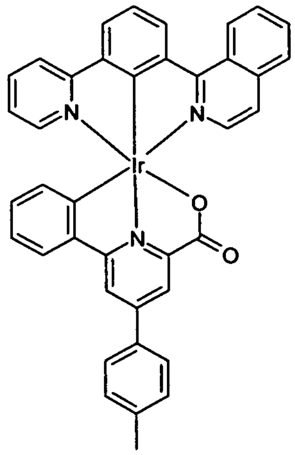 |
| | |

| | |
|---|---|
| 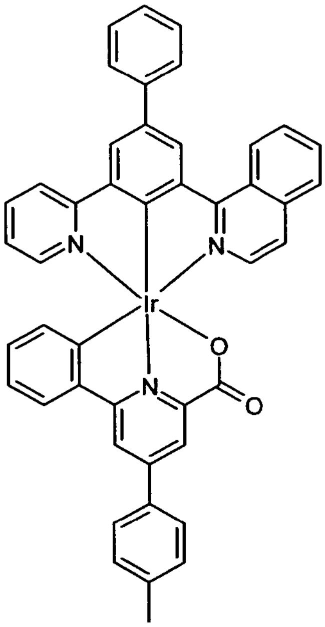 | 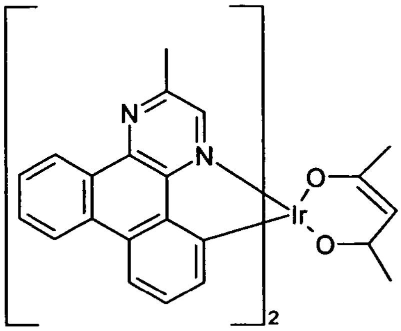 |
| | |
| 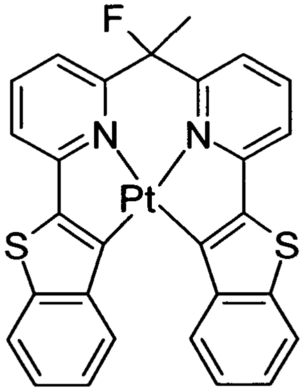 | 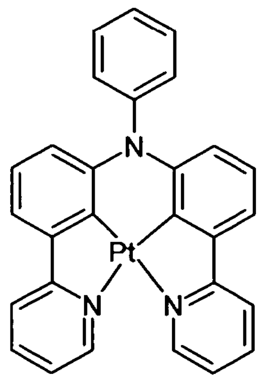 |
| | |
| 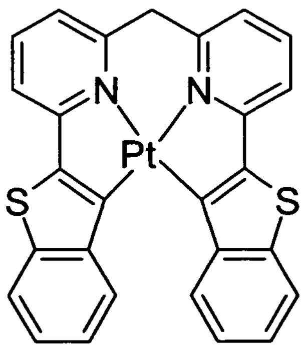 | 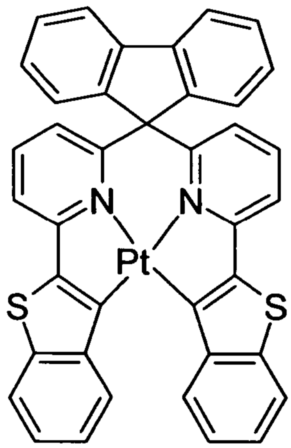 |
| | |

| | |
|---|---|
| 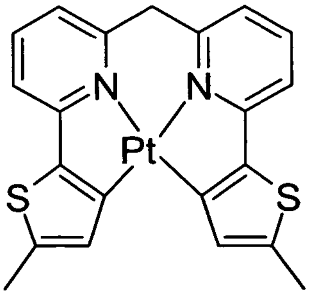 | 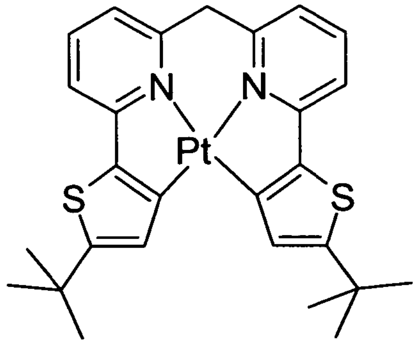 |
| | |
| 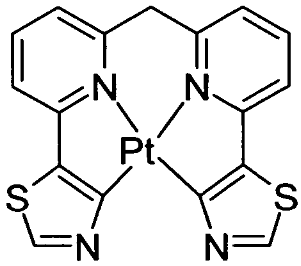 | 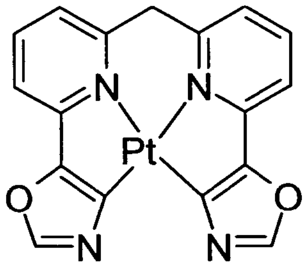 |
| | |
| 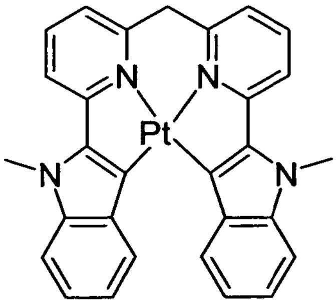 | 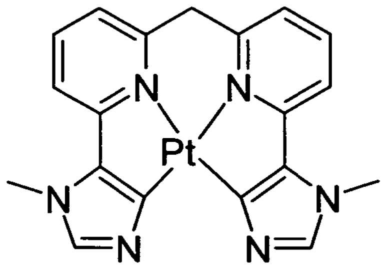 |
| | |

| | |
|---|---|
| 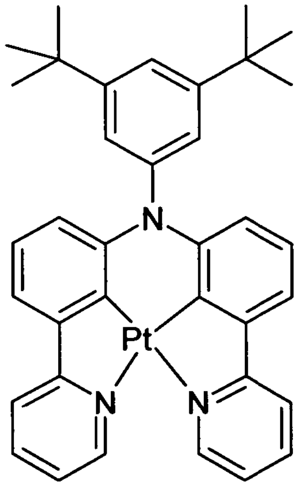 | 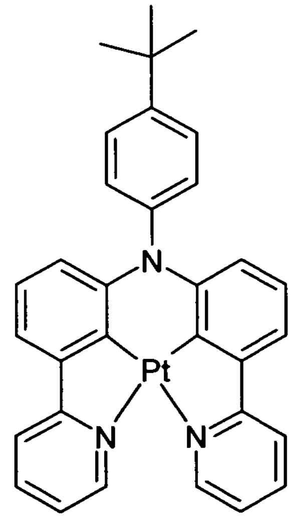 |
| | |
| 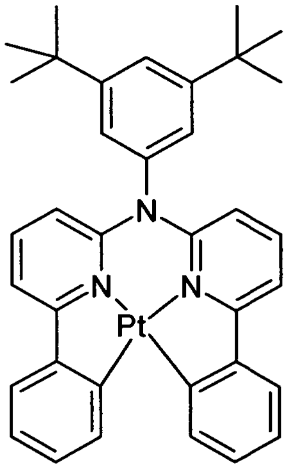 | 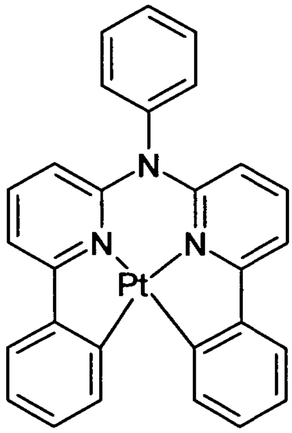 |
| | |
| 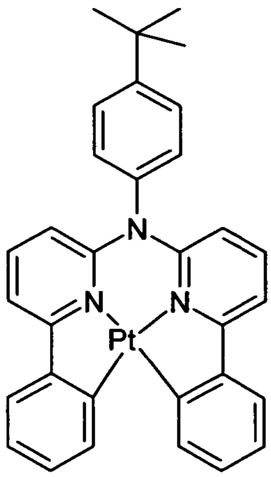 | 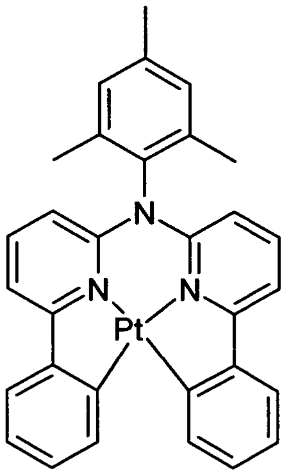 |
| | |

| | |
|---|---|
| 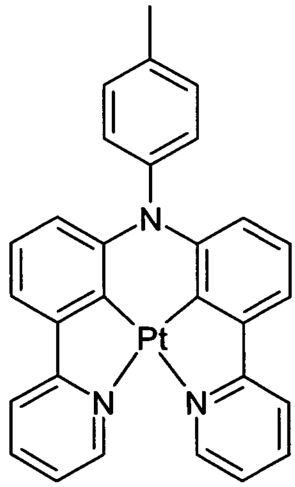 | 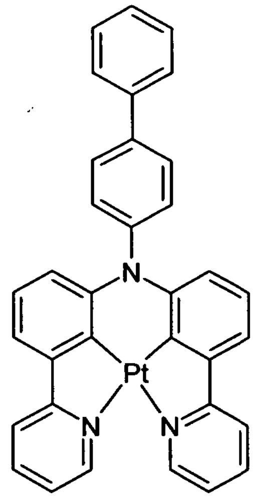 |
| | |
| 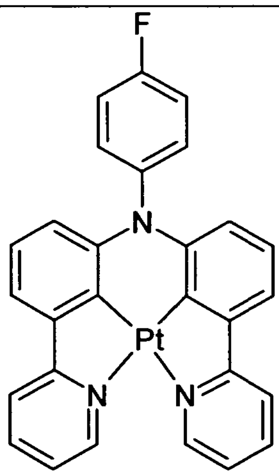 | 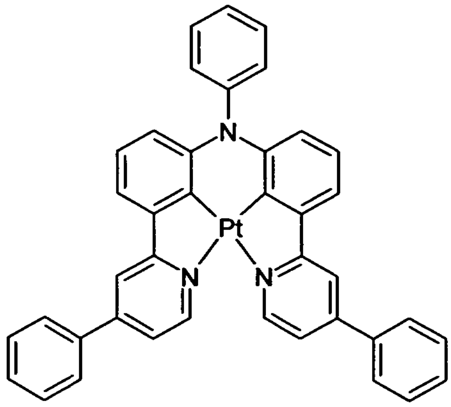 |
| | |
| 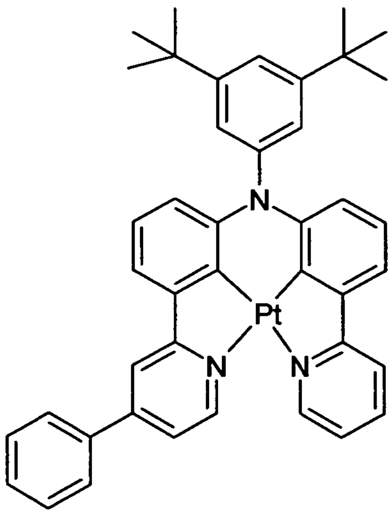 | 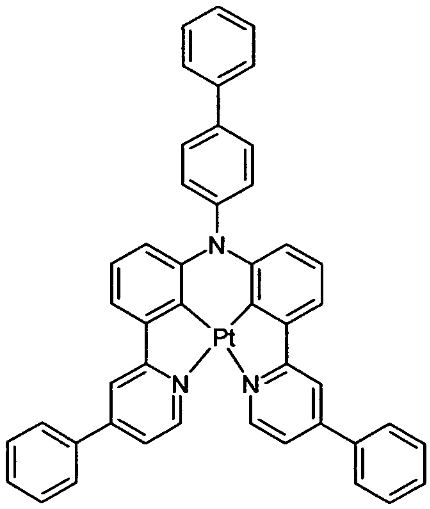 |
| | |

| | |
|---|---|
| 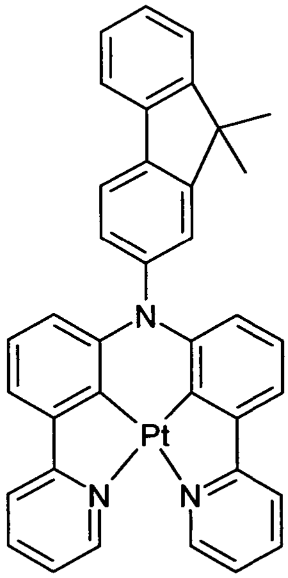 | 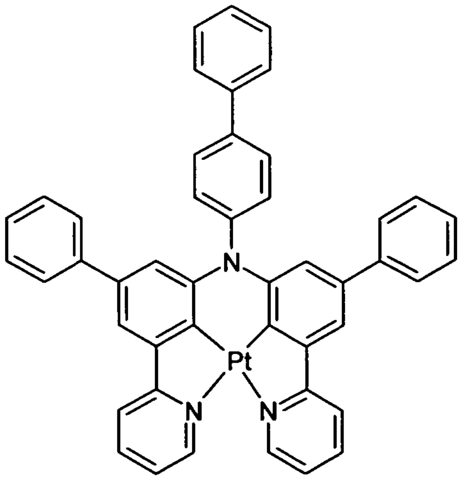 |
| | |
| 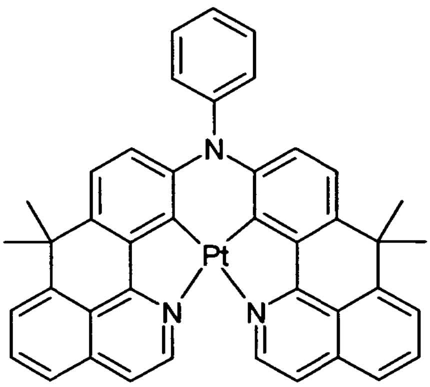 | 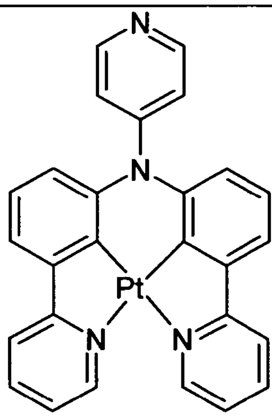 |
| | |
| 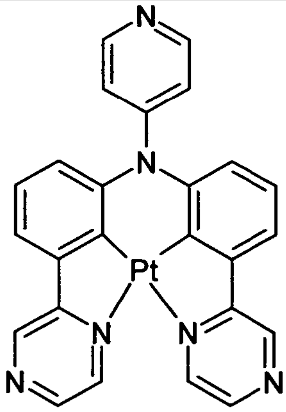 | 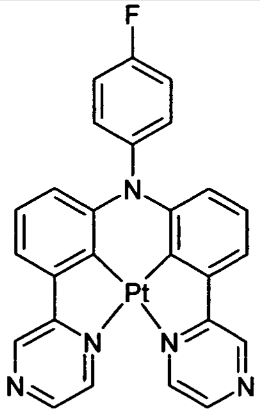 |
| | |

| | |
|---|---|
| 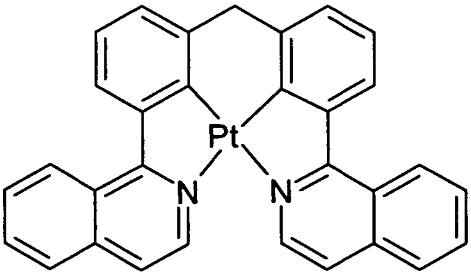 | 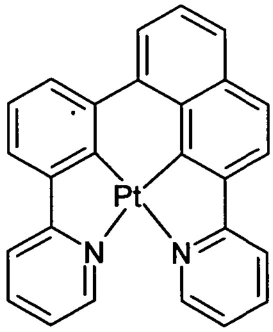 |
| | |
| 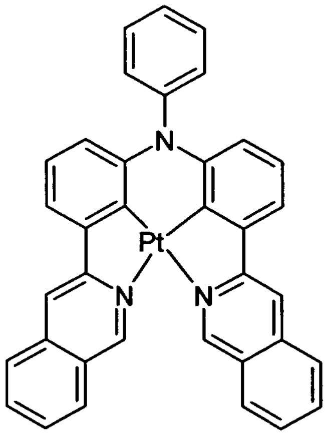 | 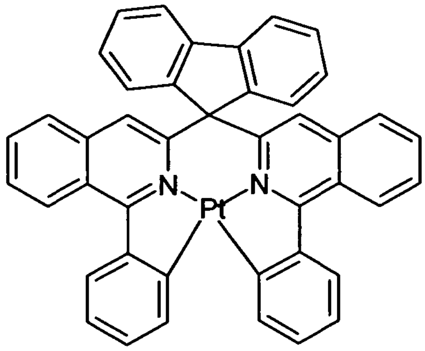 |
| | |
| 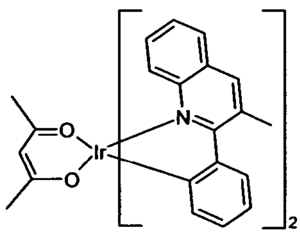 | 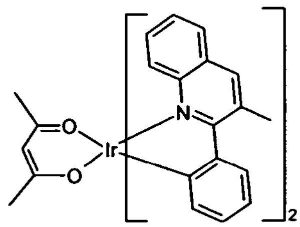 |
| | |
| 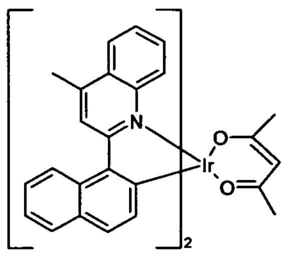 | 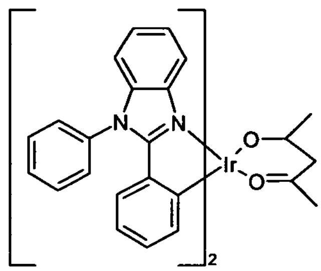 |
| | |

| | |
|---|---|
| 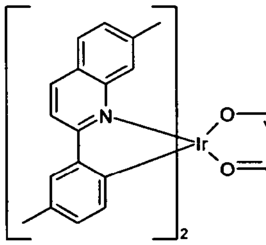 | 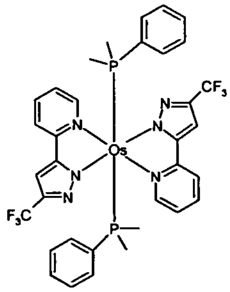 |
| | |
| 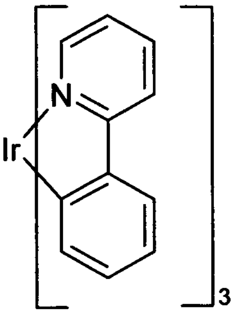 | 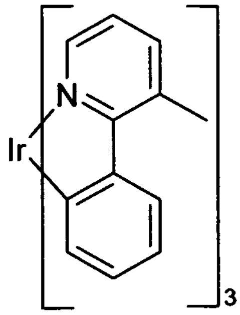 |
| | |
| 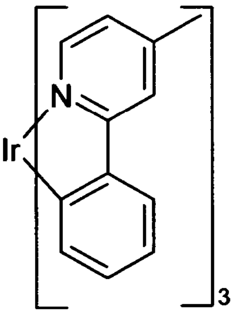 | 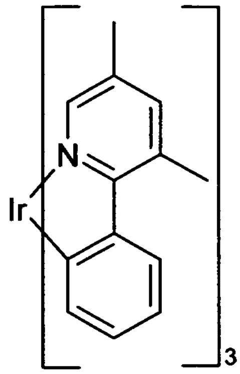 |
| | |
| 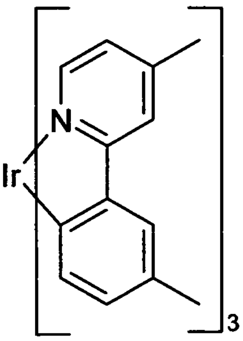 | 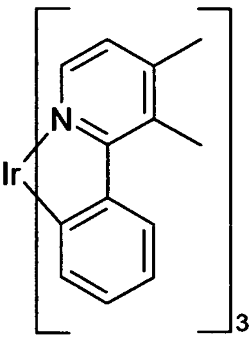 |
| | |

| | |
|---|---|
| 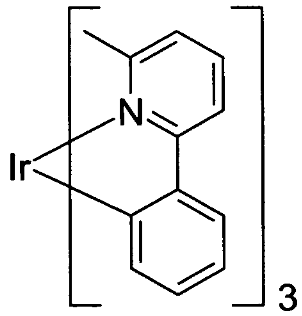 | 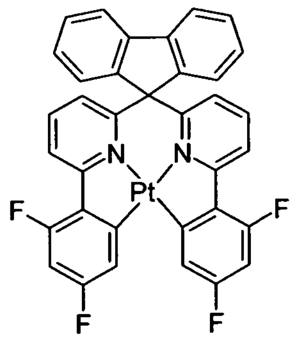 |
| | |
| 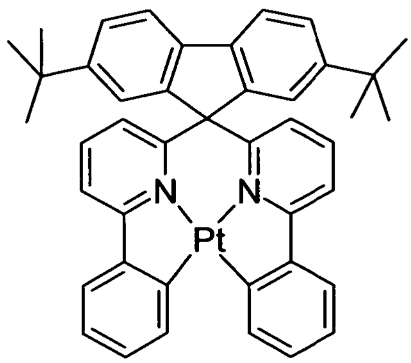 | 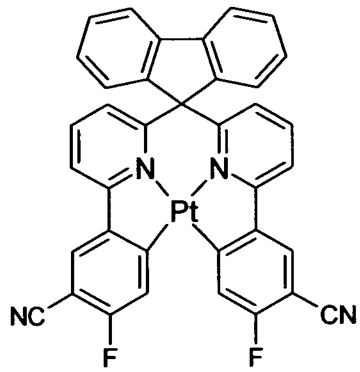 |
| | |
| 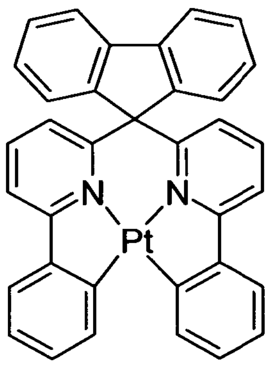 | 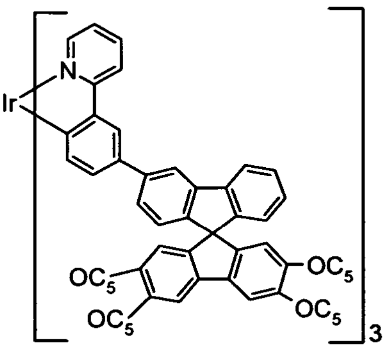 |
| | |
| 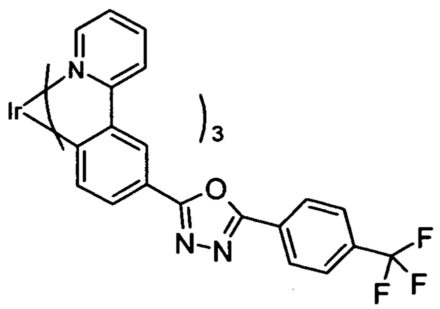 | 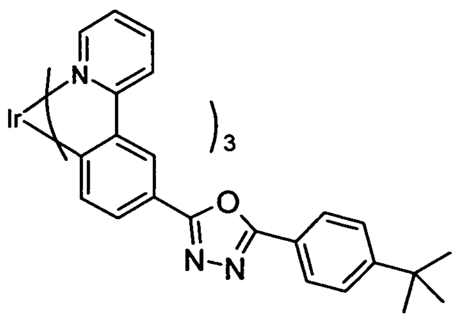 |
| | |

| | |
|---|---|
| 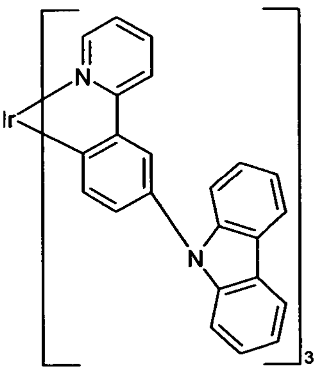 | 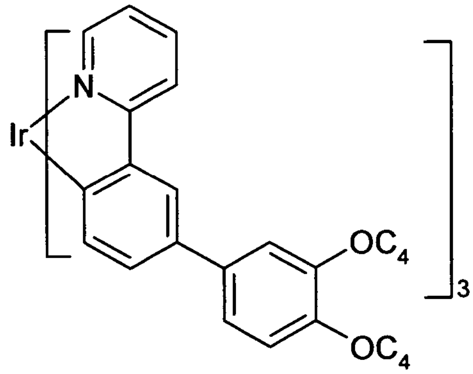 |
| | |
| 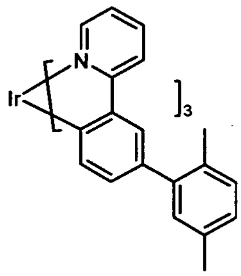 | 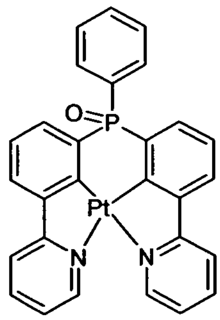 |
| | |
| 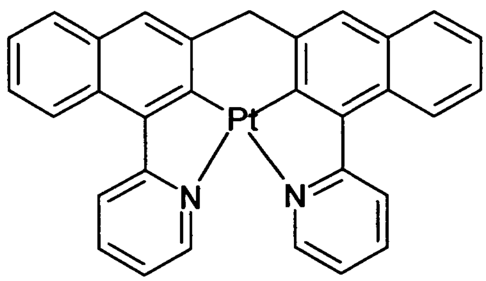 | 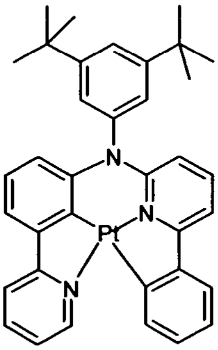 |
| | |
| 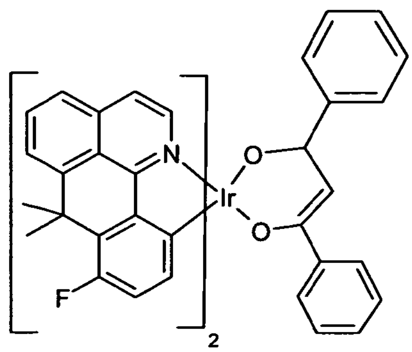 | 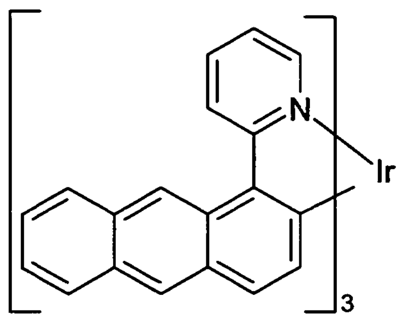 |
| | |

| | |
|---|---|
| 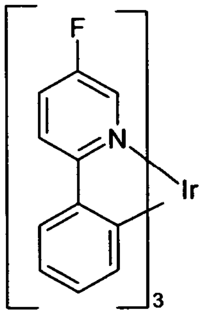 | 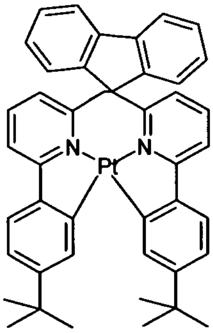 |
| | |
| 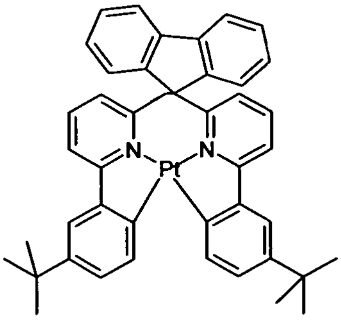 | 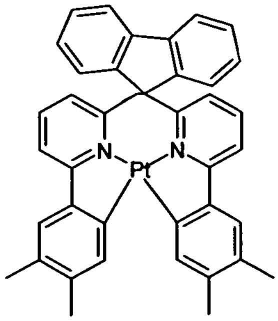 |
| | |
| 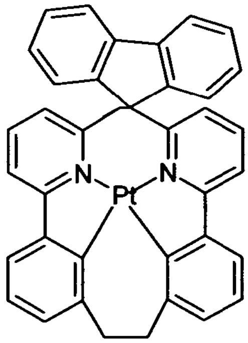 | 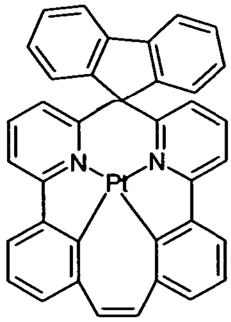 |
| | |
| 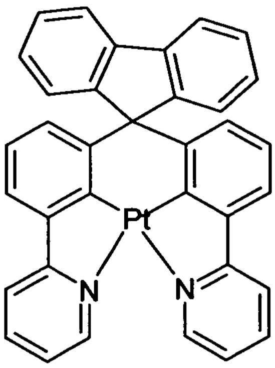 | 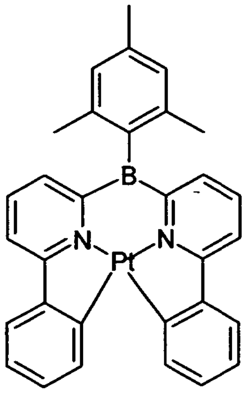 |
| | |

| | |
|---|---|
| 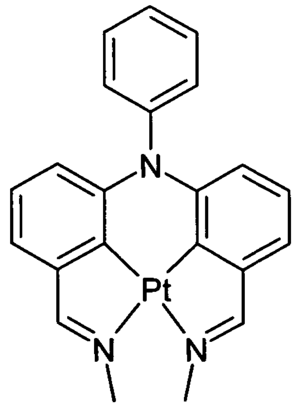 | 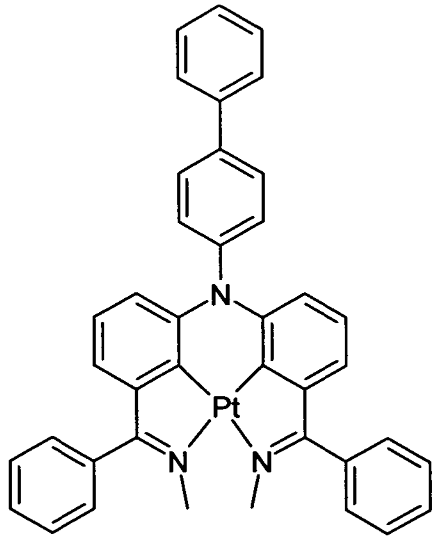 |
| | |
| 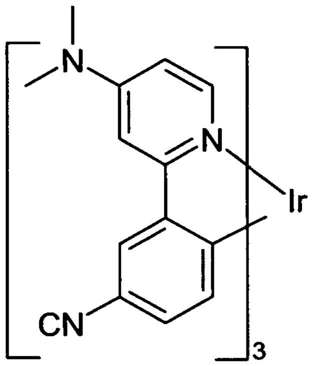 | 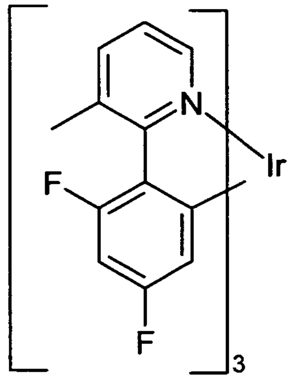 |
| | |
| 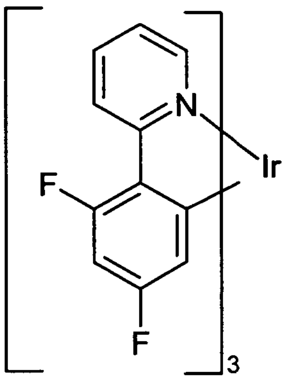 | 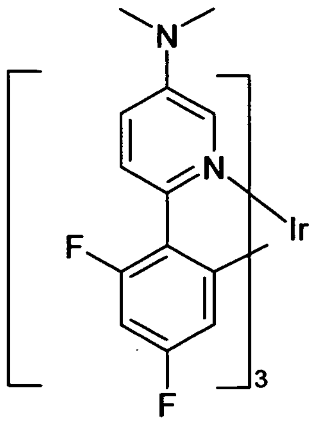 |
| | |

| | |
|---|---|
| 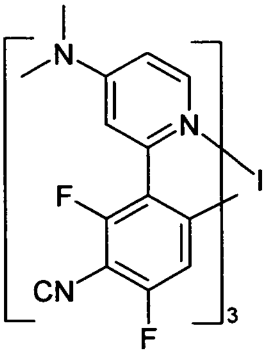 | 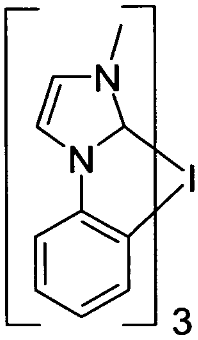 |
| | |
| 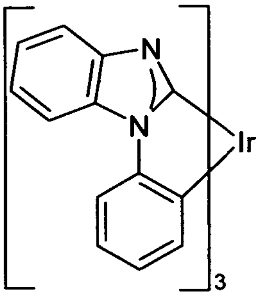 | 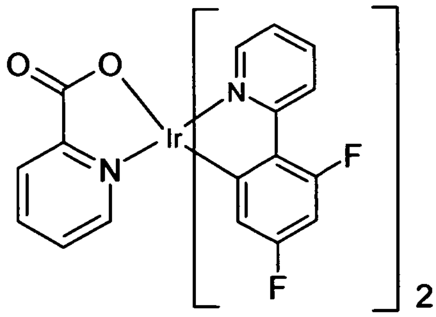 |
| | |
| 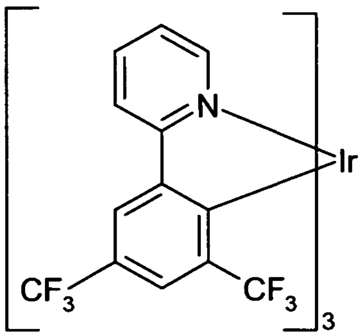 | 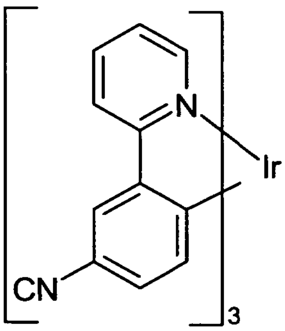 |
| | |
| 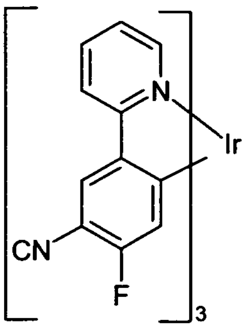 | 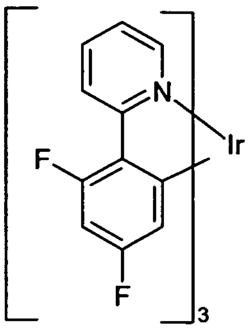 |
| | |

| | |
|---|---|
| 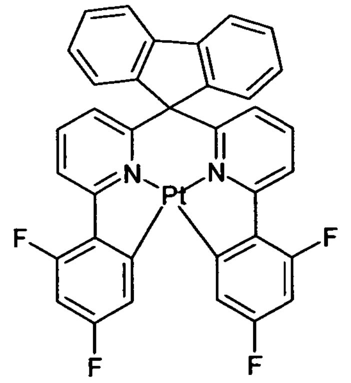 | 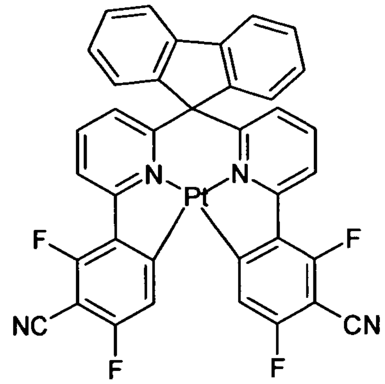 |
| | |
| 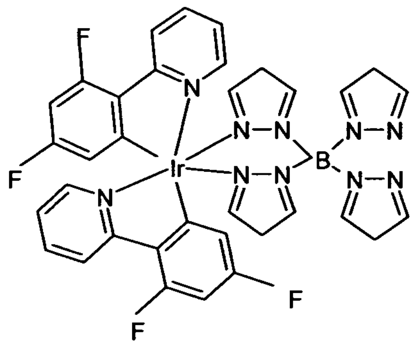 | 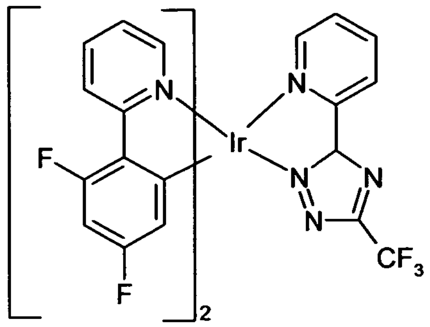 |
| | |
| 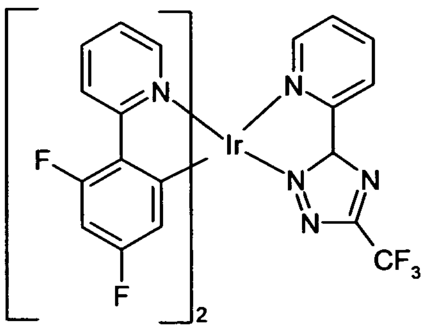 | 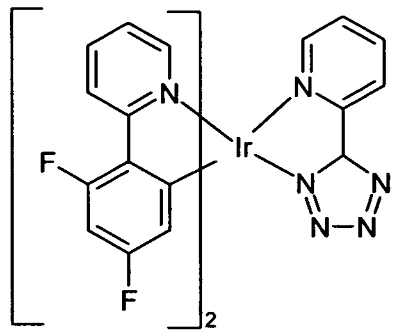 |
| | |
| 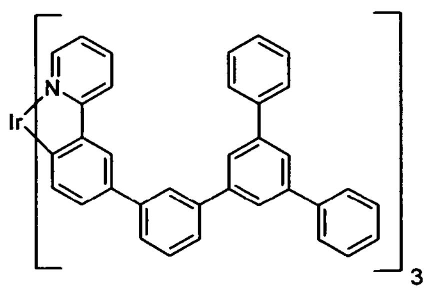 | 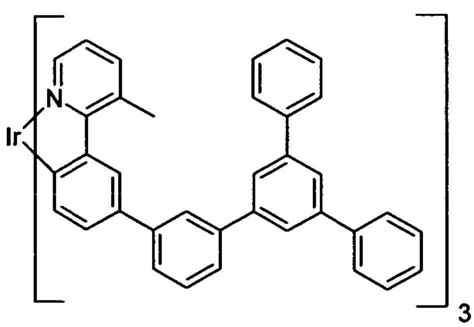 |
| | |

| | |
|---|---|
| 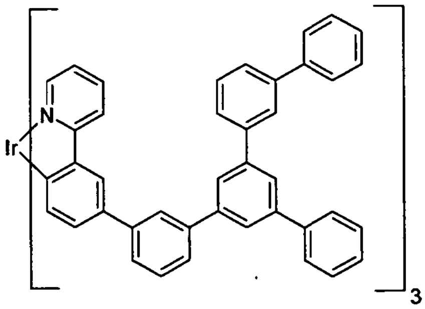 | 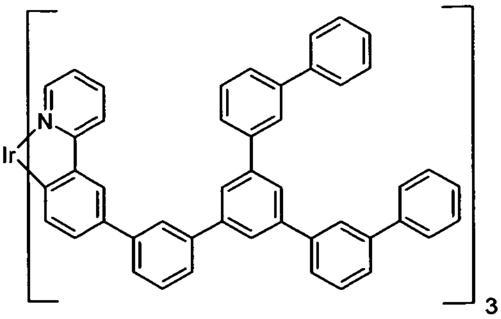 |
| | |
| 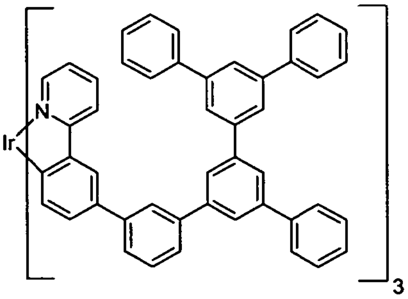 | 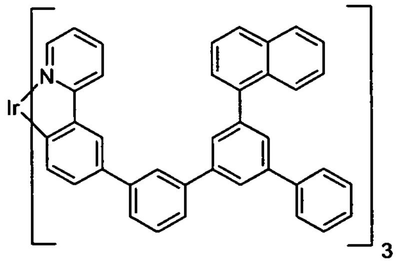 |
| | |
| 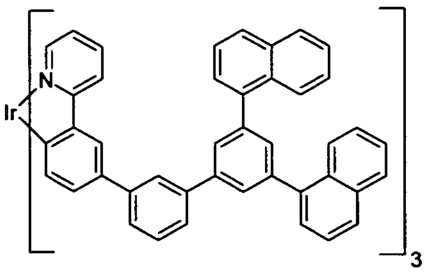 | 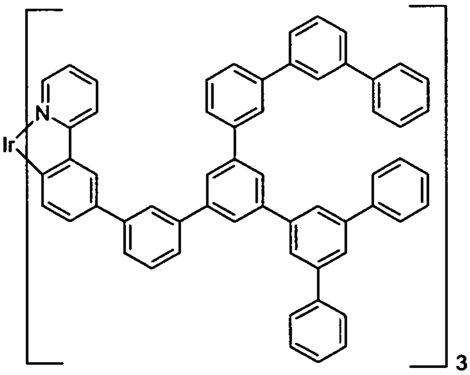 |
| | |
| 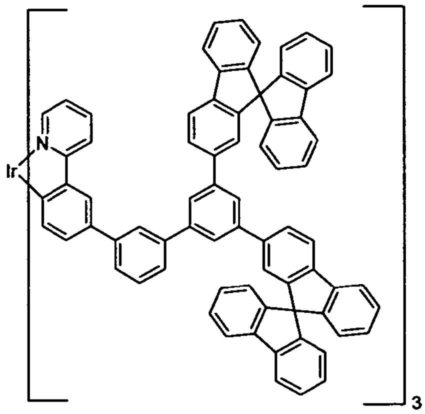 | 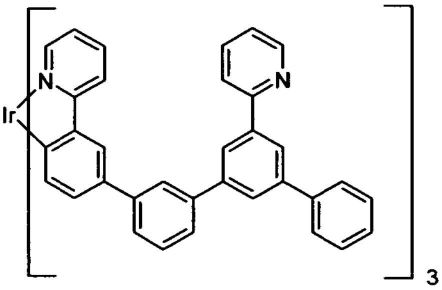 |
| | |

| | |
|---|---|
| 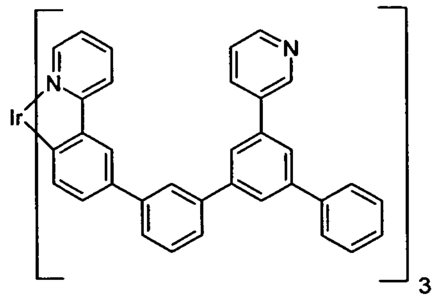 | 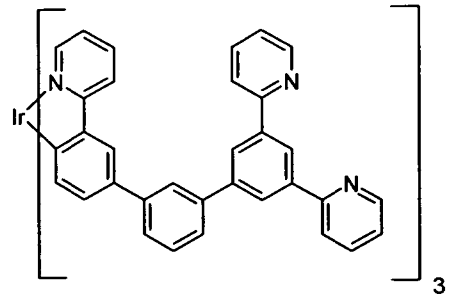 |
| | |
| 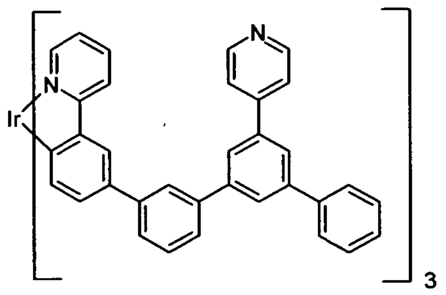 | 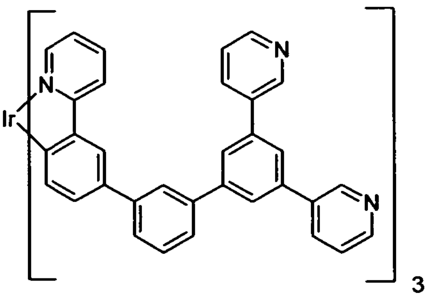 |
| | |
| 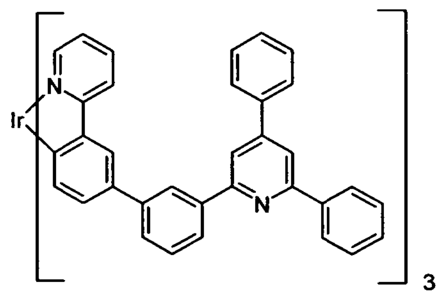 | 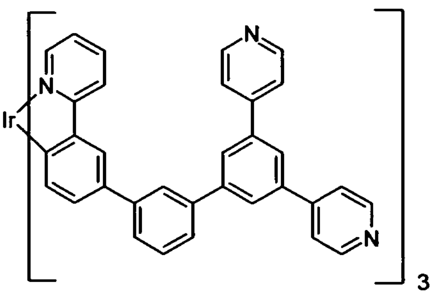 |
| | |
| 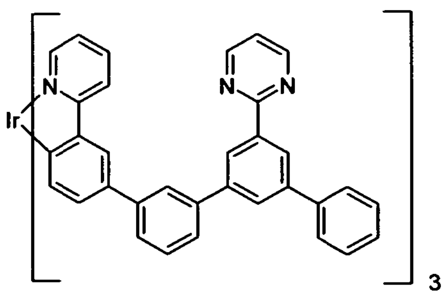 | 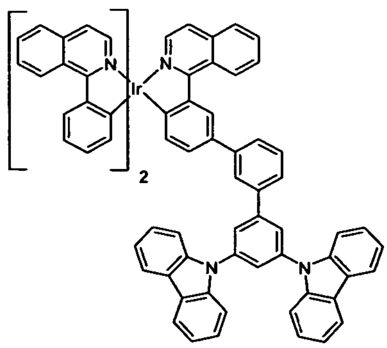 |
| | |

| | |
|---|---|
| 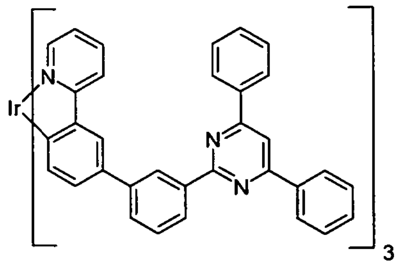 | 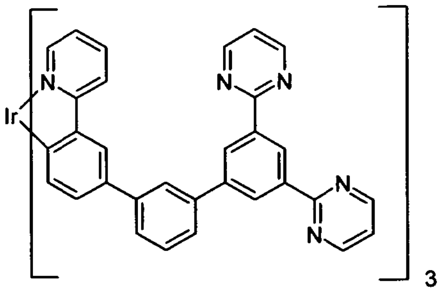 |
| | |
| 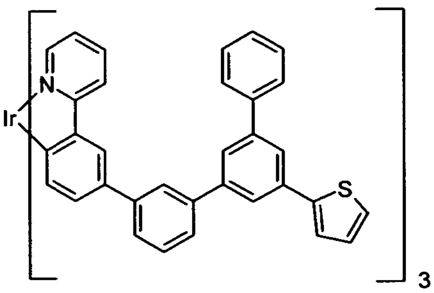 | 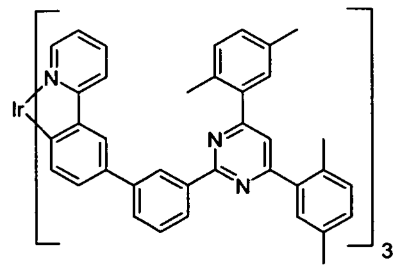 |
| | |
| 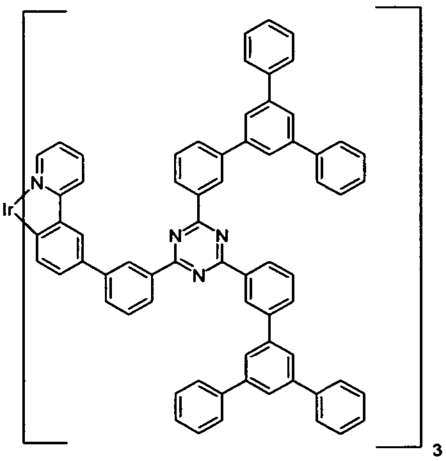 | 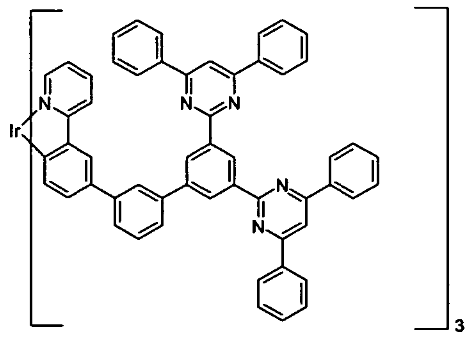 |
| | |
| 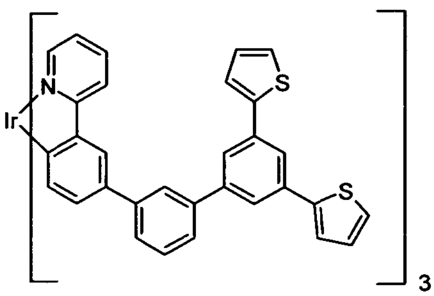 | 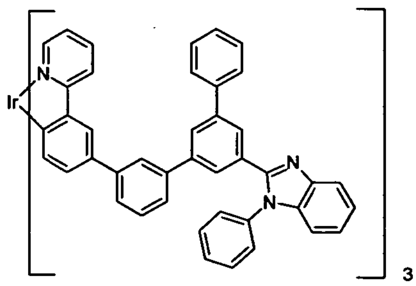 |
| | |

| | |
|---|---|
| 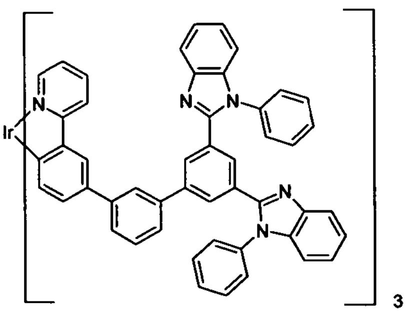 | 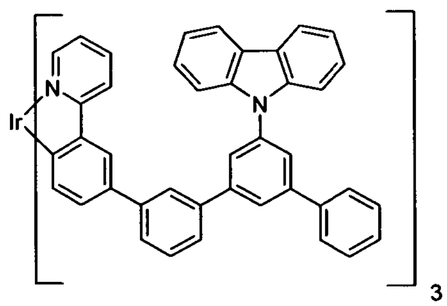 |
| | |
| 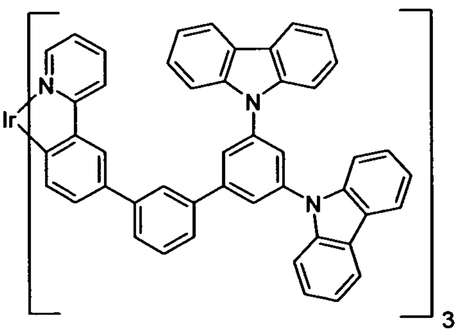 | 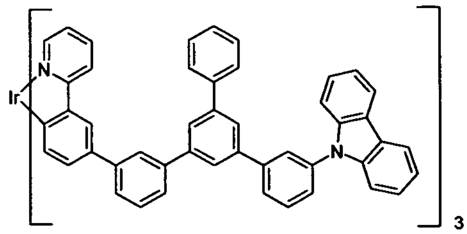 |
| | |
| 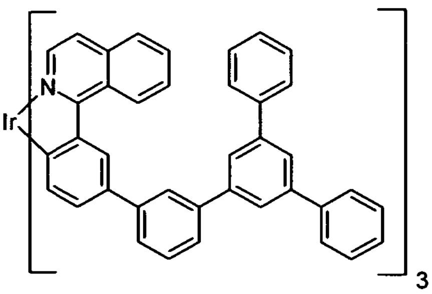 | 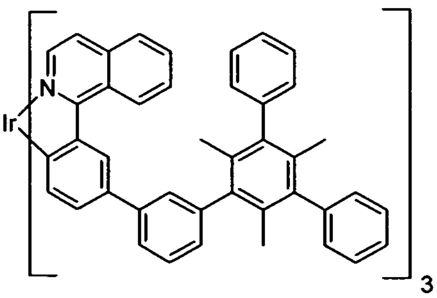 |
| | |
| 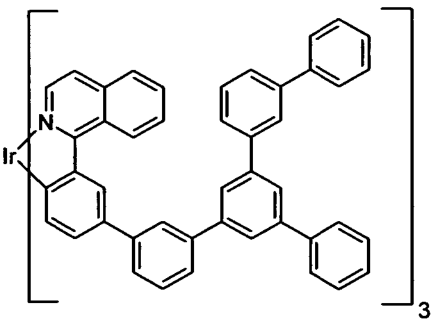 | 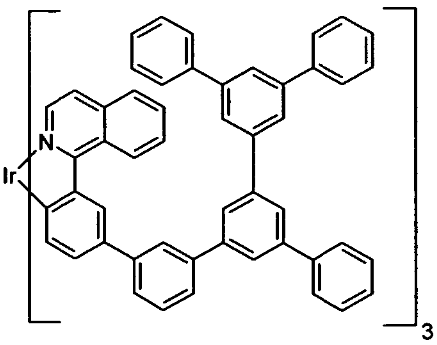 |
| | |

| | |
|---|---|
| 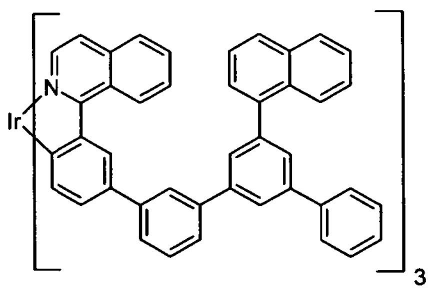 | 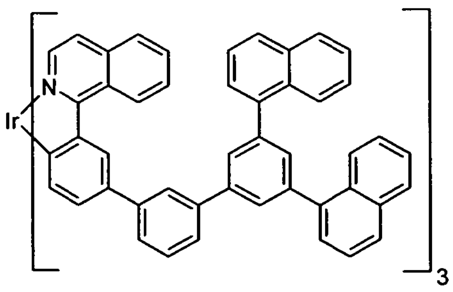 |
| | |
| 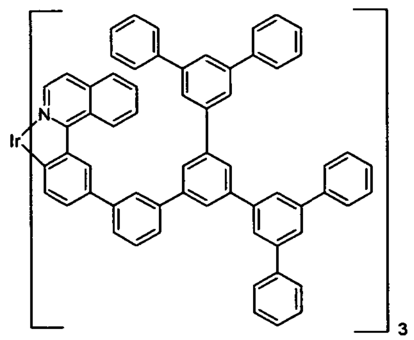 | 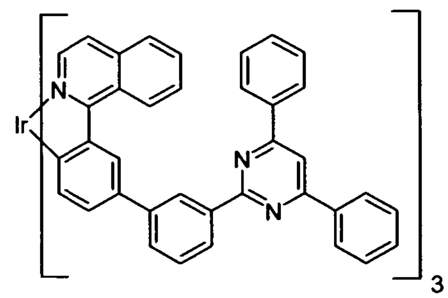 |
| | |
| 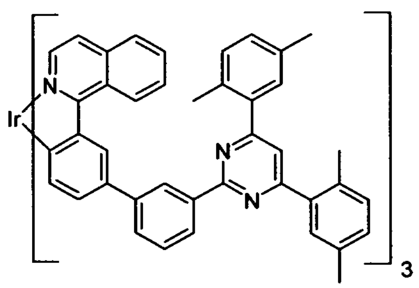 | 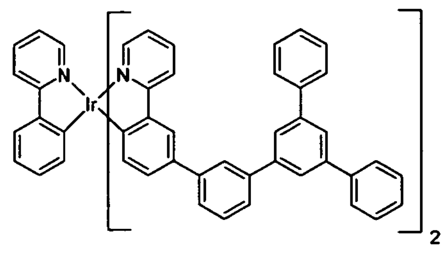 |
| | |
| 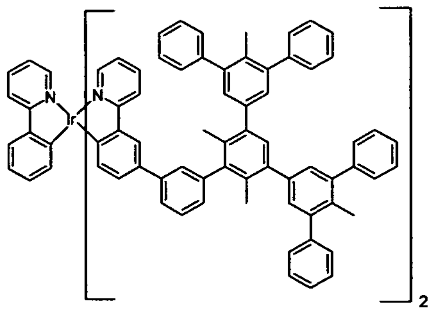 | 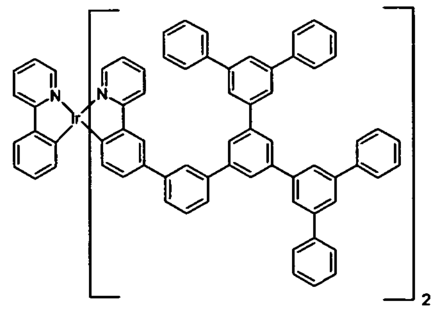 |
| | |

| | |
|---|---|
| 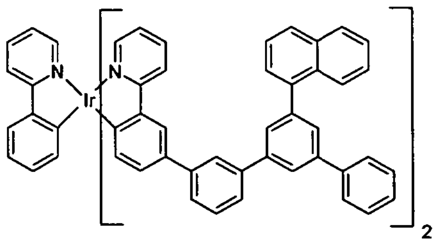 | 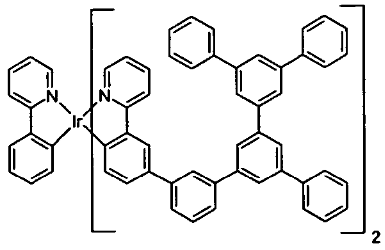 |
| | |
| 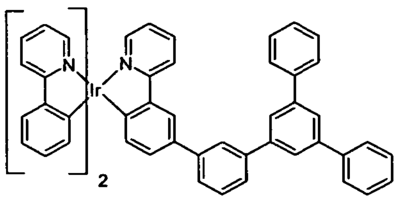 | 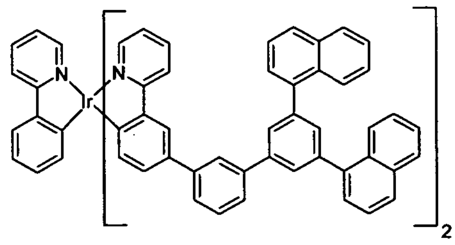 |
| | |
| 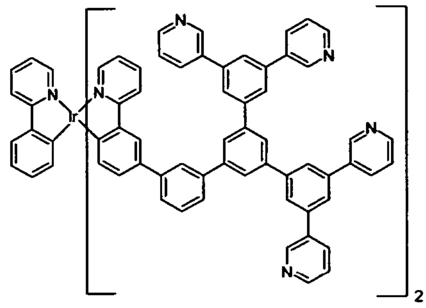 | 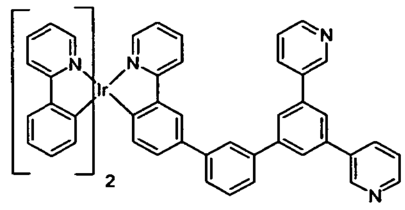 |
| | |
| 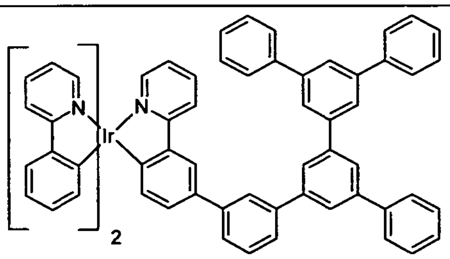 | 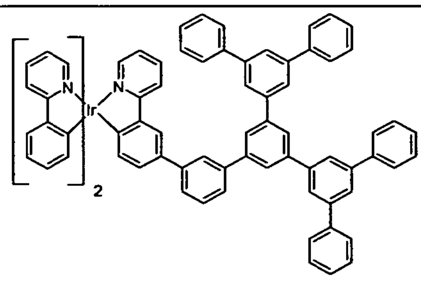 |
| | |
| 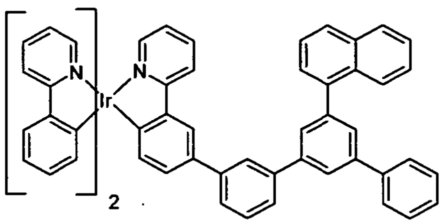 | 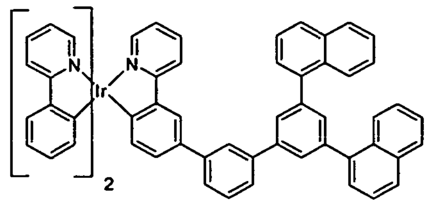 |
| | |

| | |
|---|---|
| 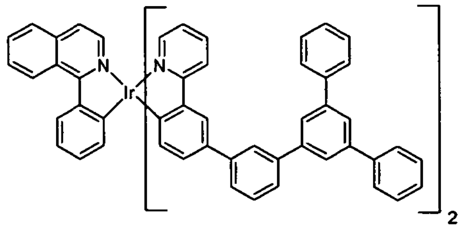 | 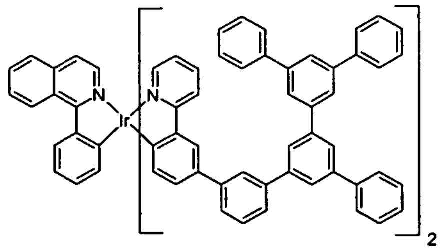 |
| | |
| 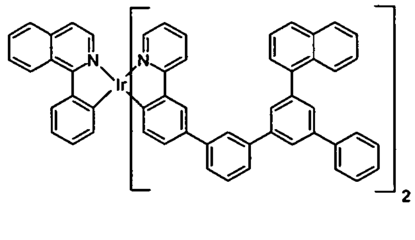 | 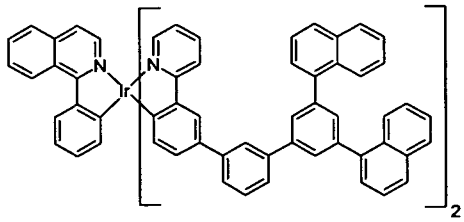 |
| | |
| 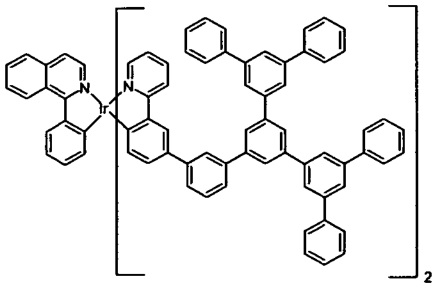 | 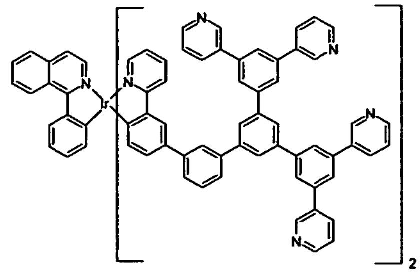 |
| | |
| 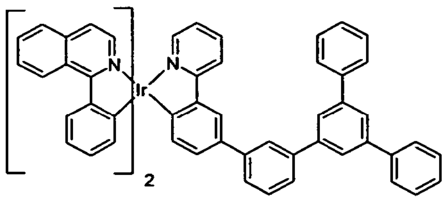 | 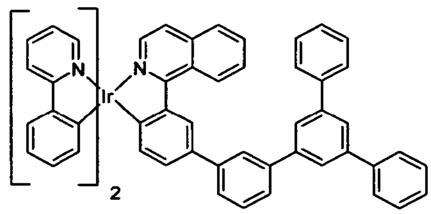 |
| | |
| 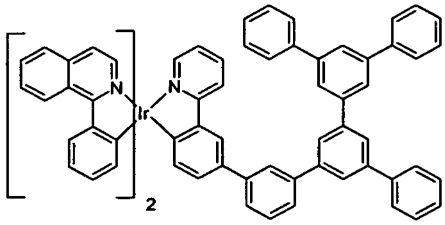 | 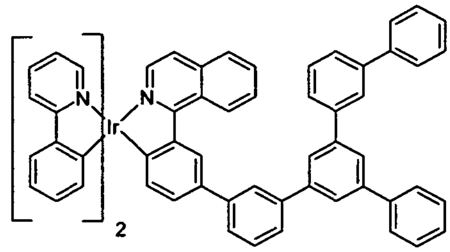 |
| | |

| | |
|---|---|
| 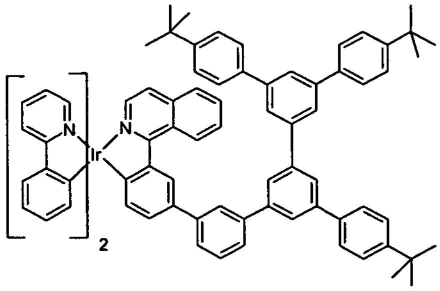 | 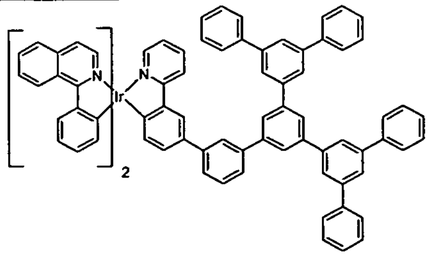 |
| | |
| 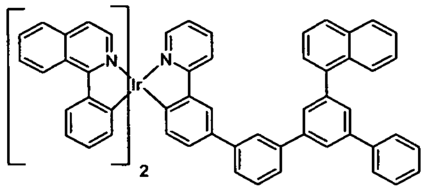 | 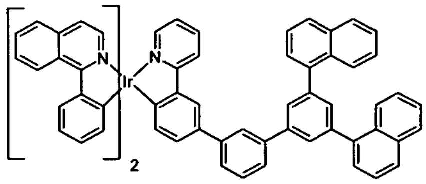 |
| | |
| 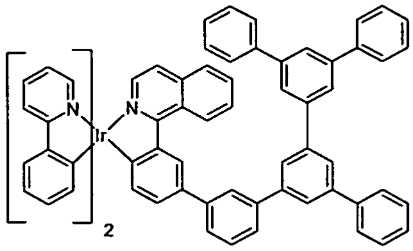 | 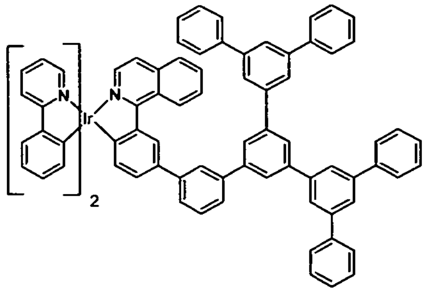 |
| | |
| 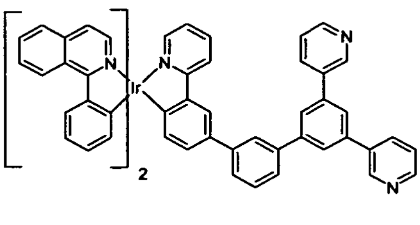 | 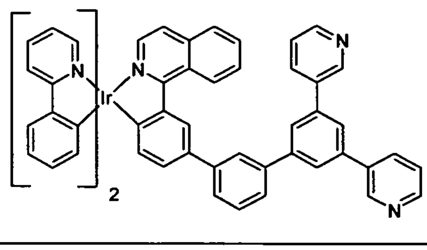 |
| | |
| 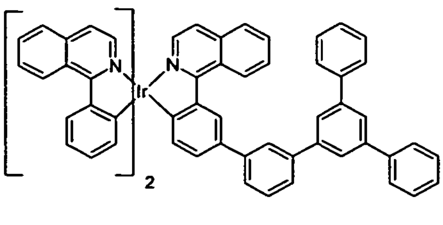 | 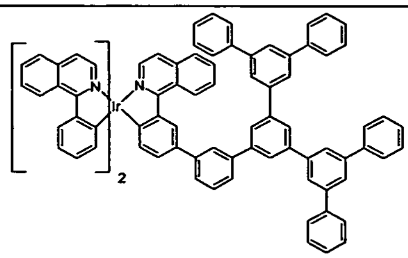 |
| | |

| |
|---|
| 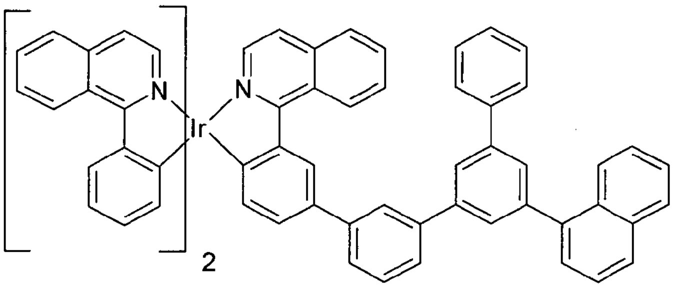 |
| 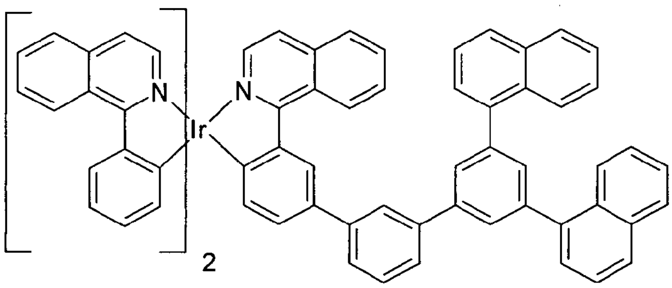 |
| 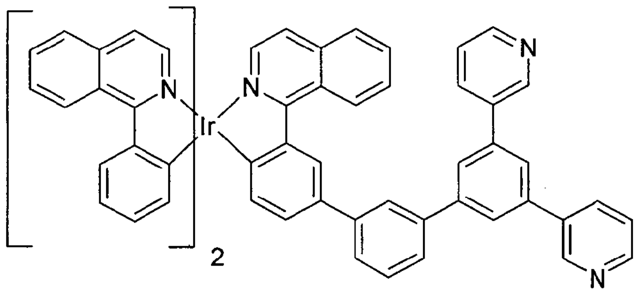 |
| 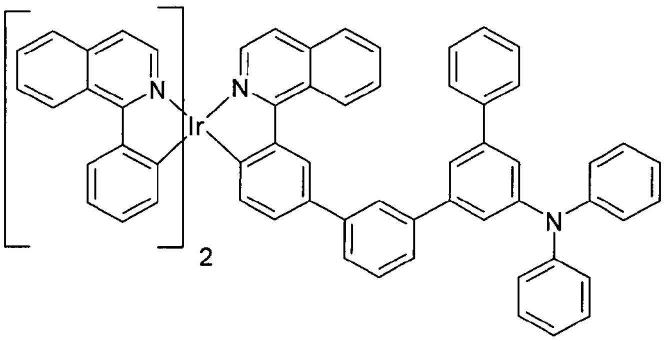 |
| 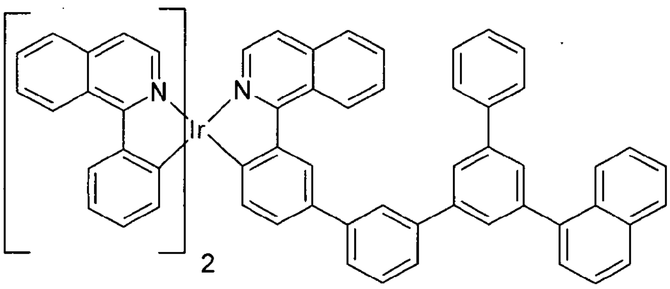 |

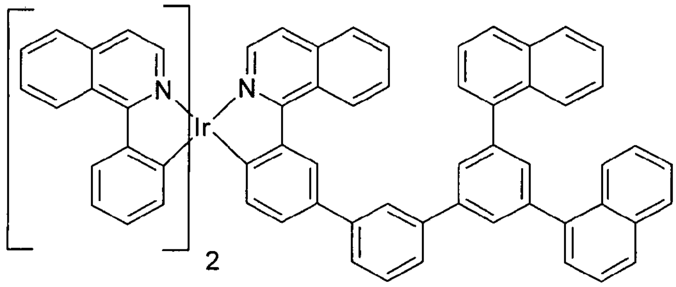

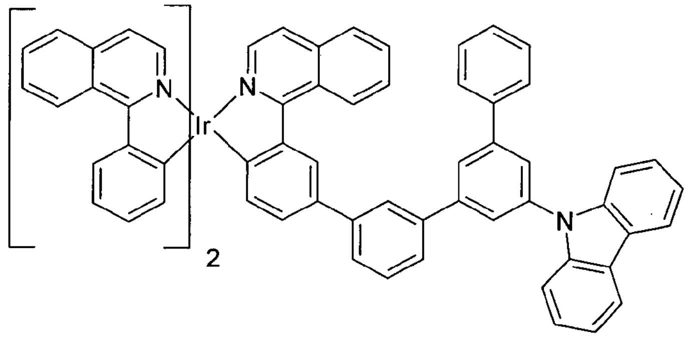

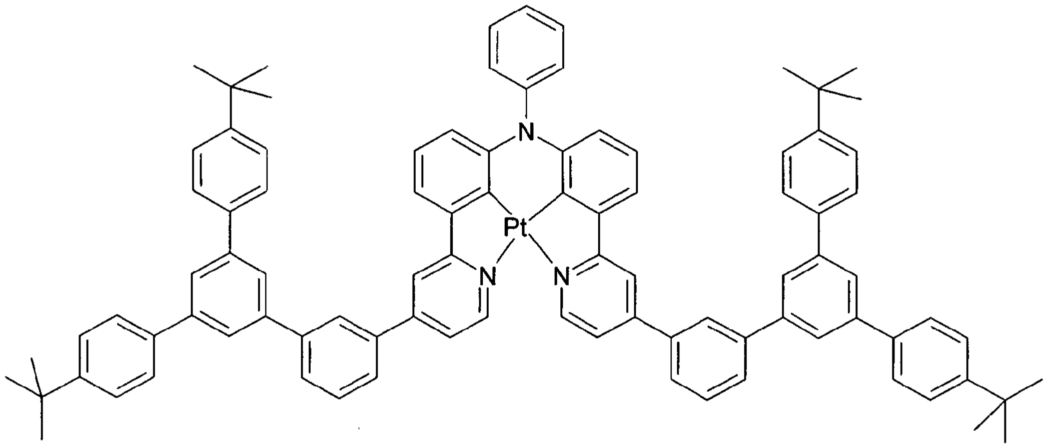

| |
|---|
| 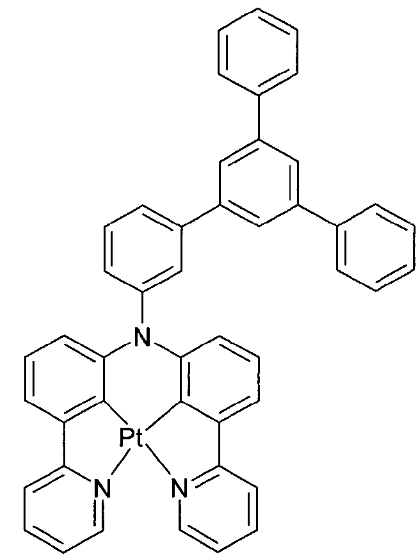 |
| 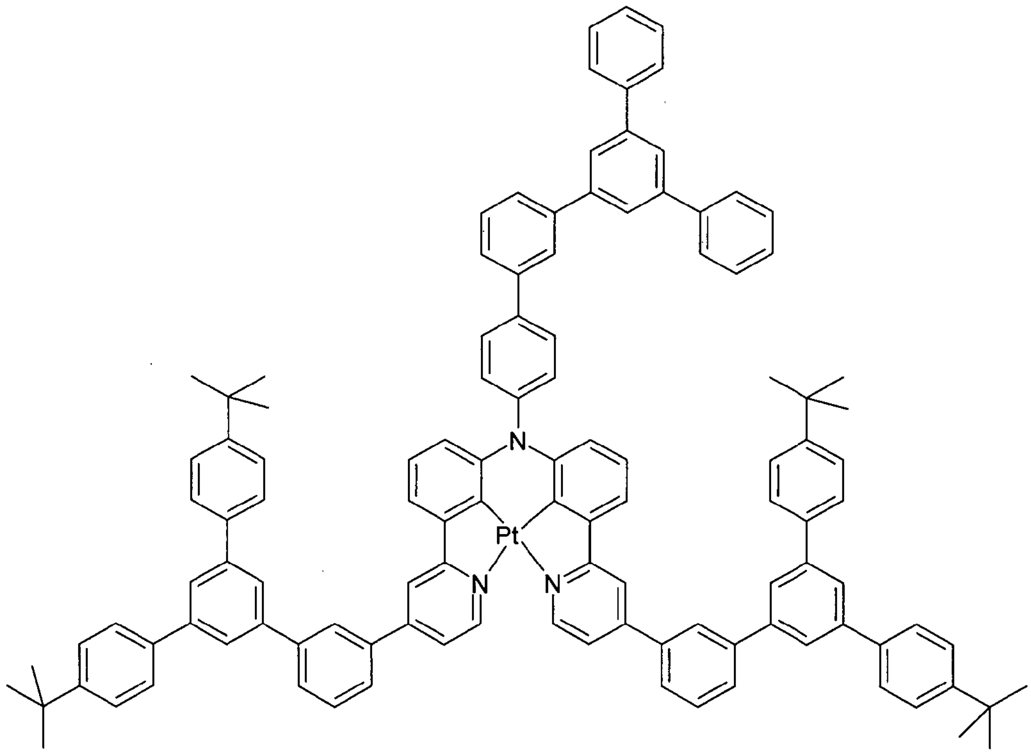 |

Preferred dopants are selected from the class of the monostyrylamines, the distyrylamines, the tristyrylamines, the tetrastyrylamines, the styryl-phosphines, the styryl ethers and the arylamines. A monostyrylamine is taken to mean a compound which contains one substituted or unsubstituted styryl group and at least one, preferably aromatic, amine. A distyrylamine is taken to mean a compound which contains two substituted or unsubstituted styryl groups and at least one, preferably aromatic, amine. A tristyrylamine is taken to mean a compound which contains three substituted or unsubstituted styryl groups and at least one, preferably aromatic, amine. A tetrastyrylamine is taken to mean a compound which contains four substituted or unsubstituted styryl groups and at least one, preferably aromatic, amine. The styryl groups are particularly preferably stilbenes, which may also be further substituted. Corresponding phosphines and ethers are defined analogously to the amines. For the purposes of the present invention, an arylamine or an aromatic amine is taken to mean a compound which contains three substituted or unsubstituted aromatic or heteroaromatic ring systems bonded directly to the nitrogen. At least one of these aromatic or heteroaromatic ring systems is preferably a condensed

ring system, particularly preferably having at least 14 aromatic ring atoms. Preferred examples thereof are aromatic anthraceneamines, aromatic anthracenediamines, aromatic pyreneamines, aromatic pyrenediamines, aromatic chryseneamines or aromatic chrysenediamines. An aromatic anthraceneamine is taken to mean a compound in which one diarylamino group is bonded directly to an anthracene group, preferably in the 9-position. An aromatic anthracenediamine is taken to mean a compound in which two diarylamino groups are bonded directly to an anthracene group, preferably in the 9,10-position. Aromatic pyreneamines, pyrenediamines, chryseneamines and chrysenediamines are defined analogously thereto, where the diarylamino groups are preferably bonded to the pyrene in the 1-position or in the 1,6-position. Further preferred dopants are selected from indenofluoreneamines or indenofluorenediamines, for example in accordance with WO 06/122630, benzoindenofluoreneamines or benzo-indenofluorenediamines, for example in accordance with WO 08/006449, and dibenzoindenofluoreneamines or dibenzoindenofluorenediamines, for example in accordance with WO 07/140847. Examples of dopants from the class of the styrylamines are substituted or unsubstituted tristilbeneamines or the dopants described in WO 06/000388, WO 06/058737,

WO 061000389, WO 07/065549 and WO 07/115610. Preference is furthermore given to the condensed hydrocarbons disclosed in DE 102008035413.

Suitable dopants are furthermore the structures depicted in the following table, and the derivatives of these structures disclosed in JP 06/001973, WO 04/047499, WO 06/098080, WO 07/065678, US 2005/0260442 and WO 04/092111.

| |
|---|
| 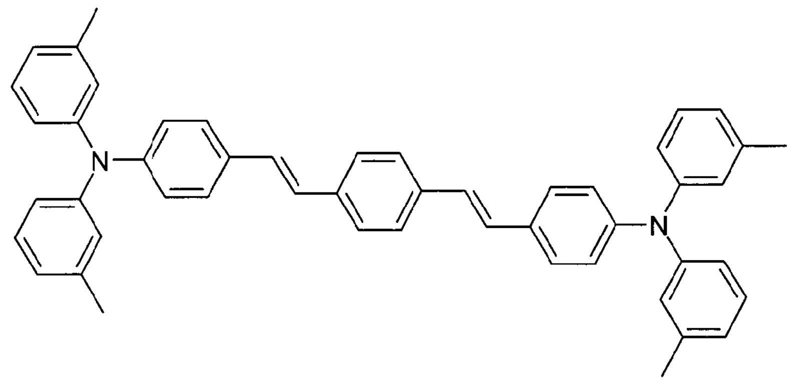 |
| 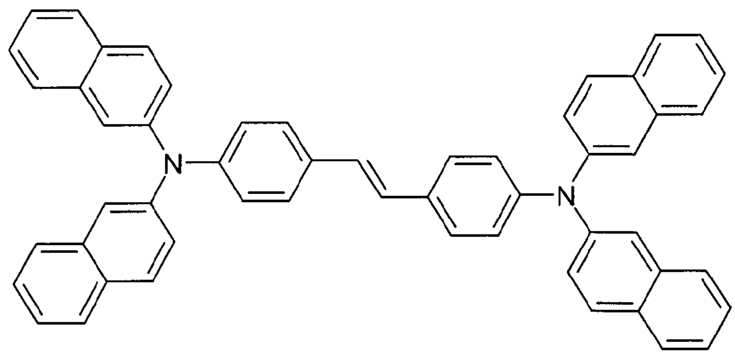 |

| |
|---|
| 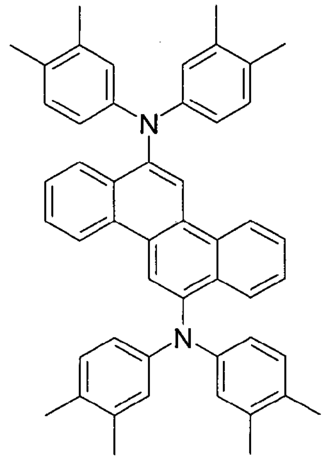 |
| 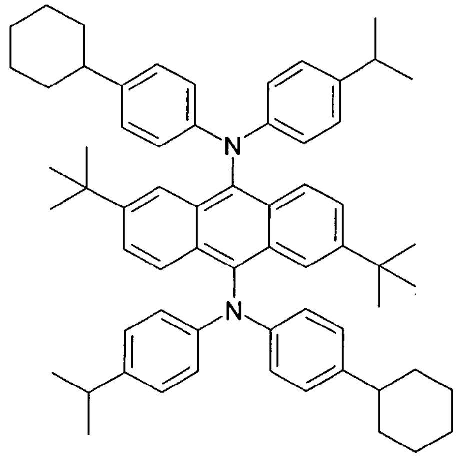 |
| 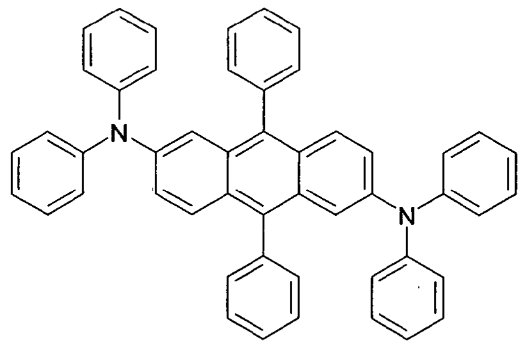 |

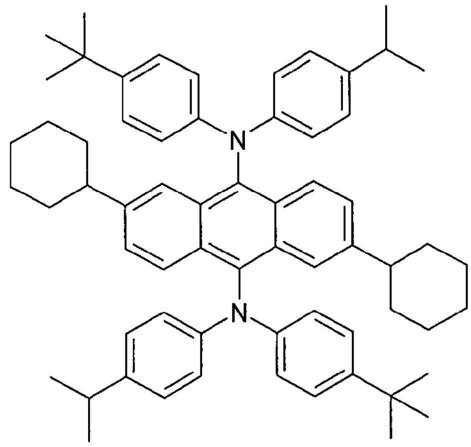

The proportion of the dopant in the mixture of the emitting layer is between 0.1 and 50.0 % by weight, preferably between 0.5 and 20.0 % by weight, particularly preferably between 1.0 and 10.0 % by weight. Correspondingly, the proportion of the host material is between 50.0 and 99.9 % by weight, preferably between 80.0 and 99.5 % by v, particularly preferably between 90.0 and 99.0 % by weight.

Suitable host materials for this purpose are materials from various classes of substance. Preferred host materials are selected from the classes of the oligoarylenes (for example 2,2',7,7'-tetraphenylspirobifluorene in accordance with EP 676461 or dinaphthylanthracene), in particular the oligoarylenes containing condensed aromatic groups, the oligoarylenevinylenes (for example DPVBi or spiro-DPVBi in accordance with EP 676461), the polypodal metal complexes (for example in accordance with WO 04/081017), the hole-conducting compounds (for example in accordance with WO 04/058911), the electron-conducting compounds, in particular ketones, phosphine oxides, sulfoxides, etc. (for example in accordance with WO 05/084081 and WO 05/084082), the atropisomers (for example in accordance with WO 06/048268), the boronic acid derivatives (for example in accordance with WO 06/117052) or the benzanthracenes (for example in accordance with WO 08/145239). Suitable host materials are furthermore also the benzo[c]phenanthrene compounds according to the invention which are described above. Particularly preferred host materials are selected from the classes of the oligoarylenes containing naphthalene, anthracene, benzanthracene and/or pyrene or atropisomers of these compounds, the oligoarylenevinylenes, the ketones, the phosphine oxides and the sulfoxides. Apart from the benzo[c]phenanthrene compounds, very particularly preferred host materials are selected from the classes of the oligoarylenes containing anthracene, benzanthracene and/or pyrene or atropisomers of these compounds. For the purposes of this invention, an oligoarylene is intended to be taken to mean a compound in which at least three aryl or arylene groups are bonded to one another. Suitable host materials are furthermore, for example, the materials depicted in the following table, and derivatives of these materials, as disclosed in WO 04/018587, WO 08/006449, US 5935721, US 2005/0181232,

JP 2000/273056, EP 681019, US 2004/0247937 and US 2005/0211958.

| | | |
|---|---|---|
| 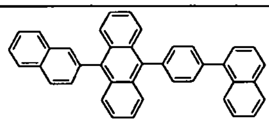 | 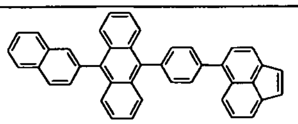 | 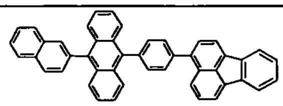 |
| | | |
| 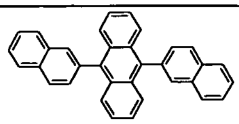 | 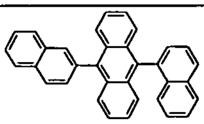 | 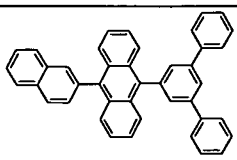 |
| | | |
| 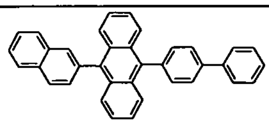 | 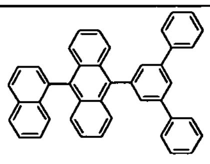 | 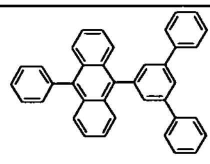 |
| | | |
| 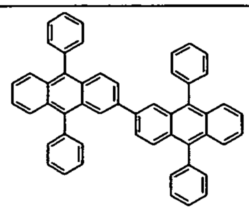 | 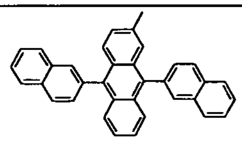 | 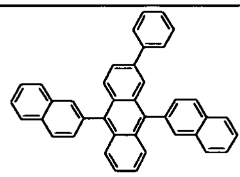 |

For the purposes of this invention, a hole-injection layer is a layer which is directly adjacent to the anode. For the purposes of this invention, a hole-transport layer is a layer which is located between a hole-injection layer and an emission layer. It may be preferred for them to be doped with electron-acceptor compounds, for example with $F_4$-TCNQ or with compounds as described in EP 1476881 or EP 1596445.

Suitable charge-transport materials, as can be used in the hole-injection or hole-transport layer or in the electron-injection or electron-transport layer of the organic electroluminescent device, are, for example, the compounds disclosed in Y. Shirota et al., Chem. Rev. 2007, 107(4), 953-1010, or other materials as employed in these layers in accordance with the prior art.

Examples of preferred hole-transport materials which can be used in a hole-transport or hole-injection layer of the electroluminescent device are indenofluoreneamines and derivatives (for example in accordance with WO 06/122630 or WO 06/100896), the amine derivatives as disclosed in EP 1661888, hexaazatriphenylene derivatives (for example in accordance with WO 01/049806), amine derivatives with condensed aromatics (for example in accordance with US 5,061,569), the amine derivatives as disclosed in WO 95/09147, monobenzoindenofluoreneamines (for example in accordance with WO 08/006449) or dibenzoindenofluoreneamines (for example in accordance with WO 07/140847). Suitable hole-transport and hole-injection materials are furthermore derivatives of the compounds depicted above, as disclosed in JP 2001/226331, EP 676461, EP 650955, WO 01/049806, US 4780536, WO 98/30071, EP 891121, EP 1661888, JP 2006/253445, EP 650955, WO 06/073054 and US 5061569.

Suitable hole-transport or hole-injection materials are furthermore, for example, the materials indicated in the following table.

| | | |
|---|---|---|
| 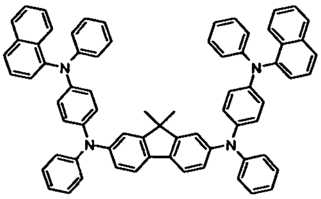 | 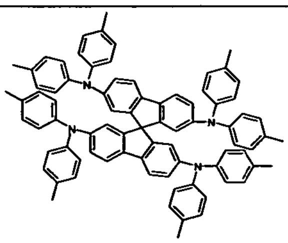 | 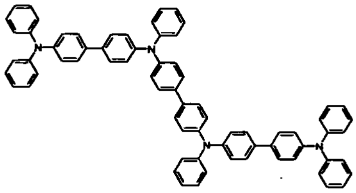 |
| | | |
| 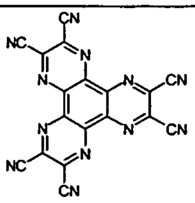 | 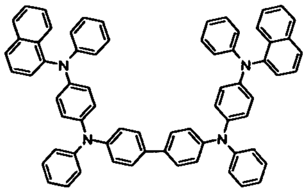 | 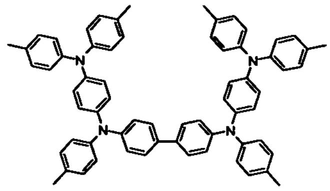 |
| | | |

| | |
|---|---|
| 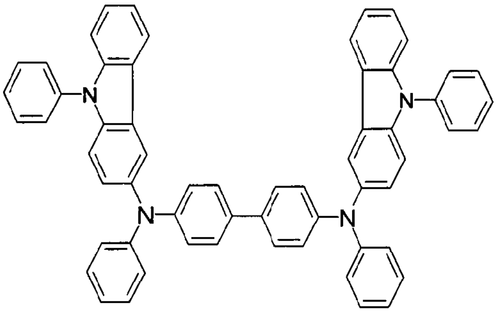 | 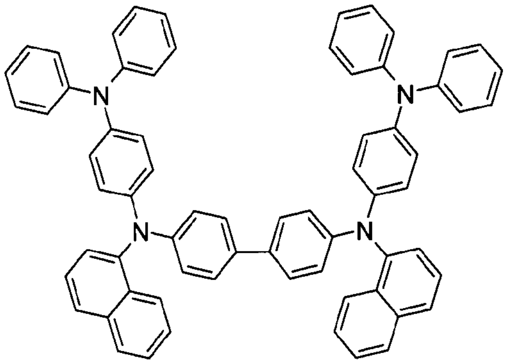 |
| 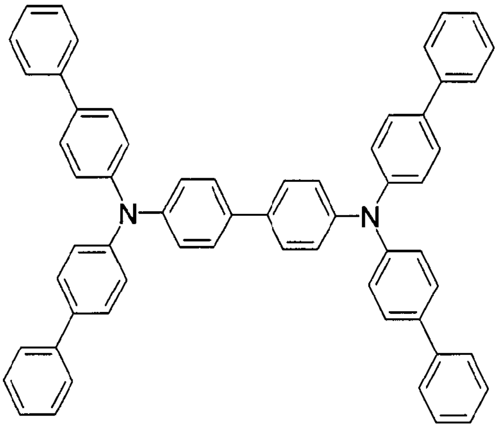 | 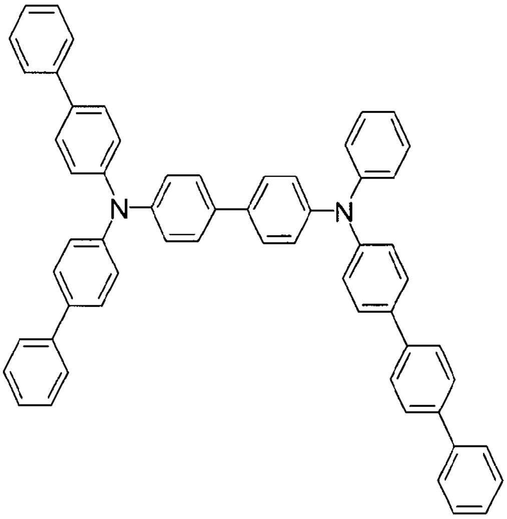 |
| 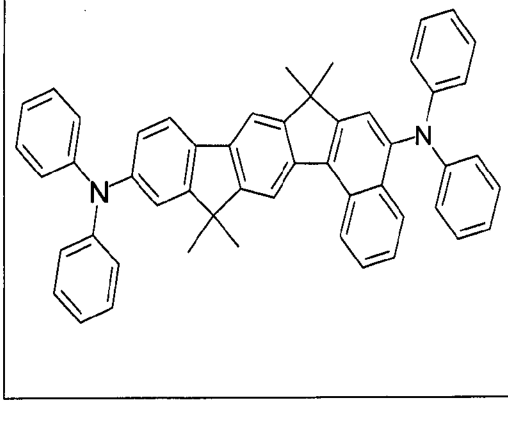 | 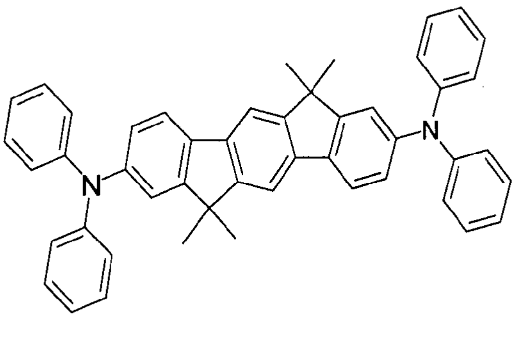 |

| | |
|---|---|
| 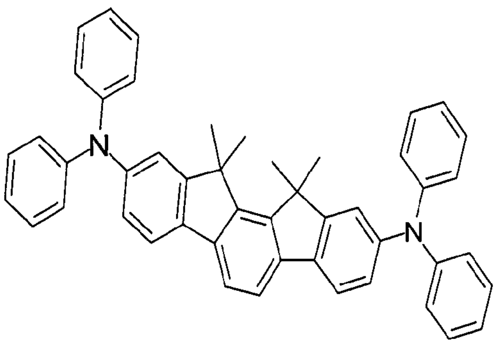 | 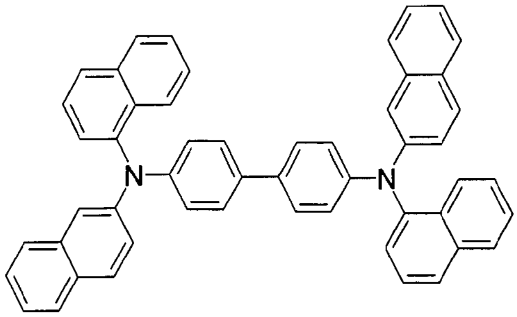 |
| 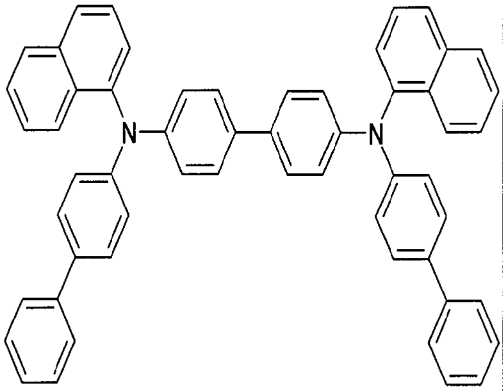 | 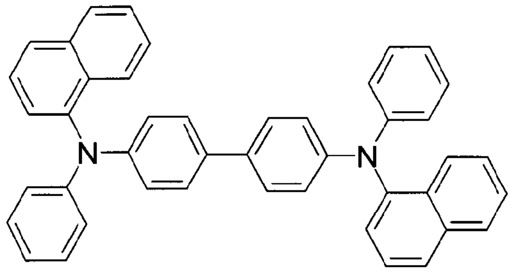 |
| 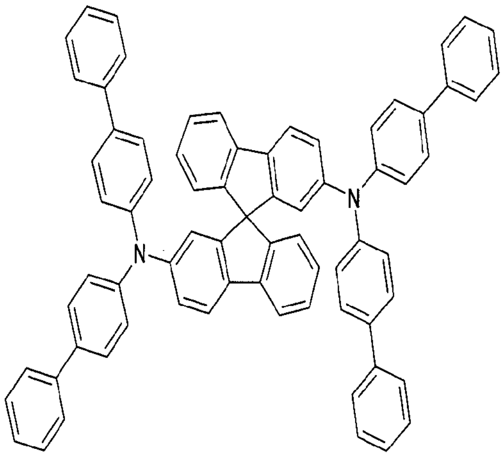 | 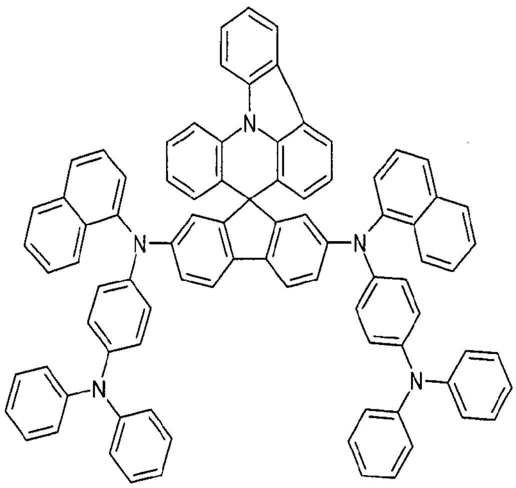 |

Suitable electron-transport or electron-injection materials which can be used in the electroluminescent device are, for example, the materials indicated in the following table. Suitable electron-transport and electron-injection materials

are furthermore derivatives of the compounds depicted above, as disclosed in JP 2000/053957, WO 03/060956, WO 04/028217 and WO 04/080975.

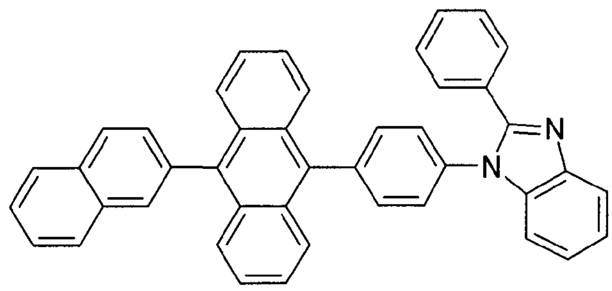

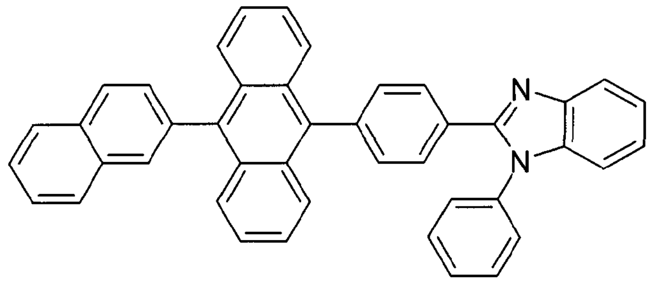

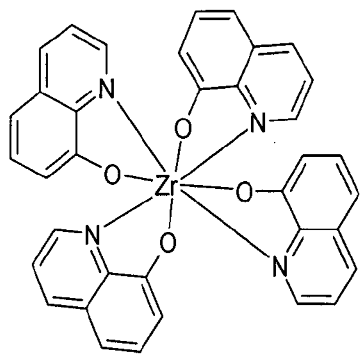

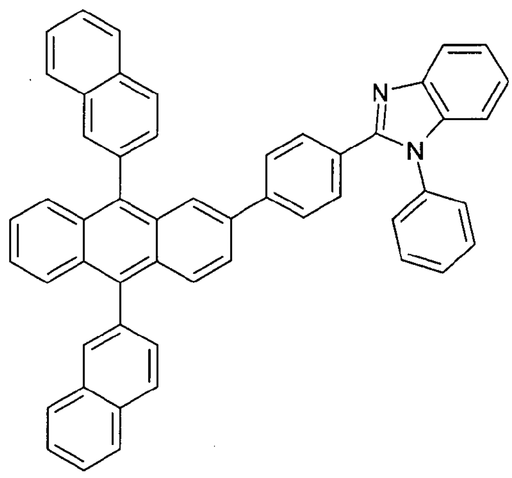

Suitable matrix materials for the compounds are ketones, phosphine oxides, sulfoxides and sulfones, for example in accordance with WO 04/013080, WO 04/093207, WO 06/005627 or DE 102008033943, triarylamines, carbazole derivatives, for example CBP (N,N-biscarbazolyl-biphenyl) or the carbazole derivatives disclosed in WO 05/039246, US 2005/0069729, JP 2004/288381, EP 1205527 or WO 08/086851, indolocarbazole derivatives, for example in accordance with WO 07/063754 or WO 08/056746, azacarbazoles, for example in accordance with EP 1617710, EP 1617711, EP 1731584, JP 2005/347160, bipolar matrix materials, for example in accordance with WO 07/137725, silanes, for example in accordance with WO 05/111172, azaboroles or boronic esters, for example in accordance with WO 06/117052, triazine derivatives, for example in accordance with DE 102008036982, WO 07/063754 or WO 08/056746, or zinc complexes,

for example in accordance with DE 102007053771.

Especially preferred host materials, hole-transport materials, electron- or exciton-blocking materials, matrix materials for fluorescent or phosphorescent compounds, hole-blocking materials or electron-transport materials comprise one or more compounds according to formula (H1)

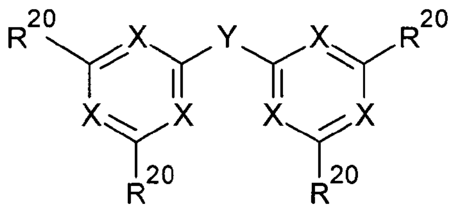

formula (H1)

where the following applies to the symbols used:

- Y is C=O or $C(R^{21})_2$;
- X is on each occurrence, identically or differently, $CR^{22}$ or N;
- $R^{20}$ is on each occurrence, identically or differently, an aromatic or hetero-aromatic ring system having 5 to 60 aromatic ring atoms, which may be substituted by one or more radicals $R^{23}$, or an $N(Ar)_2$, $Si(Ar)_3$, C(=O)Ar, OAr, ArSO, $ArSO_2$, $P(Ar)_2$, $P(O)(Ar)_2$ or $B(Ar)_2$ group;
- Ar is on each occurrence, identically or differently, an aromatic or hetero-aromatic ring system having 5 to 30 aromatic ring atoms, which may be substituted by one or more non-aromatic radicals $R^{23}$; two radicals Ar here which are bonded to the same nitrogen, phosphorus or boron atom may also be linked to one another by a single bond or a bridge selected from $B(R^{24})$, $C(R^{24})_2$, $Si(R^{24})_2$, C=O, C=N $R^{24}$, $C=C(R^{24})_2$, O, S, S=O, $SO_2$, $N(R^{24})$, $P(R^{24})$ and P(=O) $R^{24}$;
- $R^{21}$ is on each occurrence, identically or differently, H, D, F or a linear alkyl group having 1 to 20 C atoms or a branched or cyclic alkyl group having 3 to 20 C atoms; a plurality of radicals $R^{21}$ here may form a ring system with one another;
- $R^{22}$ is on each occurrence, identically or differently, H, D, F, CN, a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals $R^{24}$, where one or more non-adjacent $CH_2$ groups may be replaced by $R^{24}C=C\ R^{24}$, C=C, O or S and where one or more H atoms may be replaced by F;
- $R^{23}$ is on each occurrence, identically or differently, H, D, F, Cl, Br, I, CHO, $N(Ar)_2$, C(=O)Ar, $P(=O)(Ar)_2$, S(=O)Ar, $S(=O)_2Ar$, $CR^{22}=CR^{22}Ar$, CN, $NO_2$, $Si(R^{24})_3$, $B(O\ R^{24})_2$, $B(R^{24})_2$, $B(N(R^{24})_2)_2$, $OSO_2\ R^{24}$, a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals $R^{24}$, where one or more non-adjacent $CH_2$ groups may be replaced by $R^{24}C=C\ R^{24}$, C≡C, $Si(R^{24})_2$, $Ge(R^{24})_2$, $Sn(R^{24})_2$, C=O, C=S, C=Se, C=N $R^{24}$, P(=O)( $R^{24}$), SO, $SO_2$, $R^{24}$, O, S or CON $R^{24}$ and where one or more H atoms may be replaced by F, Cl, Br, I, CN or $NO_2$, or an aromatic or heteroaromatic ring system having 5 to 60 aromatic ring atoms, which may in each case be substituted by one or more radicals $R^{24}$, or an aryloxy or heteroaryloxy group having 5 to 60 aromatic ring atoms, which may be substituted by one or more radicals $R^{24}$, or a combination of these systems; two or more adjacent substituents $R^{23}$ here may also form a mono- or polycyclic, aliphatic or aromatic ring system with one another;
- $R^{24}$ is on each occurrence, identically or differently, H, D or an aliphatic, aromatic and/or heteroaromatic hydrocarbon radical having 1 to 20 C atoms, in which, in addition, H atoms may be replaced by F; two or more adjacent substituents $R^{24}$ here may also form a mono- or poly-cyclic, aliphatic or aromatic ring system with one another.

More preferably, compounds according to according to formula (H1a) can be used

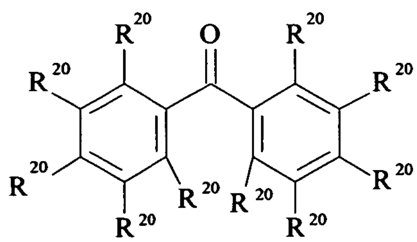

(H1a),

wherein the residue $R^{20}$ has the same meaning as in formula (H1)

More preferably, compounds according to according to formula (H1b) can be used

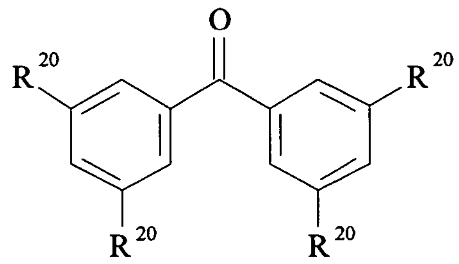

(H1b),

wherein the residue $R^{20}$ has the same meaning as in formula (H1) Preferably, the compounds according to formulae (H1), (H1a) and/or (H1b), may comprise a solubilizing structure element as described, e. g. in document WO 2011/076325 referring to formulae (L-I), (L-II) and (L-III), respectively.

Especially preferred host materials, hole-transport materials, electron- or exciton-blocking materials, matrix materials for fluorescent or phosphorescent compounds, hole-blocking materials or electron-transport materials comprise one or more compounds according to formula (H2a) and/or (H2b)

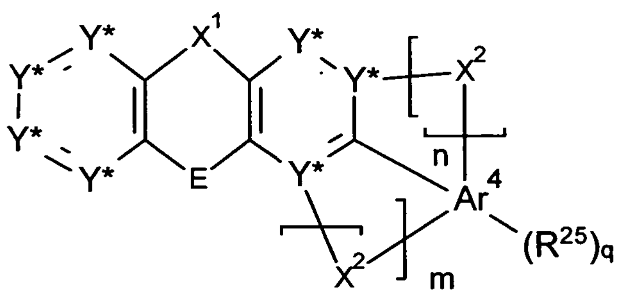

(H2a)

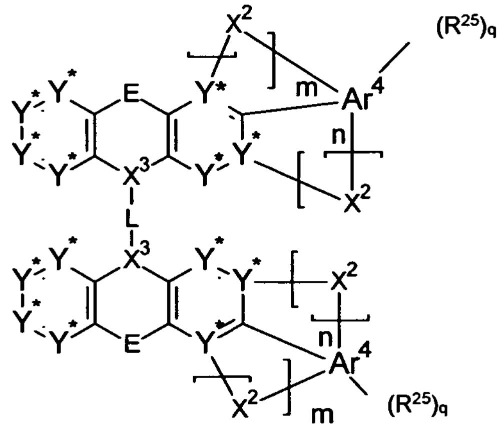

(H2b)

where the following applies to the symbols used:

- Y* is C if a group $X^2$ is bonded to the group Y, or is on each occurrence, identically or differently, $CR^{25}$ or N if no group $X^2$ is bonded to the group Y;
- E is on each occurrence, identically or differently, a covalent single bond or a divalent bridge selected from $N(R^{26})$, $B(R^{26})$, $C(R^{26})_2$, O, $Si(R^{26})_2$, C=N $R^{26}$, $C=C(R^{26})_2$, S, S=O, $SO_2$, $P(R^{26})$ and P(=O) $R^{26}$;
- $X^1$ is on each occurrence, identically or differently, a divalent bridge selected from $N(R^{26})$, $B(R^{26})$, O, $C(R^{26})_2$, $Si(R^{26})_2$, C=N $R^{26}$, $C=C(R^{26})_2$, S, S=O, $SO_2$, $P(R^{26})$ and P(=O) $R^{26}$;
- $X^2$ is on each occurrence, identically or differently, a divalent bridge selected from $N(R^{26})$, $B(R^{26})$, $C(R^{26})_2$, $Si(R^{26})_2$, C=O, C=N $R^{26}$, $C=C(R^{26})_2$, S, S=O, $SO_2$, C $R^{26}$-C $R^{26}$, $P(R^{26})$ and P(=O) $R^{26}$;
- $X^3$ is on each occurrence, identically or differently, a divalent bridge selected from N, B, $C(R^{26})$, $Si(R^{26})$, P and P(=O);
- L is a divalent aromatic or heteroaromatic ring system having 5 to 40 aromatic ring atoms, which may be substituted

by one or more radicals $R^{26}$;

n, m are, identically or differently on each occurrence, 0 or 1, with the proviso that n + m = 1 or 2;

q is 1, 2, 3, 4, 5 or 6;

$R^{25}$ is on each occurrence, identically or differently, H, D, F, Cl, Br, I, $N(Ar)_2$, C(=O) $Ar^4$, P(=O) $Ar^4{}_2$, S(=O) $Ar^4$, $S(=O)_2$ $Ar^4$, $CR^{27}$=C $R^{27}$ $Ar^4$, CN, $NO_2$, $Si(R^{27})_3$, B(O $R^{27})_2$, $OSO_2$ $R^{27}$, a straight-chain alkyl, alkoxy or thioalkoxy group having 1 to 40 C atoms or a branched or cyclic alkyl, alkoxy or thioalkoxy group having 3 to 40 C atoms, each of which may be substituted by one or more radicals $R^{27}$, where one or more non-adjacent $CH_2$ groups may be replaced by $R^{27}$C=C $R^{27}$, C≡C, $Si(R^{27})_2$, $Ge(R^{27})_2$, $Sn(R^{27})_2$, C=O, C=S, C=Se, C=N $R^{27}$, P(=O)( $R^{27}$), SO, $SO_2$, N $R^{27}$, O, S or CON $R^{27}$ and where one or more H atoms may be replaced by D, F, Cl, Br, I, CN or $NO_2$, or an aryl or heteroaryl group having 5 to 40 ring atoms, which may in each case be substituted by one or more radicals $R^{27}$, or an aromatic or heteroaromatic ring system having 5 to 60 aromatic ring atoms, which may in each case be substituted by one or more radicals $R^{27}$, or an aryloxy or heteroaryloxy group having 5 to 40 aromatic ring atoms, which may be substituted by one or more radicals $R^{27}$, or an aralkyl or heteroaralkyl group having 5 to 40 aromatic ring atoms, which may be substituted by one or more radicals $R^{27}$, or a combination of these systems; two or more substituents R here, together with the atoms to which they are bonded, may also form a mono- or polycyclic aliphatic or aromatic ring system with one another or, if they are bonded to $Ar^4$, with $Ar^4$;

$R^{26}$ is on each occurrence, identically or differently, H, D, F, Cl, Br, I, CN, $NO_2$, $CF_3$, $B(OR^{27})_2$, $Si(R^{27})_3$, a straight-chain alkyl, alkoxy or thioalkoxy group having 1 to 40 C atoms or a branched or cyclic alkyl, alkoxy or thioalkoxy group having 3 to 40 C atoms, or an alkenyl or alkynyl group having 2 to 40 C atoms, each of which may be substituted by one or more radicals $R^{27}$, where one or more non-adjacent $CH_2$ groups may be replaced by $-R^{27}C=CR^{27}-$, -C≡C-, $Si(R^{27})_2$, $Ge(R^{27})_2$, $Sn(R^{27})_2$, C=O, C=S, C=Se, C=N $R^{27}$, -O-, -S-, -COO- or -CON $R^{27}$- and where one or more H atoms may be replaced by F, Cl, Br, I, CN or $NO_2$, or arylamines, or substituted or unsubstituted carbazoles, which may in each case be substituted by one or more radicals $R^{27}$, or an aryl or heteroaryl group having 5 to 40 ring atoms, which may be substituted by one or more aromatic, heteroaromatic or non-aromatic radicals $R^{27}$, or an aromatic or heteroaromatic ring system having 5 to 60 aromatic ring atoms, which may be substituted by one or more non-aromatic radicals $R^{27}$, or an aryloxy or heteroaryloxy group having 5 to 40 aromatic ring atoms, which may be substituted by one or more radicals $R^{27}$, or an aralkyl or heteroaralkyl group having 5 to 40 aromatic ring atoms, which may be substituted by one or more radicals $R^{27}$, or a combination of these systems; two or more substituents $R^{26}$ here may also form a mono- or polycyclic aliphatic or aromatic ring system with one another, together with the atoms to which they are bonded;

$R^{27}$ is on each occurrence, identically or differently, H, D or an aliphatic hydrocarbon radical having 1 to 20 C atoms or an aryl or heteroaryl group having 5 to 40 ring atoms, or a combination of these groups;

$Ar^4$ is on each occurrence, identically or differently, an aromatic or heteroaromatic ring system, preferably an aryl or heteroaryl group having 5 to 40 ring atoms, which may be substituted by one or more radicals $R^{26}$.

Preferably, the compounds according to formulae (H2a) and/or (H2b) may comprise a solubilizing structure element as described, e. g. in document WO 2011/076325 referring to formulae (L-I), (L-II) and (L-III), respectively.

Especially preferred host materials, hole-transport materials, electron- or exciton-blocking materials, matrix materials for fluorescent or phosphorescent compounds, hole-blocking materials or electron-transport materials comprise one or more compounds according to formula (H3a) and/or formula (H3b) and/or

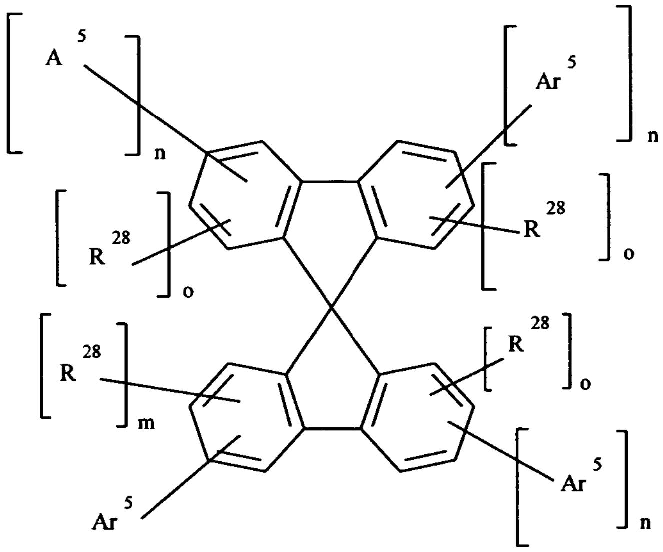

formula

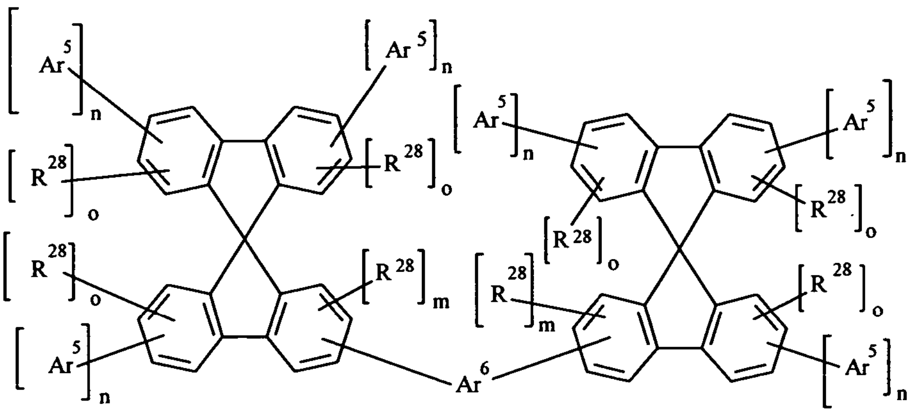

formula (H3b)

where the following applies to the symbols and indices used:

$Ar^5$ is a group of the following formula (H3c):

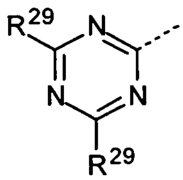

formula (H3c)

where the dashed bond indicates the bond to the spirobifluorene;

$Ar^6$ is a group of the following formula (H3d):

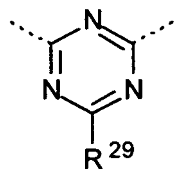

formula (H3d)

where the dashed bonds indicate the bonds to the spirobifluorene;

$R^{28}$, $R^{29}$ are on each occurrence, identically or differently, H, D, F, Cl, Br, I, CHO, $N(R^{30})_2$, $N(Ar^7)_2$, $B(Ar^7)_2$, $C(=O)Ar^7$, $P(=O)(Ar^7)_2$, $S(=O)Ar^7$, $S(=O)_2Ar^7$, $CR^{30}=CR^{30}Ar^7$, CN, $NO_2$,$Si(R^{30})_3$, $B(OR^{30})_2$, $B(R^{30})_2$, $B(N(R^{33})_2)_2$, $OSO_2R^{39}$, a straight-chain alkyl, alkenyl, alkynyl, alkoxy or thioalkoxy group having 1 to 40 C atoms or a branched or cyclic alkyl, alkenyl, alkynyl, alkoxy or thioalkoxy group having 3 to 40 C atoms, each of which may be substituted by one or more radicals $R^{30}$, where one or more non-adjacent $CH_2$ groups may be replaced by $R^{30}C=CR^{30}$, C≡C, $Si(R^{30})_2$, $Ge(R^{30})_2$, $Sn(R^{30})_2$, C=O, C=S, C=Se, $C=NR^{30}$, $P(=O)(R^{30})$, SO, $SO_2$, $NR^{30}$, O, S or $CONR^{30}$ and where one or more H atoms may be replaced by D, F, Cl, Br, I, CN or $NO_2$, or an aromatic or heteroaromatic ring system having 5 to 60 aromatic ring atoms, which may in each case be substituted by one or more radicals $R^{30}$, or an aryloxy or heteroaryloxy group having 5 to 60 aromatic ring atoms, which may be substituted by one or more radicals $R^{30}$, or a combination of these systems; two or more adjacent substituents $R^{28}$ here may also form a mono- or polycyclic, aliphatic or aromatic ring system with one another;

$Ar^7$ is on each occurrence, identically or differently, an aromatic or heteroaromatic ring system having 5 to 30 aromatic ring atoms, which may be substituted by one or more radicals $R^{30}$; two radicals $Ar^7$ here which are bonded to the same nitrogen, phosphorus or boron atom may also be linked to one another by a single bond or a bridge selected from $B(R^{30})$, $C(R^{30})_2$, $Si(R^{30})_2$, C=O, $C=NR^{30}$, $C=C(R^{30})_2$, O, S, S=O, $SO_2$, $N(R^{30})$, $P(R^{30})$ and $P(=O)R^{30}$;

$R^{30}$ is on each occurrence, identically or differently, H, D or an aliphatic, aromatic and/or heteroaromatic hydrocarbon radical having 1 to 20 C atoms, in which, in addition, H atoms may be replaced by D or F; two or more adjacent substituents $R^{30}$ here may also form a mono- or polycyclic, aliphatic or aromatic ring system with one another;

n is 0 or 1;

m is 0, 1, 2 or 3;

o is 0, 1, 2, 3 or 4 if n = 0 in the same ring and is 0, 1, 2 or 3 if n = 1 in the same ring.

Preferably, the compounds according to formulae (H3a) and/or (H3b) may comprise a solubilizing structure element as described, e. g. in document WO 2011/076325 referring to formulae (L-I), (L-II) and (L-III), respectively.

Preferred compounds having solubilising groups being useful for performing the present invention include

| | |
|---|---|
| 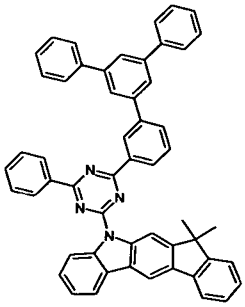 | 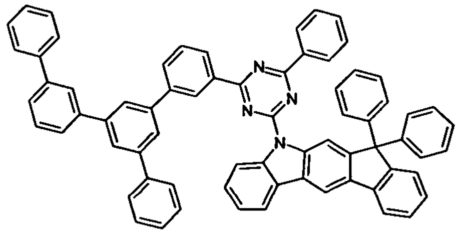 |
| 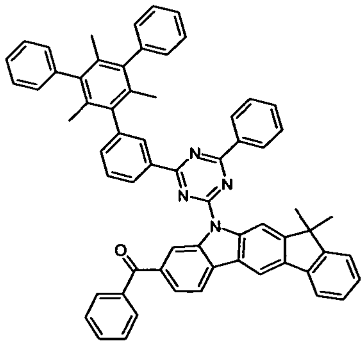 | 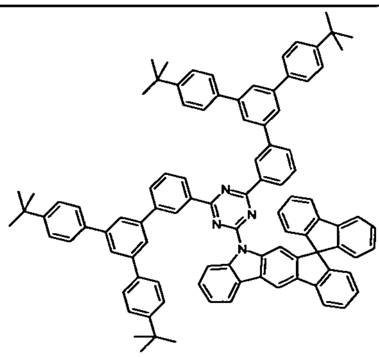 |
| 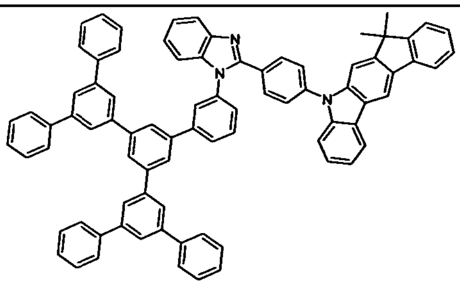 | 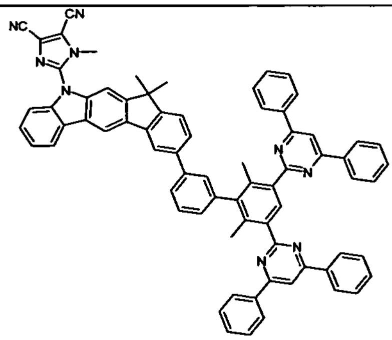 |
| 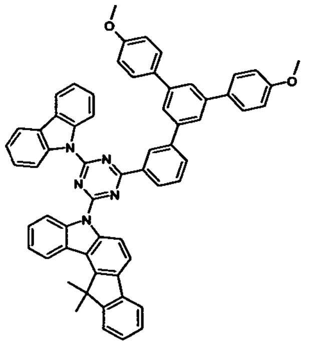 | 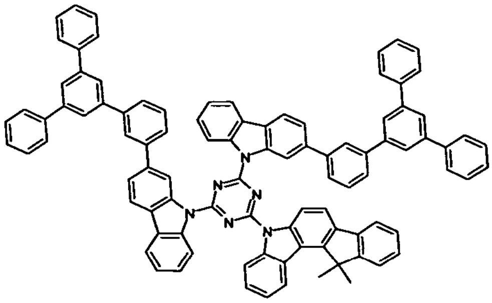 |

| | |
|---|---|
| 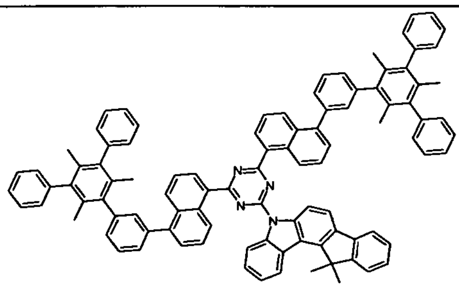 | 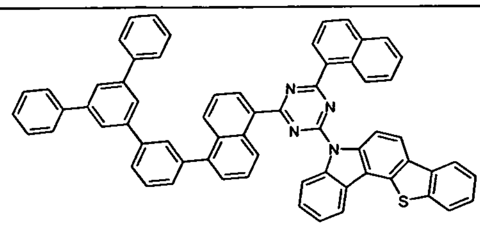 |
| 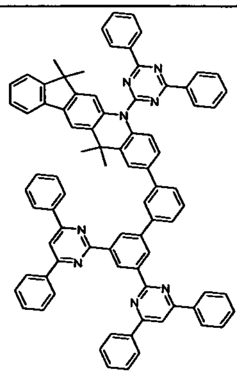 | 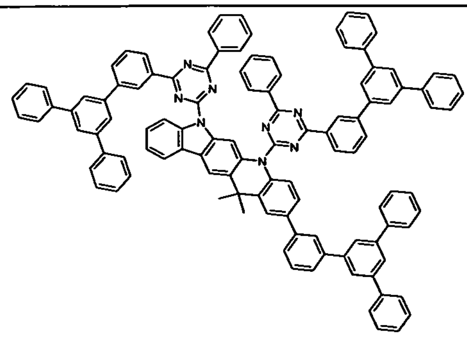 |
| 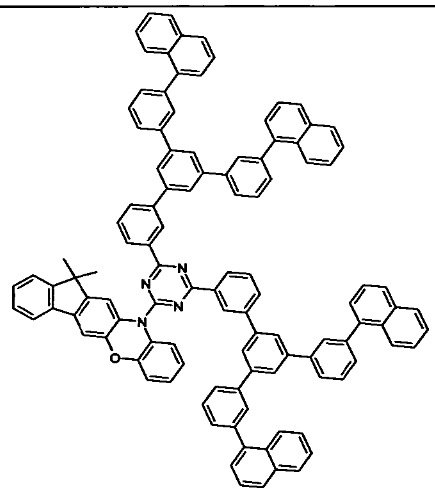 | 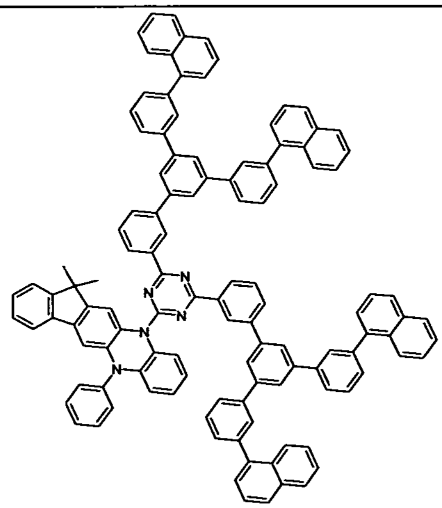 |
| 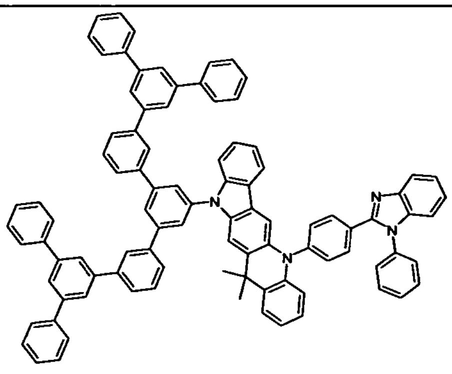 | 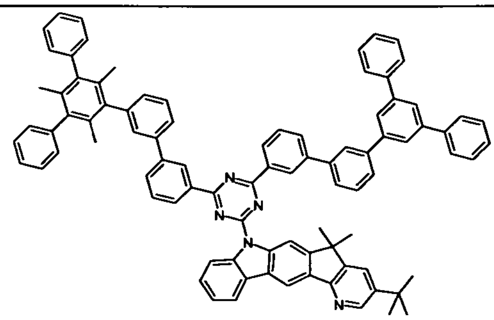 |

| |
|---|
| 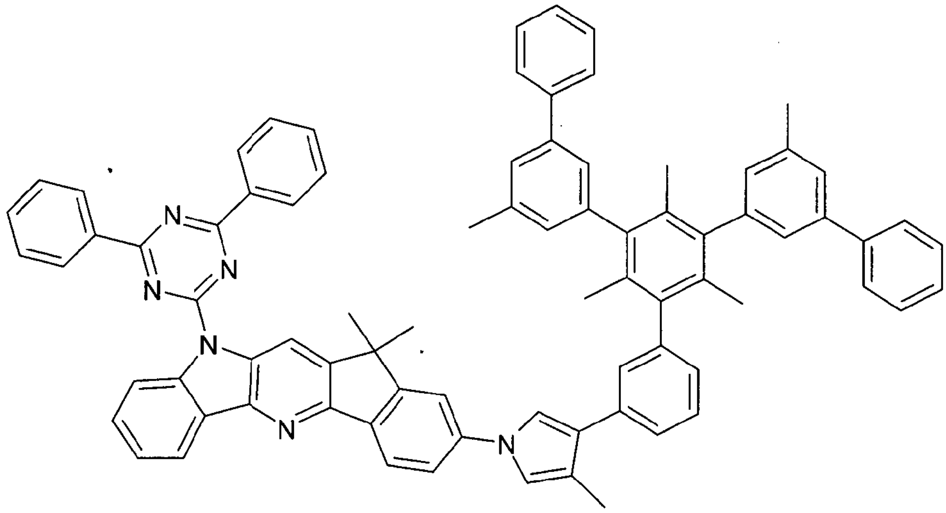 |
| 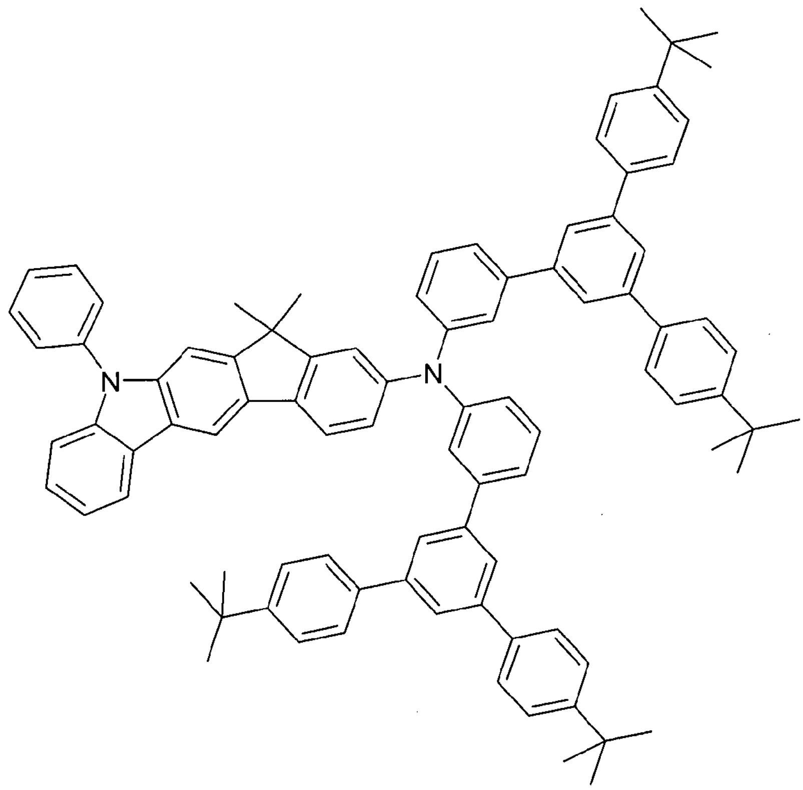 |

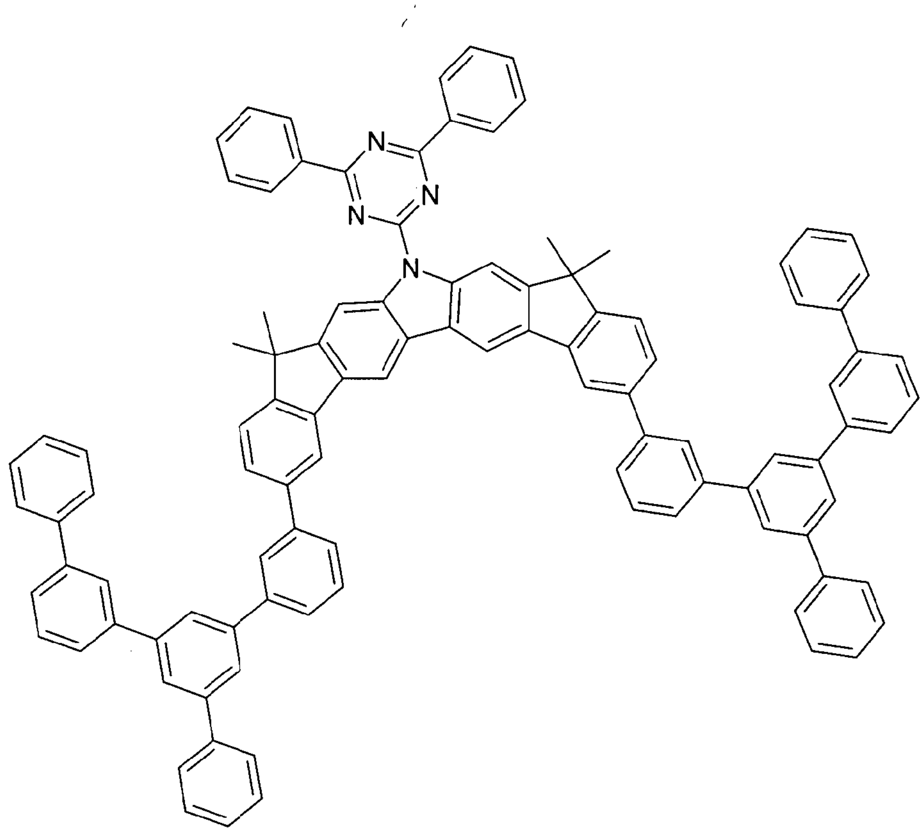

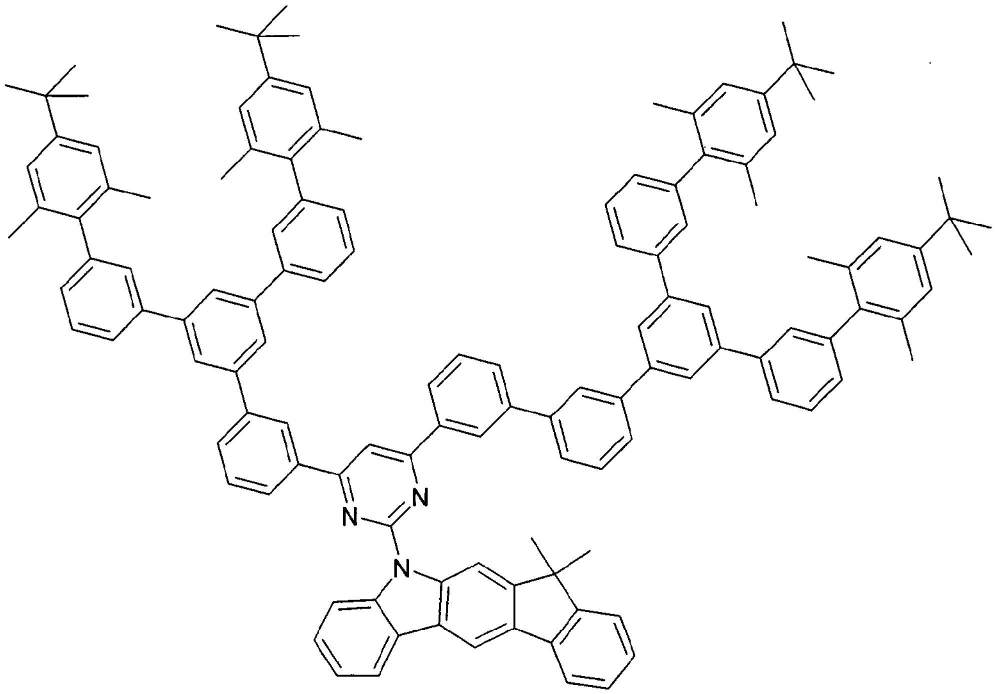

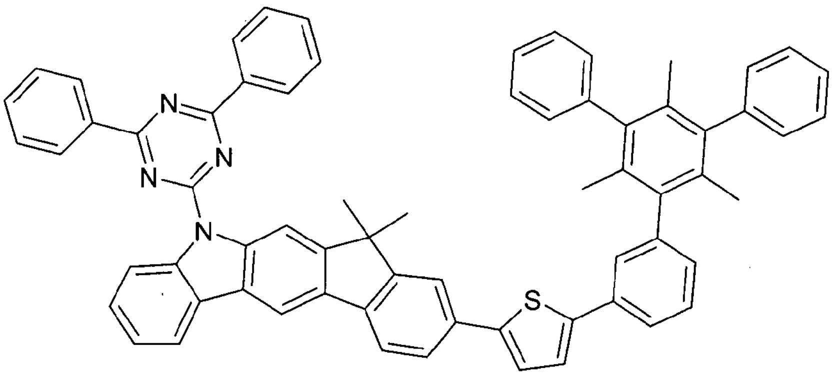

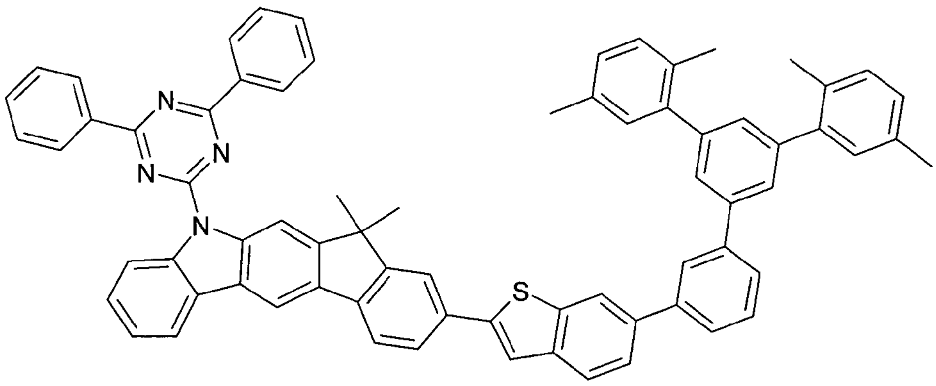

| |
|---|
| 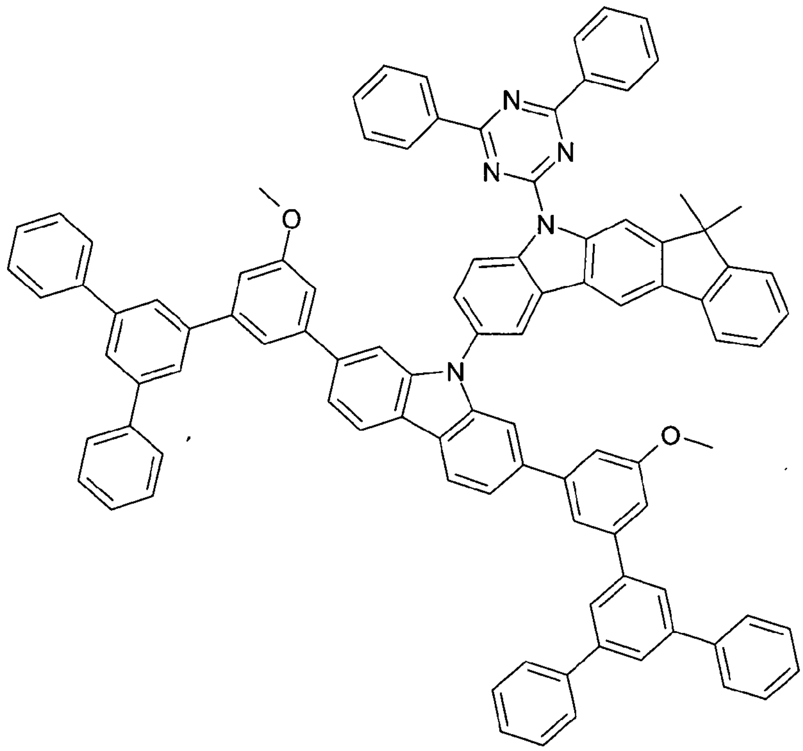 |
| 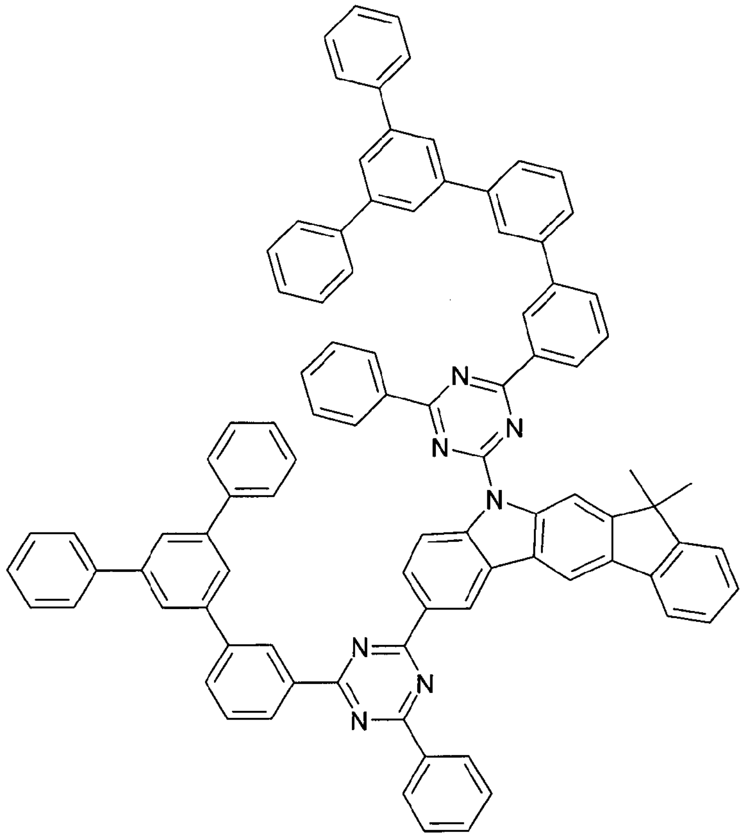 |

| | |
|---|---|
| 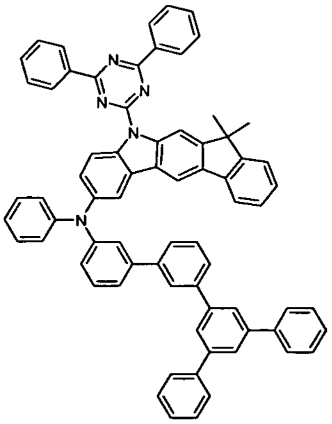 | 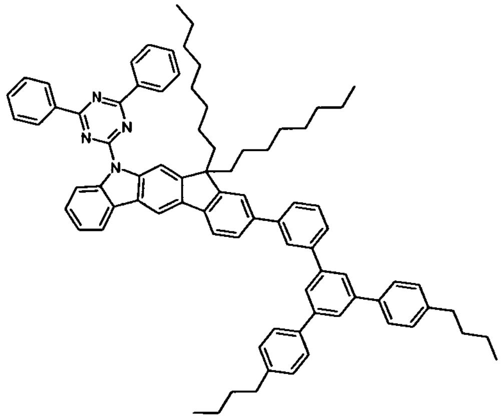 |
| 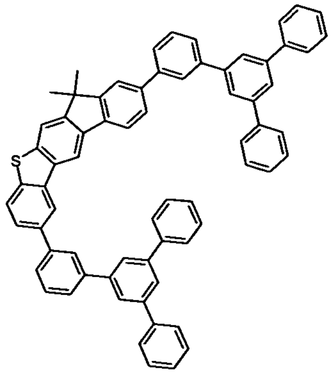 | 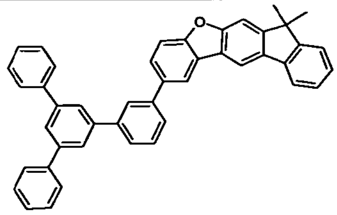 |
| 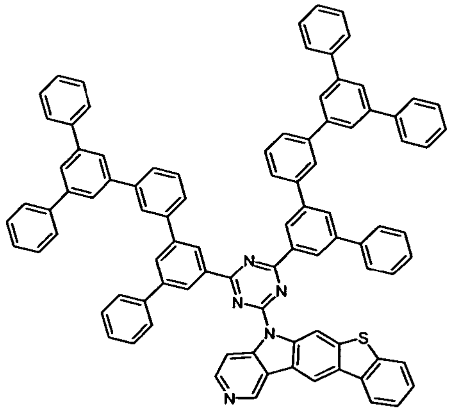 | 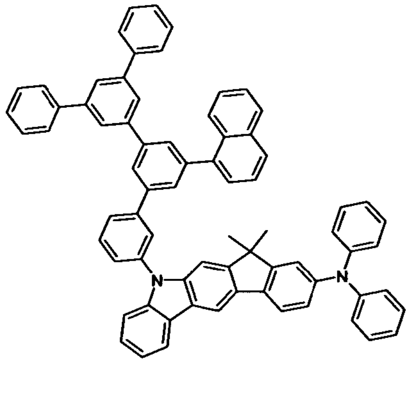 |
| 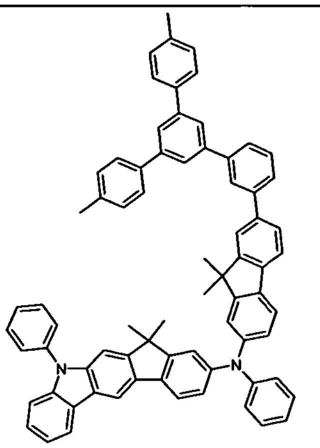 | 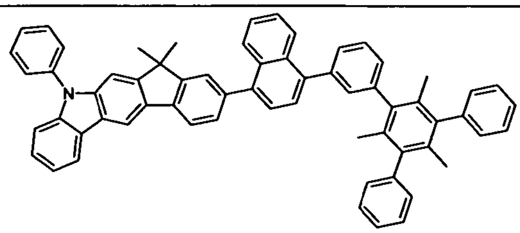 |

| |
|---|
| 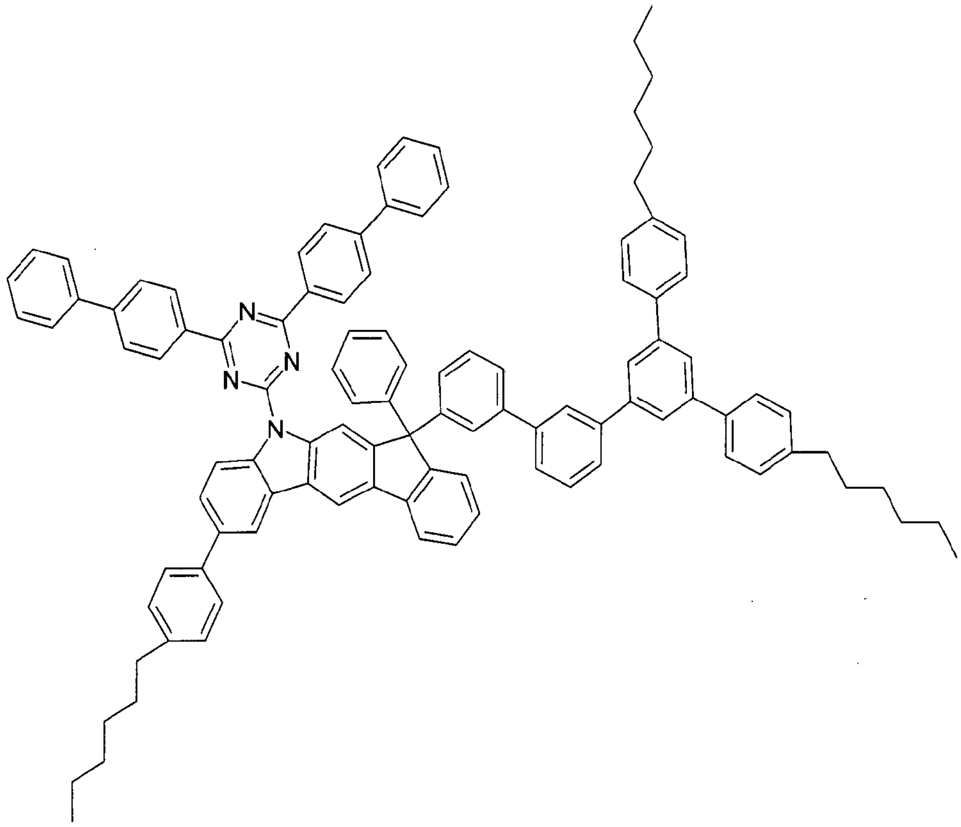 |
| 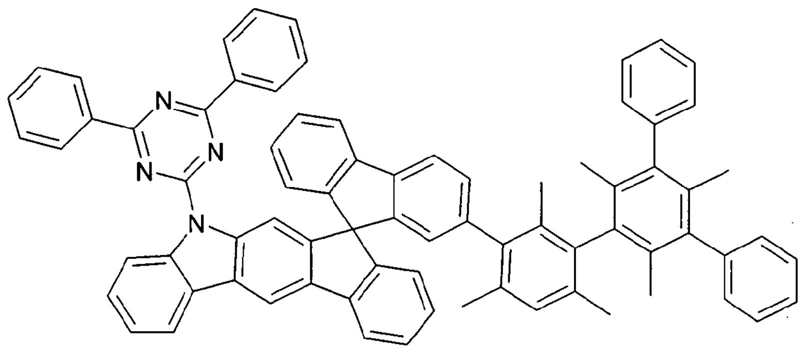 |

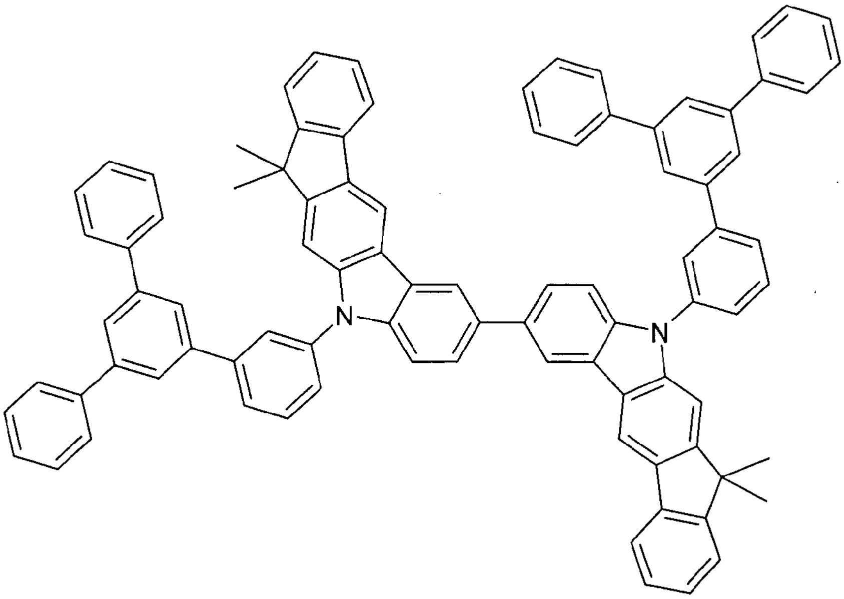

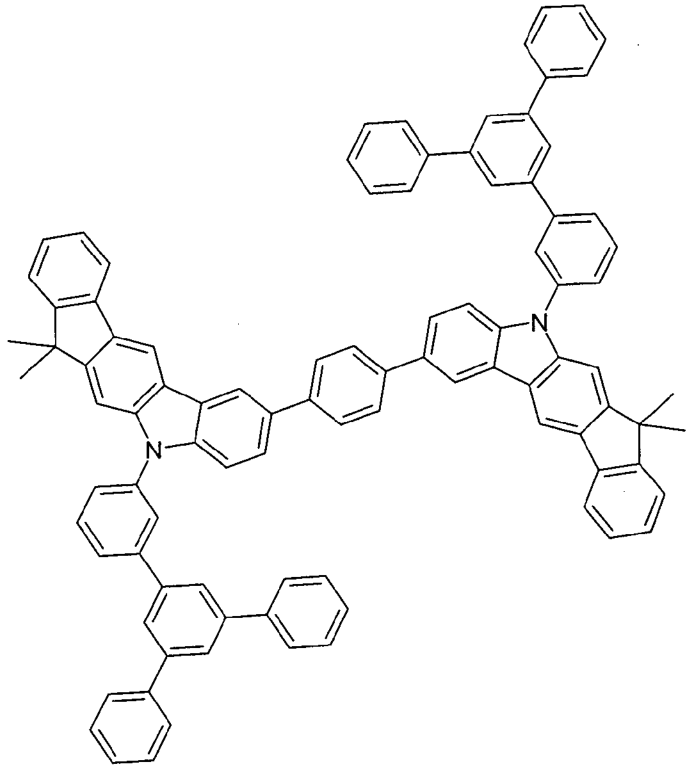

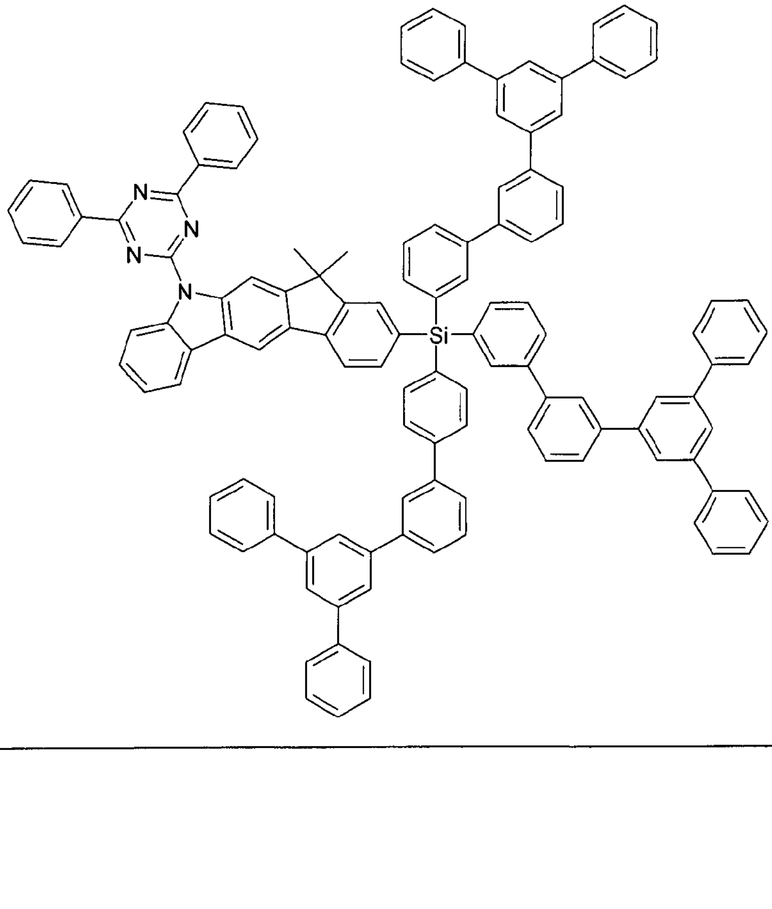

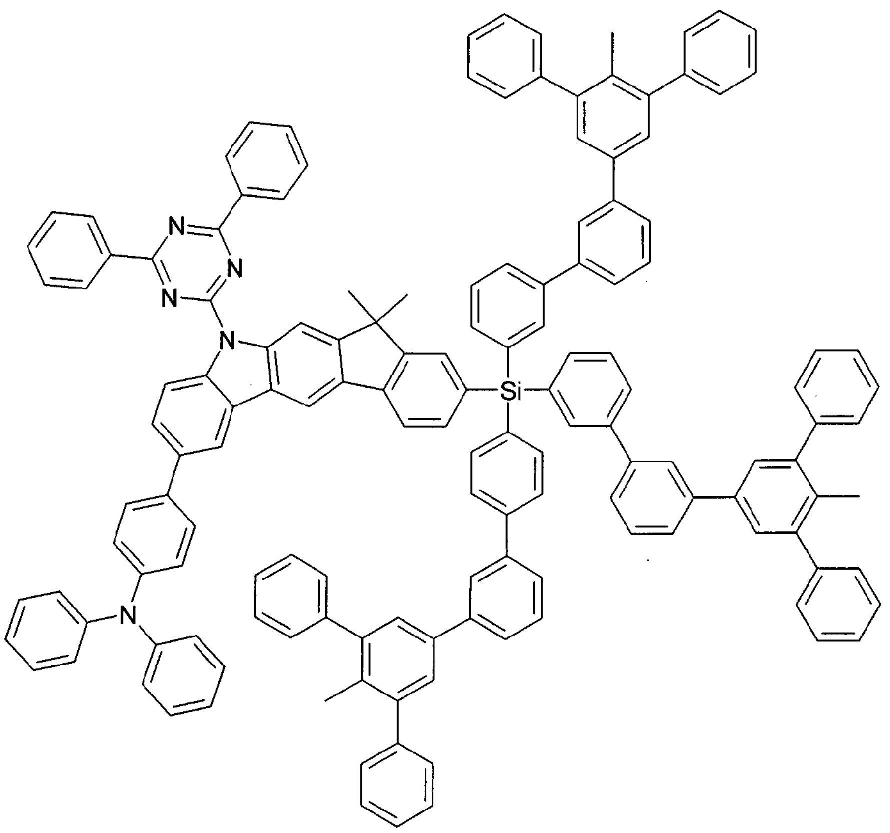

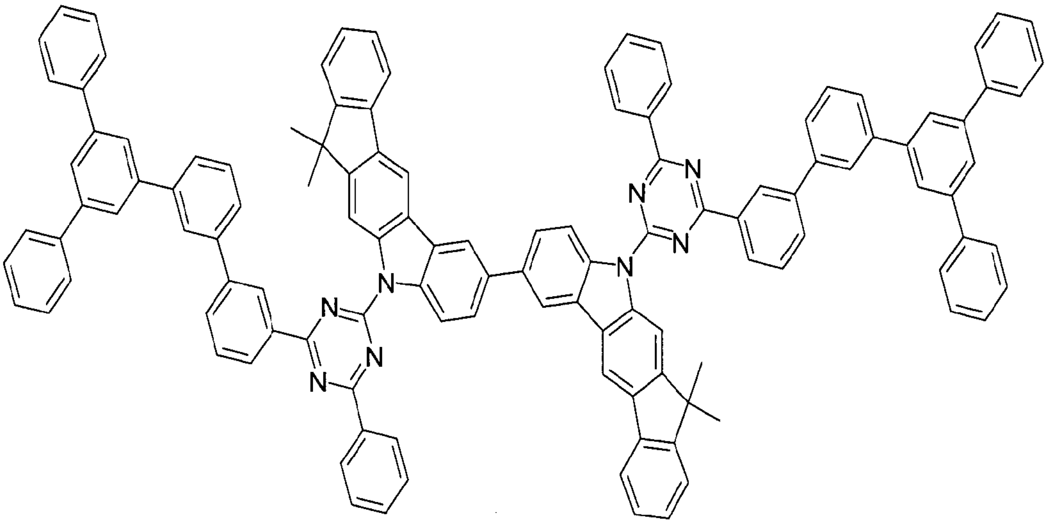

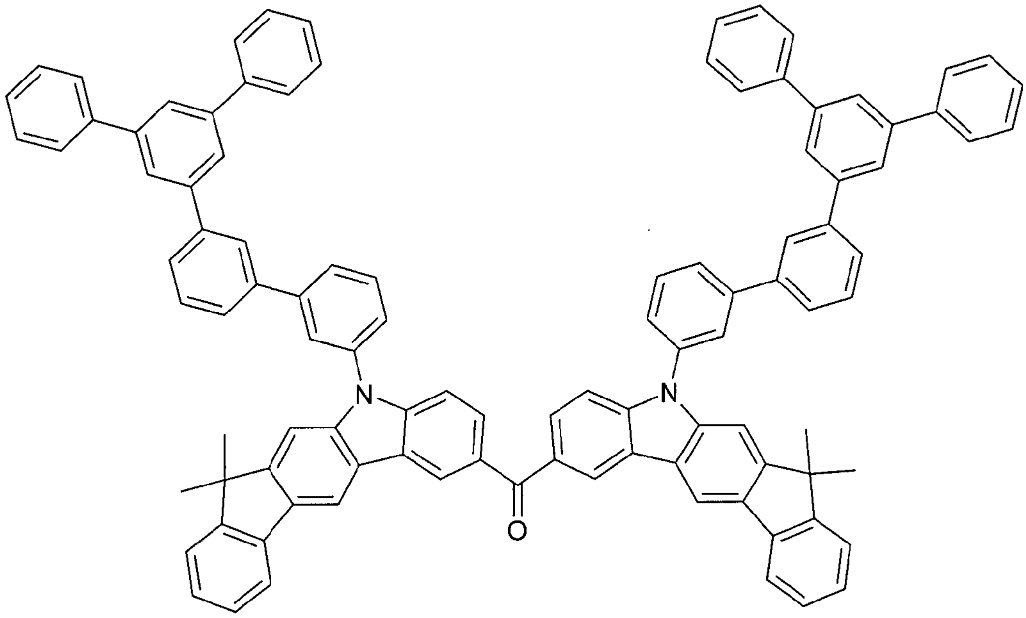

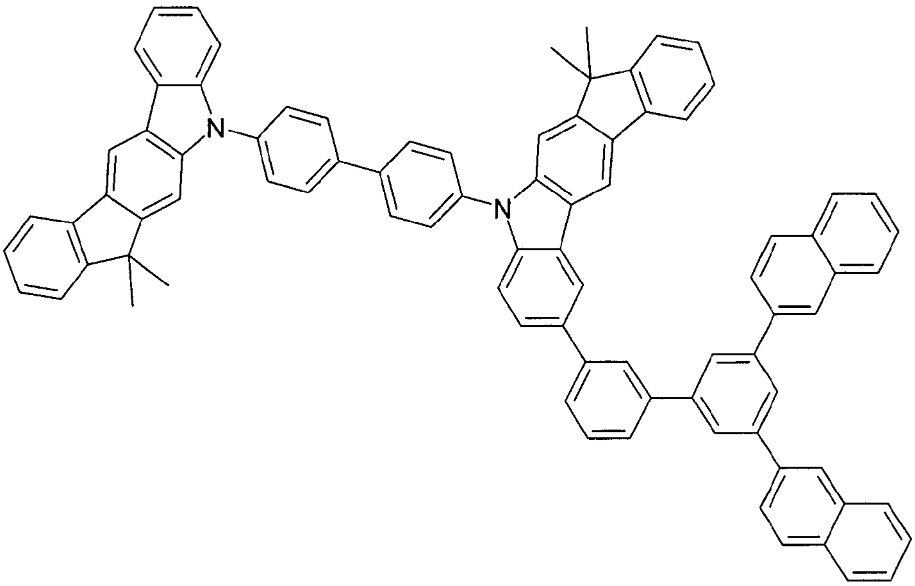

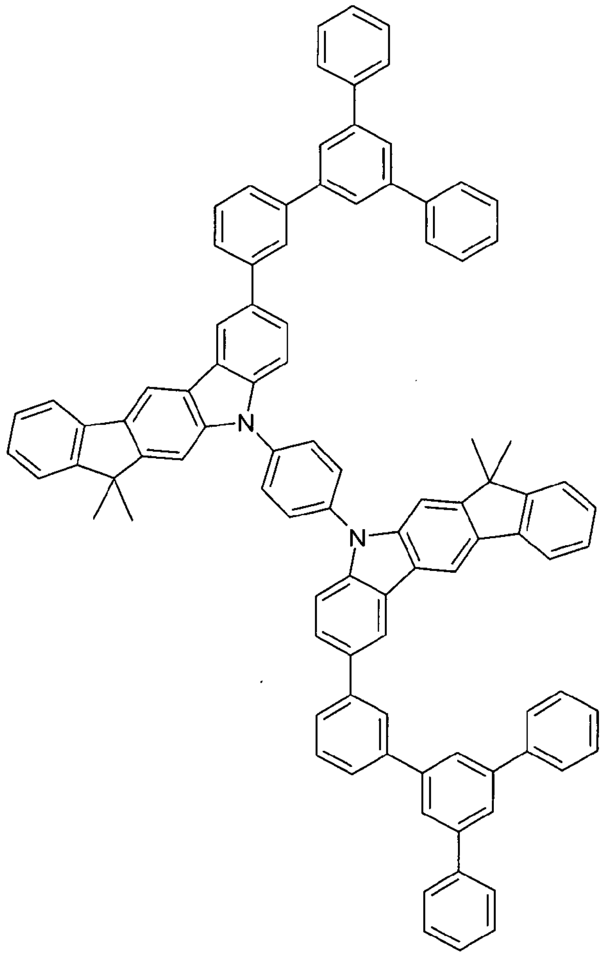

| |
|---|
| 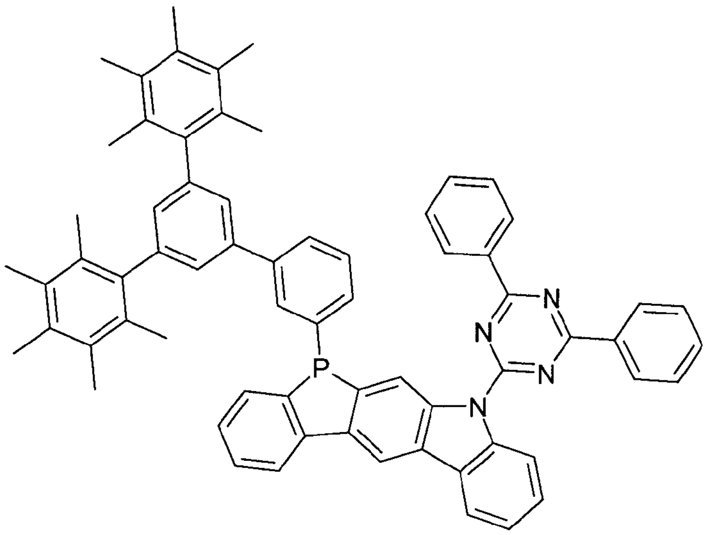 |
| 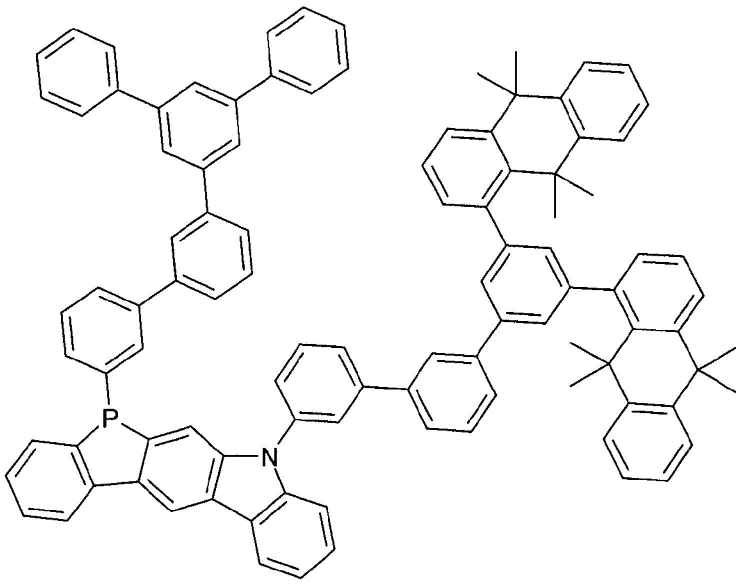 |

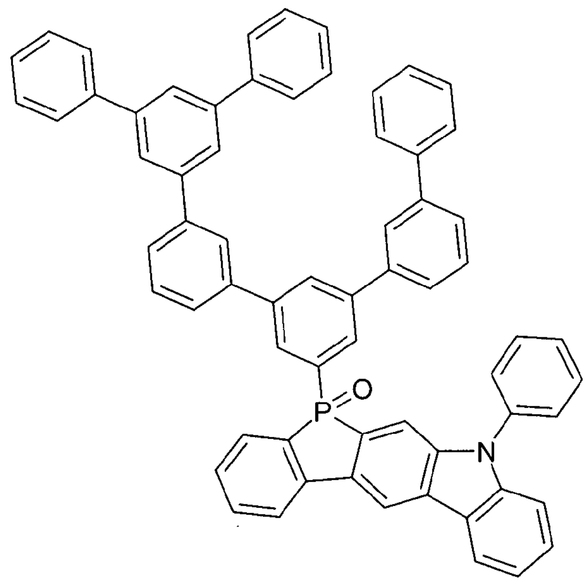

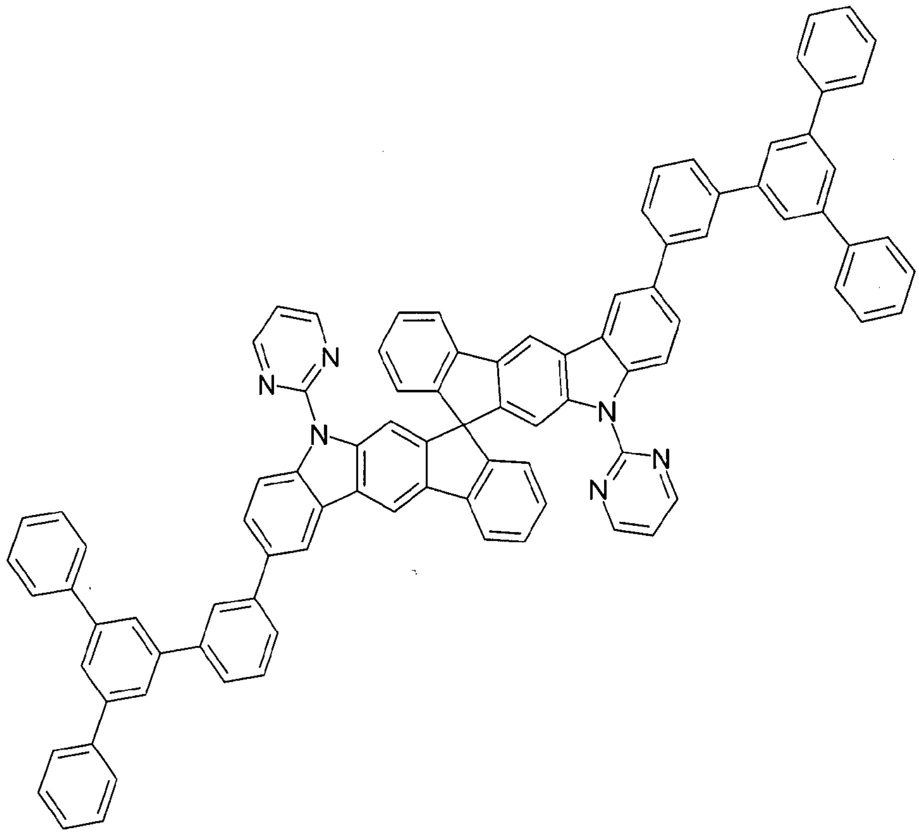

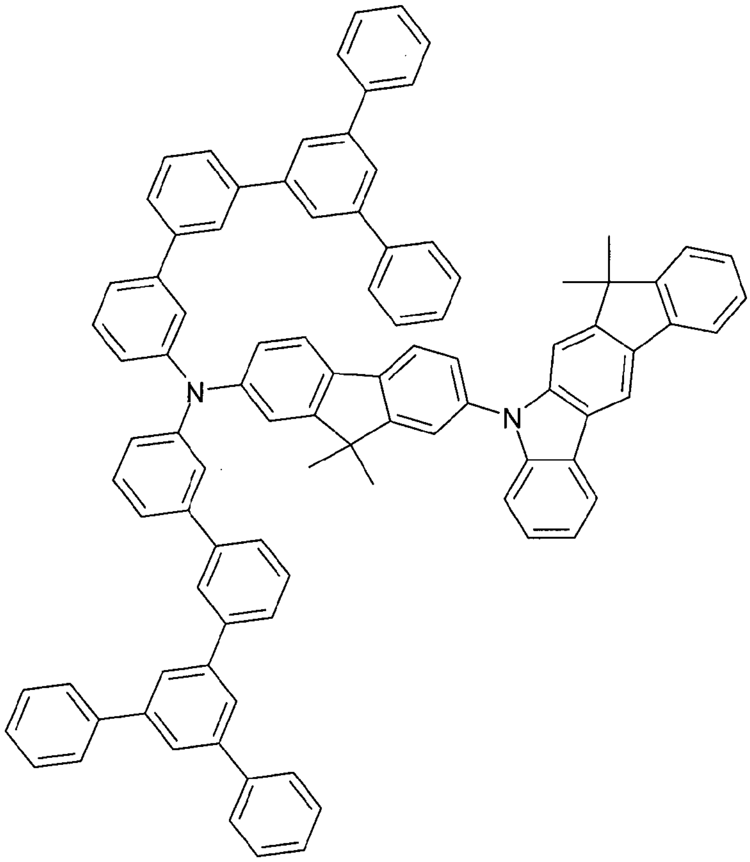

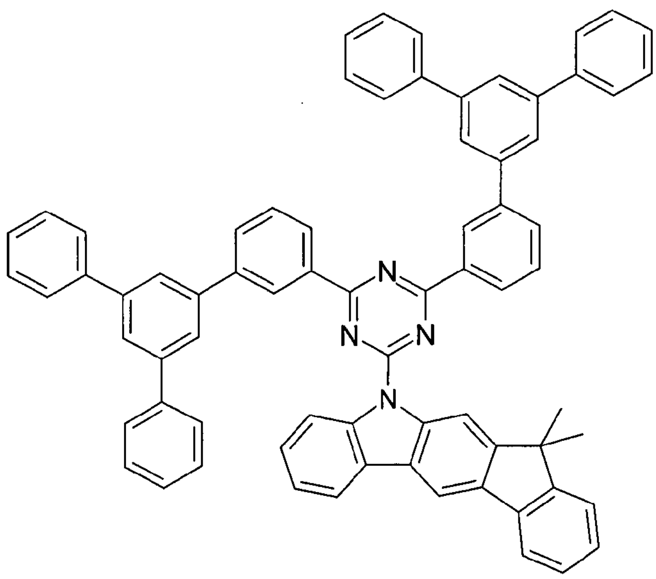

| | |
|---|---|
| 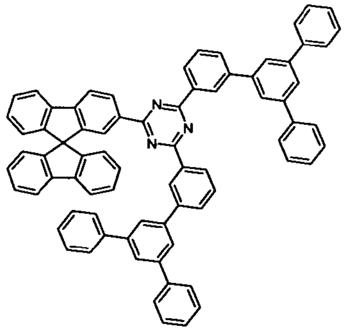 | 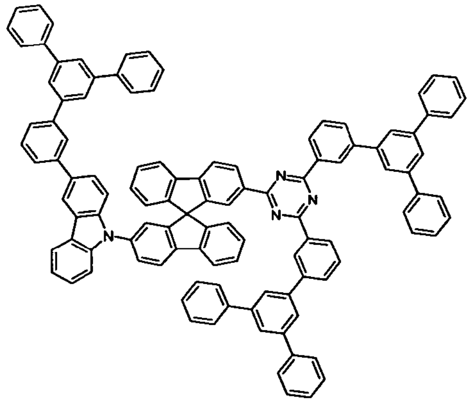 |
| 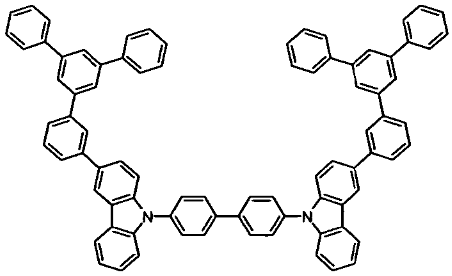 | 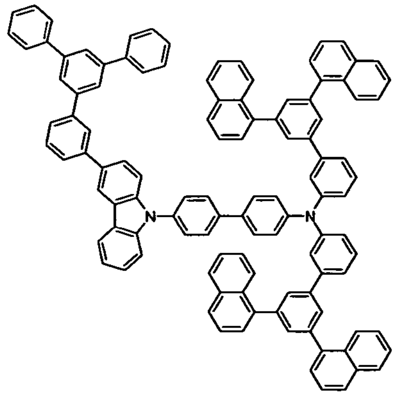 |
| 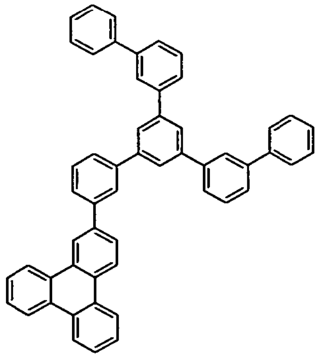 | 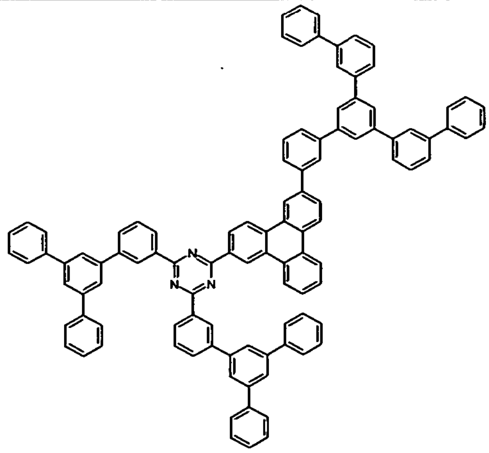 |
| 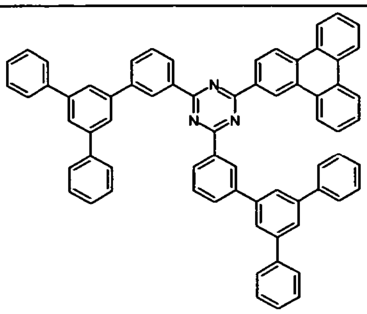 | 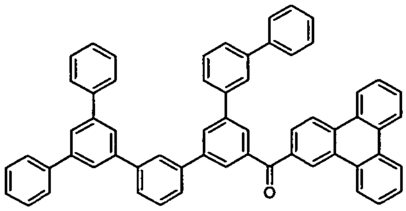 |

| | |
|---|---|
| 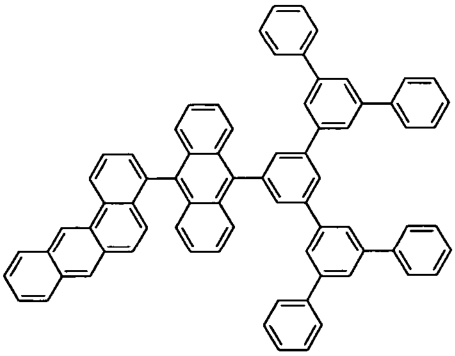 | 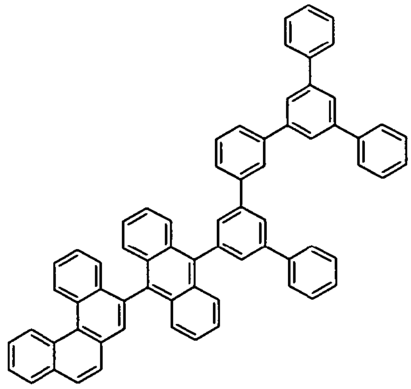 |
| 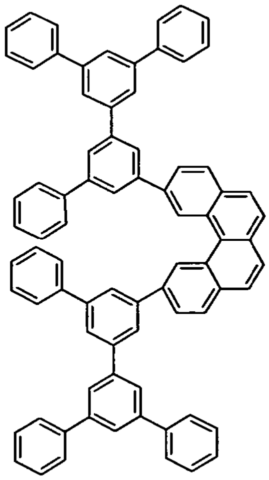 | 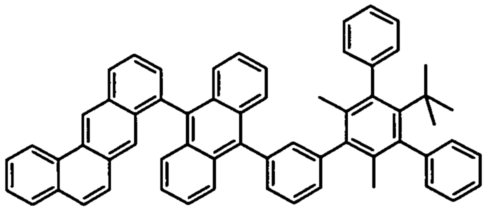 |
| 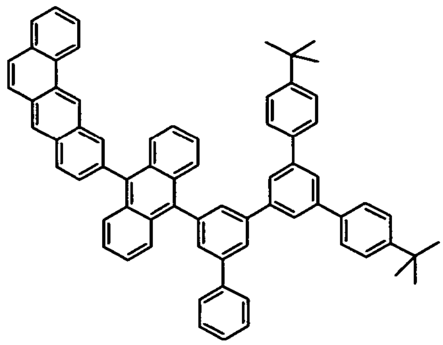 | 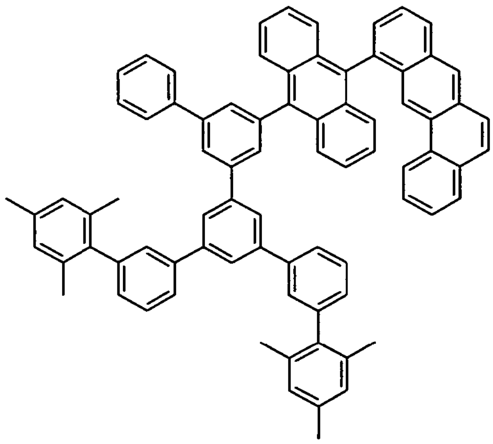 |

| | |
|---|---|
| 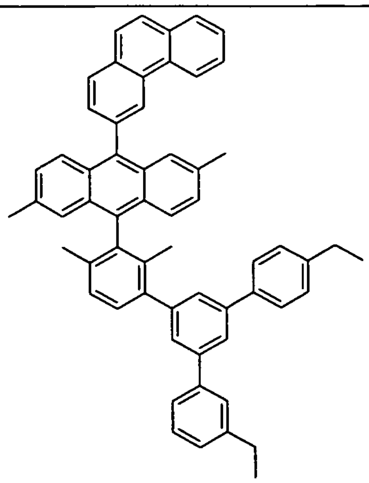 | 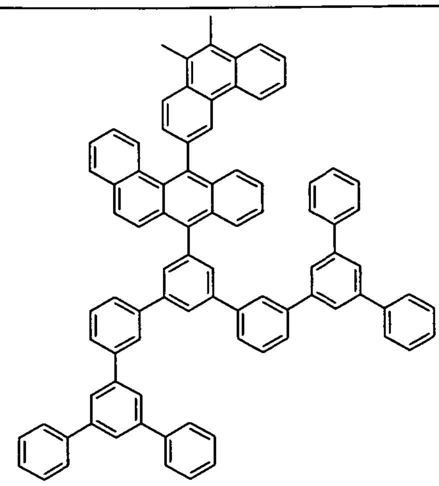 |
| 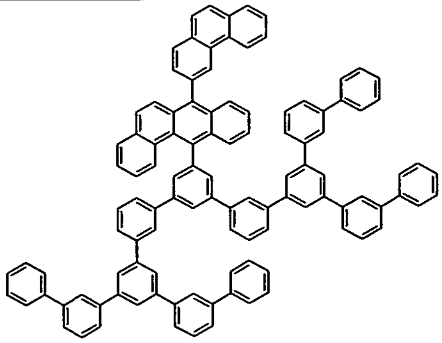 | 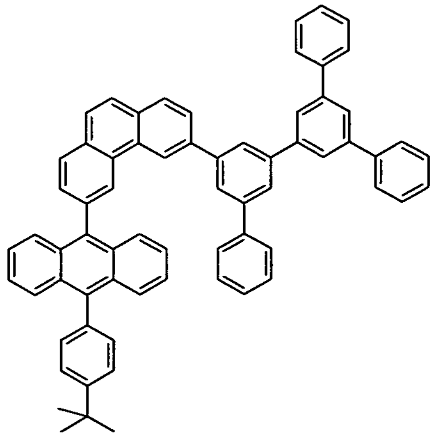 |
| 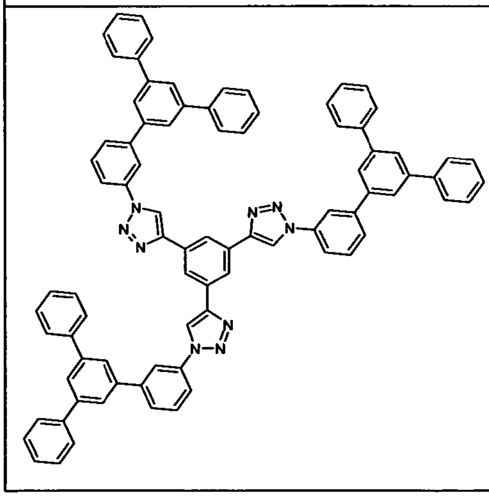 | 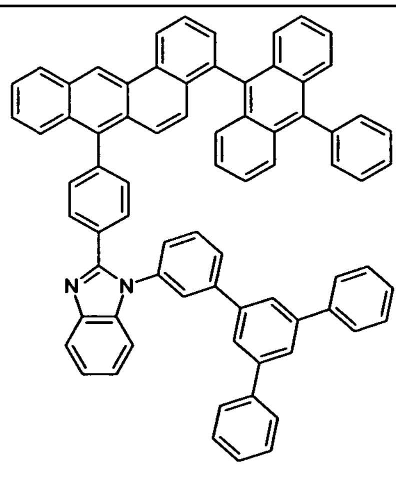 |

| | |
|---|---|
| 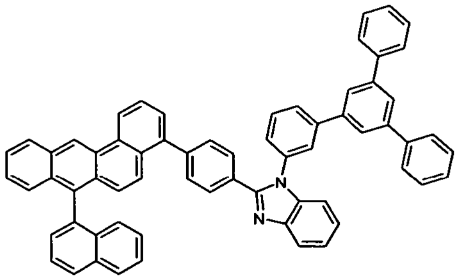 | 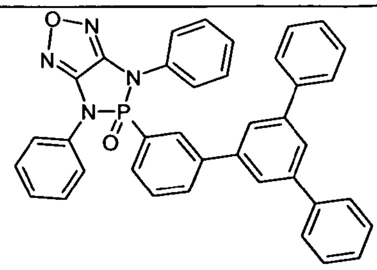 |
| 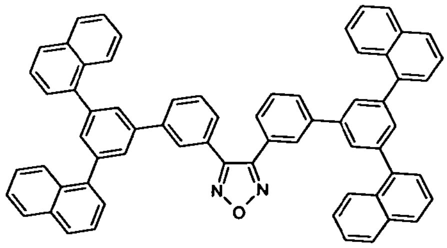 | 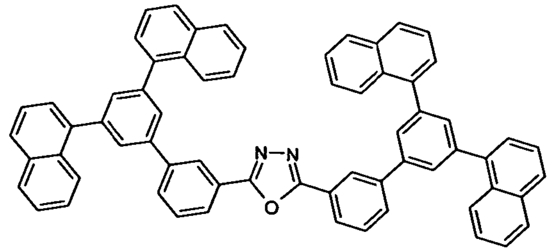 |
| 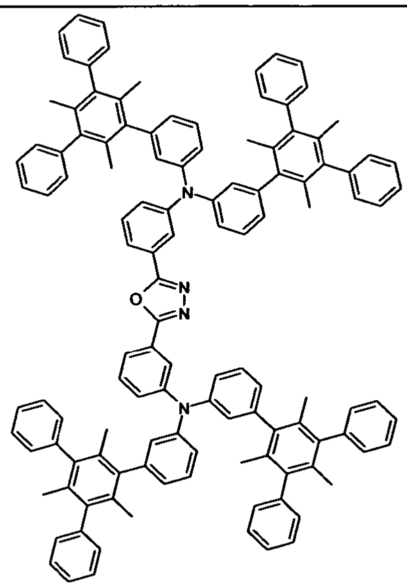 | 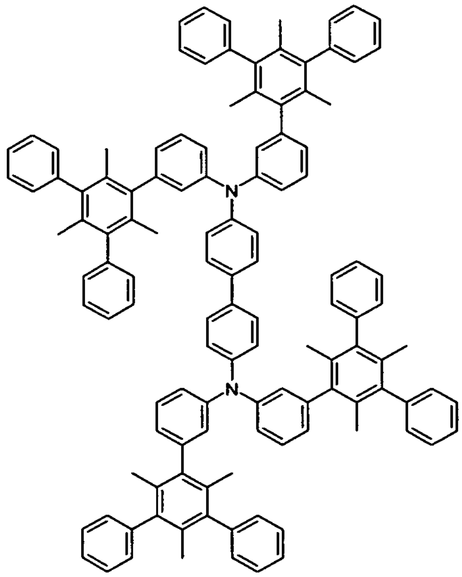 |

Further suitable compounds, their Hansen Solubility Parameters incl. their radii are mentioned in the following table:

| Material | Hd [MPa$^{0.5}$] | $H_h$ [MPa$^{0.5}$] | $H_p$ MPa$^{0.5}$ | Radius [MPa$^{0.5}$] |
|---|---|---|---|---|
| 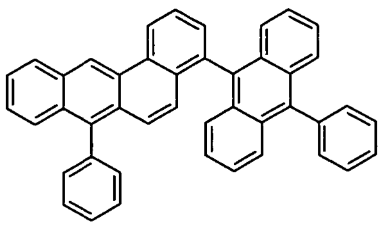 | 19.5 | 3.6 | 3.9 | 3.2 |

| Material | $H_d$ [MPa$^{0.5}$] | $H_h$ [MPa$^{0.5}$] | $H_p$ [MPa$^{0.5}$] | Radius [MPa$^{0.5}$] |
|---|---|---|---|---|
| 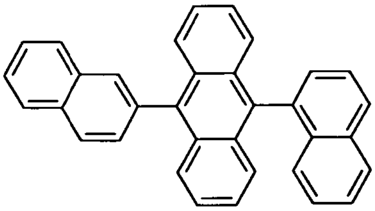 | 18.1 | 6.5 | 4.6 | 6.6 |
| 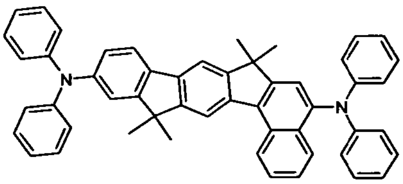 | 18.1 | 6.5 | 4.6 | 6.6 |
| 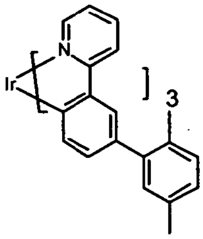 | 19.1 | 3.0 | 5.2 | 2.7 |
| 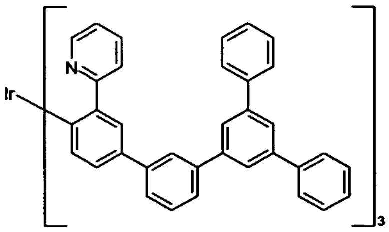 | 17.7 | 4.0 | 7.4 | 8.4 |
| 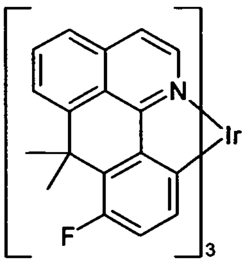 | 17.9 | 7.0 | 6.4 | 3.0 |

| Material | Hd [MPa$^{0.5}$] | $H_h$ [MPa$^{0.5}$] | $H_p$ [MPa$^{0.5}$] | Radius [MPa$^{0.5}$] |
|---|---|---|---|---|
| 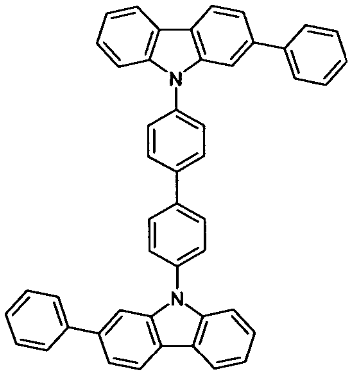 | 18.8 | 4.1 | 2.9 | 4.5 |
| 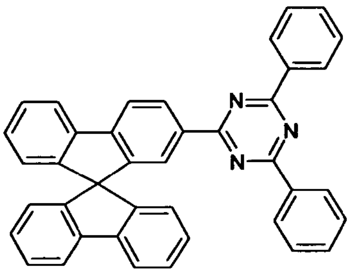 | 18.6 | 3.6 | 5.6 | 5.0 |
| 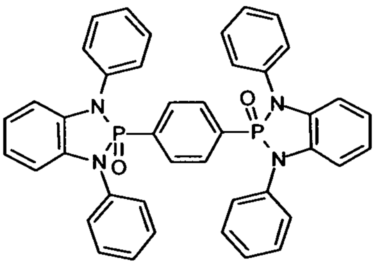 | 18.8 | 4.7 | 5.3 | 5.0 |
| 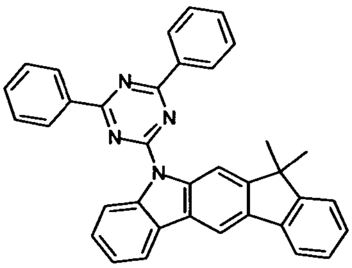 | 17.6 | 3.7 | 4.3 | 5.3 |
| 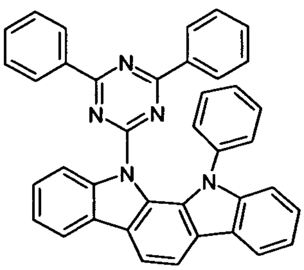 | 17.6 | 3.7 | 4.3 | 5.3 |

| Material | Hd [MPa$^{0.5}$] | $H_h$ [MPa$^{0.5}$] | $H_p$ [MPa$^{0.5}$] | Radius [MPa$^{0.5}$] |
|---|---|---|---|---|
| 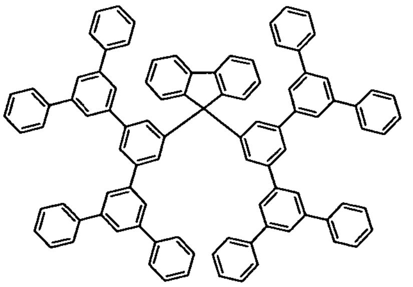 | 18.5 | 3.1 | 5.0 | 5.5 |

According to a preferred embodiment, the organic semiconducting compounds (OSC) preferably have a molecular weight of at most 5,000 g/mol, particularly at most 2,000 g/mol, especially at most 1,500 g/mol and more preferably at most 1,000 g/mol.

Composition according to any one of claims 1 to 15, characterized in that said composition comprises 0.01 to 10 % weight, preferably 0.5 to 7 % by weight of the organic semiconducting compound.

In an further embodiment of the present invention a polymeric material can be used as organic semiconducting compound. Perferably, the polymers useful for the invention may contain structural units as disclosed and listed extensively in WO 02/077060 A1, in WO 2005/014689 A2 and in WO 2010/136110 A2. The further structural units can originate, for example, from the following classes:

Group 1: Units which influence, preferably enhance, the hole-injection and/or hole-transport properties of the polymers;

Group 2: Units which influence, preferably enhance, the electron-injection and/or electron-transport properties of the polymers;

Group 3: Units which have combinations of individual units from group 1 and group 2;

Group 4: Units which modify the emission characteristics to such an extent that electrophosphorescence can be obtained instead of electrofluorescence;

Group 5: Units which improve transfer from the singlet state to the triplet state;

Group 6: Units which influence the emission colour of the resultant polymers;

Group 7: Units which are typically used as backbone;

Group 8: Units which influence the film-morphological and/or rheological properties of the resultant polymers.

Preferred polymers are those in which at least one structural unit has charge-transport properties, i.e. which contain units from groups 1 and/or 2.

Structural units from group 1 which have hole-injection and/or hole-transport properties are, for example, triarylamine, benzidine, tetraaryl-para-phenylenediamine, triarylphosphine, phenothiazine, phenoxazine, dihydro-phenazine, thianthrene, dibenzo-para-dioxin, phenoxathiyne, carbazole, azulene, thiophene, pyrrole and furan derivatives and further O-, S- or N-containing heterocycles having a high HOMO (HOMO = highest occupied molecular orbital). These arylamines and heterocycles preferably result in an HOMO in the polymer of greater than -5.8 eV (against vacuum level), particularly preferably greater than -5.5 eV.

Structural units from group 2 which have electron-injection and/or electron-transport properties are, for example, pyridine, pyrimidine, pyridazine, pyrazine, oxadiazole, quinoline, quinoxaline, anthracene, benzanthracene, pyrene, perylene, benzimidazole, triazine, ketone, phosphine oxide and phenazine derivatives, but also triarylboranes and further O-, S- or N-containing heterocycles having a low LUMO (LUMO = lowest unoccupied molecular orbital). These units in the polymer preferably result in an LUMO of less than -1.9 eV (against vacuum level), particularly preferably less than -2.5 eV.

It may be preferred for the polymers to contain units from group 3 in which structures which increase the hole mobility and structures which increase the electron mobility (i.e. units from groups 1 and 2) are bonded directly to one another or structures which increase both the hole mobility and the electron mobility. Some of these units can serve as emitters and shift the emission colour into the green, yellow or red. Their use is thus suitable, for example, for the generation of other emission colours from originally blue-emitting polymers.

Structural units from group 4, so-called triplet emitter units, are those which are able to emit light from the triplet state with high efficiency, even at room temperature, i.e. exhibit electrophosphorescence instead of electrofluorescence, which frequently causes an increase in the energy efficiency. For the purposes of the present application, a triplet emitter unit is taken to mean a compound which comprises a triplet emitter. For the purposes of the present application, triplet emitters are taken to mean all compounds which are capable of emitting light in the visible or NIR region through transfer from a triplet state into an energetically lower state. This is also referred to as phosphorescence. Suitable for this purpose are firstly compounds which contain heavy atoms having an atomic number of greater than 36. Preference is given to compounds which contain d- or f-transition metals which satisfy the above-mentioned condition. Particular preference is given here to corresponding structural units which contain elements from groups 8 to 10 (Ru, Os, Rh, Ir, Pd, Pt). Suitable structural units for the polymers here are, for example, various complexes, as described, for example, in WO 02/068435 A1, WO 02/081488 A1 and EP 1239526 A2. Corresponding monomers are described in WO 02/068435 A1 and in WO 2005/042548 A1.

It is preferred to employ tnplet emitters which emit in the visible spectral region (red, green or blue).

The triplet emitter may be part of the backbone of the polymer (i.e. in the main chain of the polymer) or it may be located in the side chain of the polymer.

Structural units from group 5 are those which improve transfer from the singlet state to the triplet state and which, employed in support of the above-mentioned triplet emitter units, improve the phosphorescence properties of these structural elements. Suitable for this purpose are, in particular, carbazole and bridged carbazole dimer units, as described, for example, in WO 2004/070772 A2 and WO 2004/113468 A1. Also suitable for this purpose are ketones, phosphine oxides, sulfoxides, sulfones, silane derivatives and similar compounds, as described, for example, in WO 2005/040302 A1.

Structural units from group 6, are those which have at least one further aromatic structure or another conjugated structure which does not fall under the above-mentioned groups, i.e. which have only little influence on the charge-carrier mobilities, are not organometallic complexes or do not influence singlet-triplet transfer. Structural elements of this type can influence the emission colour of the resultant polymers. Depending on the unit, they can therefore also be employed as emitters. Preference is given here to aromatic structures having 6 to 40 C atoms and also tolan, stilbene or bisstyrylarylene derivatives, each of which may be substituted by one or more radicals. Particular preference is given here to the incorporation of 1,4-phenylene, 1,4-naphthylene, 1,4- or 9,10-anthrylene, 1,6-, 2,7- or 4,9-pyrenylene, 3,9- or 3,10-perylenylene, 4,4'-biphenylylene, 4,4"-terphenylylene, 4,4'-bi-1,1'-naphthylylene, 4,4'-tolanylene, 4,4'-stilbenylene, 4,4"-bisstyrylarylene, benzothiadiazole and corresponding oxygen derivatives, quinoxaline, phenothiazine, phenoxazine, dihydrophenazine, bis(thiophenyl)arylene, oligo(thiophenylene), phenazine, rubrene, pentacene or perylene derivatives, which are preferably substituted, or preferably conjugated push-pull systems (systems which are substituted by donor and acceptor substituents) or systems such as squarines or quinacridones, which are preferably substituted.

Structural units from group 7 are units which contain aromatic structures having 6 to 40 C atoms, which are typically used as polymer backbone. These are, for example, 4,5-dihydropyrene derivatives, 4,5,9,10-tetrahydro-pyrene derivatives, fluorene derivatives, 9,9'-spirobifluorene derivatives, phenanthrene derivatives, 9,10-dihydrophenanthrene derivatives, 5,7-dihydrodibenzoxepine derivatives and cis- and trans-indenofluorene derivatives, but in principle also all similar structures which, after polymerisation, would result in a conjugated, bridged or unbridged polyphenylene or polyphenylene-vinylene homopolymer. Here too, the said aromatic structure may contain heteroatoms, such as O, S or N, in the backbone or the side chain.

Structural units from group 8 are those which influence the film-morphological properties and/or the rheological properties of the polymers, such as, for example, siloxanes, long alkyl chains or fluorinated groups, but also particularly rigid or flexible units, such as, for example, liquid crystal-forming units or crosslinkable groups.

The synthesis of the above-described units from groups 1 to 8 and of the further emitting units is known to the person skilled in the art and is described in the literature, for example in WO 2005/014689 A2, WO 2005/030827 A1, WO 2005/030828 A1 and WO2010/136110 A2.

The polymers useful for the present invention may contain one or more units selected from groups 1 to 8. It may furthermore be preferred for more than one structural unit from one group to be present simultaneously.

The way in which white-emitting copolymers can be synthesised is described in detail, for example, in WO 2005/030827 A1, WO 2005/030828 A1 and WO 2010/136110 A2.

According to a special embodiment of the present invention, the formulation can comprise 0.01 to 10 % by weight, preferably 0.5 to 7 % by weight, more preferably 1 to 6 % by weight and most preferably 2 to 5% by weight of the organic semiconducting compound, preferably having a molecular weight of at most 5000 g/mol, more preferably emitting materials and/or charge transporting materials.

According to a special embodiment of the present invention, the formulation can comprise 0.01 to 5 % by weight, preferably 0.1 to 3 % by weight, more preferably 0.5 to 2 % by weight and most preferably 0.7 to 1.8% by weight of the polymeric organic semiconducting compound, preferably having a molecular weight of at least 10,000 g/mol, more preferably emitting materials and/or charge transporting materials.

Preferably, the composition has a viscosity at 25°C in the range of 0.8 to 8 mPas, especially 1.0 to 7 mPas, more preferably in the range of 1.5 to 6 mPas and most preferably in the range of 2.0 to 5 mPas. In a further embodiment the composition has preferably a viscosity at 25°C of at most 8 mPas, preferably at most 7 mPas, preferably at most 6 mPas and especially preferably at most 5 mPas. The viscosity is determined at a temperature of 25°C by measuring on AR-G2 rheometer manufactured by TA Instruments. This is measured using a parallel plate geometry as mentioned above.

Preference is furthermore also given to solutions of non-conducting, electronically inert polymers (matrix polymers; inert polymeric binders) which comprise admixed low-molecular-weight, oligomeric, dendritic, linear or branched and/or polymeric organic and/or organometallic semiconductors. Preferably, the formulation may comprise 0.1 to 10 % more preferably 0.25 to 5% most preferably 0.3 to 3% by weight inert polymeric binders.

The formulation according to the present invention may additionally comprise one or more further components like for example surface-active compounds, lubricating agents, conductive additives, dispersing agents, hydrophobing agents, adhesive agents, flow improvers, defoaming agents, deaerators, diluents which may be reactive or non-reactive, auxiliaries, colourants, dyes or pigments, sensitizers, stabilizers, nanoparticles or inhibitors. However, these further components should not be oxidising or otherwise capable of chemically reacting with the OSC or have an electrically doping effect on the OSC.

Surprising improvements can be achieved with volatile wetting agents. The term "volatile" as used above and below means that the agent can be removed from the organic semiconducting materials by evaporation, after these materials have been deposited onto a substrate of an OE device, under conditions (like temperature and/or reduced pressure) that do not significantly damage these materials or the OE device. Preferably this means that the wetting agent has a boiling point or sublimation temperature of < 350°C, more preferably ≤ 300°C, most preferably ≤ 250°C, at the pressure employed, very preferably at atmospheric pressure (1013 hPa). Evaporation can also be accelerated e.g. by applying heat and/or reduced pressure. Preferably, the wetting agents are not capable of chemically reacting with the OSC compounds. In particular they are selected from compounds that do not have a permanent doping effect on the OSC material (e.g. by oxidising or otherwise chemically reacting with the OSC material). Therefore, the formulation preferably should not contain additives, like e.g. oxidants or protonic or Lewis acids, which react with the OSC materials by forming ionic products.

Surprising effects can be accomplished by formulations comprising volatile components having similar boiling points. Preferably, the difference of the boiling point of the wetting agent and the first organic solvent is in the range of -50°C to 50°C, more preferably in the range of -30°C to 30°C and most preferably in the range of -20°C to 20°C. If a mixture of two or more solvents is used meeting the requirements as mentioned above in connection with the description of the first organic solvent, the boiling point of the lowest boiling first organic solvent is deciding.

Preferred wetting agents are non-aromatic compounds. With further preference the wetting agents are non-ionic compounds. Particular useful wetting agents comprise a surface tension of at most 35 mN/m, especially of at most 30 mN/m, and more preferably of at most 25 mN/m. The surface tension can be measured using a FTA (First Ten Angstrom) 1000 contact angle goniometer at 25°C. Details of the method are available from First Ten Angstrom as published by Roger P. Woodward, Ph.D. "Surface Tension Measurements Using the Drop Shape Method". Preferably, the pendant drop method can be used to determine the surface tension.

According to a special aspect of the present invention, the difference of the surface tension of the organic solvent and the wetting agent is preferably at least 1 mN/m, especially at least 5 mN/m and more preferably at least 10 mN/m.

Unexpected improvements can be achieved by wetting agents comprising a molecular weight of at least 100 g/mol, especially at least 150 g/mol, preferably at least 180 g/mol and more preferably at least 200 g/mol. Suitable and preferred wetting agents that do not oxidise or otherwise chemically react with the OSC materials are selected from the group consisting of siloxanes, alkanes, amines, alkenes, alkynes, alcohols and/or halogenated derivates of these compounds. Furthermore, fluoro ethers, fluoro esters and/or fluoro ketones can be used. More preferably, these compounds are selected from methyl siloxanes having 6 to 20 carbon atoms, especially 8 to 16 carbon atoms; $C_7$-$C_{14}$ alkanes, $C_7$-$C_{14}$ alkenes, $C_7$-$C_{14}$ alkynes, alcohols having 7 to 14 carbon atoms, fluoro ethers having 7 to 14 carbon atoms, fluoro esters having 7 to 14 carbon atoms and fluoro ketones having 7 to 14 carbon atoms. Most preferred wetting agents are methyl siloxanes having 8 to 14 carbon atoms.

Useful and preferred alkanes having 7 to 14 carbon atoms include heptane, octane, nonane, decane, undecane, dodecane, tridecane, tetradecane, 3-methyl heptane, 4-ethyl heptane, 5-propyl decane, trimethyl cyclohexane and decalin.

Halogenated alkanes having 7 to 14 carbon atoms include 1-chloro heptane, 1,2-dichloro octane, tetrafluoro octane, decafluoro dodecane, perfluoro nonane, 1,1,1-trifluoromethyl decane, and perfluoro methyl decalin.

Useful and preferred alkenes having 7 to 14 carbon atoms include heptene, octene, nonene, 1-decene, 4-decene, undecene, dodecene, tridecene, tetradecene, 3-methyl heptene, 4-ethyl heptene, 5-propyl decene, and trimethyl cyclohexene.

Halogenated alkenes having 7 to 14 carbon atoms include 1,2-dichloro octene, tetrafluoro octene, decafluoro dodecene, perfluoro nonene, and 1,1,1-trifluoromethyl decene.

Useful and preferred alkynes having 7 to 14 carbon atoms include octyne, nonyne, 1-decyne, 4-decyne, dodecyne, tetradecyne, 3-methyl heptyne, 4-ethyl heptyne, 5-propyl decyne, and trimethyl cyclohexyne.

Halogenated alkynes having 7 to 14 carbon atoms include 1,2-dichloro octyne, tetrafluoro octyne, decafluoro dodecyne, perfluoro nonyne, and 1,1,1-trifluoromethyl decyne.

Useful and preferred alcanols having 7 to 14 carbon atoms include, heptanol, octanol, nonanol, decanol, undecanol, dodecanol, tridecanol, tetradecanol, 3-methyl heptanol, 3,5-dimethyl-1-hexyn-3-ol, 4-ethyl heptanol, 5-propyl decanol, trimethyl cyclohexanol and hydroxyl decalin. Halogenated alkanols having 7 to 14 carbon atoms include 1-chloro heptanol, 1,2-dichloro octanol, tetrafluoro octanol, decafluoro dodecanol, perfluoro nonanol, 1,1,1-trifluoromethyl decanol, and 2-trifluoro methyl-1-hydroxy decalin.

Useful and preferred fluoro ethers having 7 to 14 carbon atoms include 3-ethoxy-1,1,1,2,3,4,4,5,5,6,6,6 dodecafluoro-2-trifluoromethyl-hexane, 3-propoxy-1,1,1,2,3,4,4,5,5,6,6,6 dodecafluoro-2-trifluoromethyl-hexane, and 3-propoxy-1,1,1,2,3,4,4,5,5,5 decafluoro-2-trifluoromethyl-pentane.

Useful and preferred fluoro esters having 7 to 14 carbon atoms include 3-(1,1,1,2,3,4,4,5,5,6,6,6 dodecafluoro-2-trifluoromethyl-hexyl) ethanoate, and 3-(1,1,1,2,3,4,4,5,5,5 decafluoro-2-trifluoromethyl-pentyl) propanoate.

Useful and preferred fluoro ketones having 7 to 14 carbon atoms include 3-(1,1,1,2,3,4,4,5,5,6,6,6 dodecafluoro-2-trifluoromethyl-hexyl) ethyl ketone, and 3-(1,1,1,2,3,4,4,5,5,5 decafluoro-2-trifluoromethyl-pentyl) propyl ketone.

Useful and preferred siloxanes include hexamethyl disiloxane, octamethyl trisiloxane, decamethyl tetrasiloxane, dodecamethyl pentasiloxane, and tetradecamethyl hexasiloxane.

Preferably, the formulation may comprise at most 5 % by weight, especially at most 3 % by weight of wetting additives. More preferably, the formulation comprises 0.01 to 4 % by weight, especially preferably 0.1 to 1 % by weight of wetting agent.

The formulation according to the present invention can be designed as an emulsion, dispersion or solution. Preferably, the present formulation is a solution (homogeneous mixture) comprising no considerable amounts of a second phase.

The formulation according to the present invention can be used for the preparation of organic electronic (OE) devices, for example transistors like OFETs or organic photovoltaic (OPV) devices like diodes or solar cells, or organic light emitting diodes (OLED).

Preference is given to an OLED which is prepared by using at least one formulation according to the present invention, wherein said formulation comprises at least two organic solvents as outlined above.

A typical sequence of layers as found in an OLED and O-SC is, for example:

- optionally a first substrate,
- an anode layer,
- optionally a hole injection layer (HIL),
- optionally a hole transport layer (HTL) and/or an electron blocking layer (EBL),
- an active layer, which upon electrical or optical exciation, produces excitons,
- optionally an electron transport layer (ETL) and/or a hole blocking layer (HBL),
- optionally an electron injection layer (EIL),
- a cathode layer,
- optionally a second substrate.

The sequence of the given layer structure is exemplary. Other sequences are possible. Depending on the active layers in the above mentioned device, different opto-electronic devices will be obtained. In a first preferred embodiment, the active layer generates excitons upon electrical excitation through applying voltage between anode and cathode, and further emits light through radiative decay of the excitons. In general, this is called light emitting device. In another preferred embodiment, the active layer generates exciton through absorbing light, and further produces free charge carrier through exciton dissociation. In general, this is called photovoltaic or solar cell.

The term interlayer as used herein is defined as layer between the hole injection layer (or buffer layer) and the emissive layer in polymer light emitting diodes (PLEDs), being an electron blocking layer, as disclosed for example in WO 2004/084260 A2. In another preferred embodiment, the electronic device is soluble system based OLEDs, particularly PLEDs as disclosed for example in WO 2004/084260 A2, which comprises the multilayer structure as follows: anode/HIL/EML/Cathode, wherein the double-layer HIL/EML is made by using at leat one method for multilayer structure as described above.

The HIL is usually a transparent conductive polymer thin film comprising HIM. Preferred HIM are those mentioned above. The emissive materials may further comprise a blend or mixture of two or more different emitters, for example two emitters of different type and/or emitters that emit light of different colors. Thus, a device may provide white light.

The device structure of the above mentioned further electronic device is clear to the skilled person in the art in the field. Nevertheless, for the sake of clarity, references are made to some detailed device structures. Organic light emitting electrochemical cells (OLECs) comprise two electrodes, and a mixture or blends of electrolyte and fluorescent species in between, as firstly reported by Pei & Heeger in Science (1995), 269, 1086-1088. I It is preferred here that an OLEC is prepared by using an formulation and the methods described above and below.

The formulation according to the present invention may be used to form a layer or multilayer structures.

A device may be fabricated comprising said layer.

Preferably the devices are opto-electronic devices as outlined elsewhere in the present invention.

Especially preferred OE devices are OFETs. A preferred OFET according to the present invention comprises the following components:

- optionally a substrate (1),
- a gate electrode (2),
- an insulator layer comprising a dielectric material (3),
- an OSC layer (4)
- source and drain electrodes (5),
- optionally one or more protection or passivation layers (6).

Figure 1A exemplarily and schematically depicts a typical bottom gate (BG), top contact (TC) OFET device, comprising a substrate (1), a gate electrode (2), a layer of dielectric material (3) (also known as gate insulator layer), an OSC layer (4), and source and drain (S/D) electrodes (5), and an optional passivation or protection layer (6).

The device of Figure 1A can be prepared by a process comprising the steps of depositing a gate electrode (2) on a substrate (1), depositing a dielectric layer (3) on top of the gate electrode (2) and the substrate (1), depositing an OSC layer (4) on top of the dielectric layer (3), depositing S/D electrodes (5) on top of the OSC layer (4), and optionally depositing a passivation or protection layer (6) on top of the S/D electrodes (5) and the OSC layer (4).

Figure 1B exemplarily and schematically depicts a typical bottom gate (BG), bottom contact (BC) OFET device comprising a substrate (1), a gate electrode (2), a dielectric layer (3), S/D electrodes (5), an OSC layer (4), and an optional passivation or protection layer (6).

The device of Figure 1B can be prepared by a process comprising the steps of depositing a gate electrode (2) on a substrate (1), depositing a dielectric layer (3) on top of the gate electrode (2) and the substrate (1), depositing S/D electrodes (5) on top of the dielectric layer (3), depositing an OSC layer (4) on top of the S/D electrodes (4) and the dielectric layer (3), and optionally depositing a passivation or protection layer (6) on top of the OSC layer (4).

Figure 2 exemplarily and schematically depicts a top gate (TG) OFET device, comprising a substrate (1), source and drain electrodes (5), an OSC layer (4), a dielectric layer (3), and a gate electrode (2), and an optional passivation or protection layer (6). The device of Figure 2 can be prepared by a process comprising the steps of depositing S/D electrodes (5) on a substrate (1), depositing an OSC layer (4) on top of the S/D electrodes (4) and the substrate (1), depositing a dielectric layer (3) on top of the OSC layer (4), depositing a gate electrode (2) on top of the dielectric layer (3), and optionally depositing a passivation or protection layer (6) on top of the gate electrode (2) and the dielectric layer (3).

The passivation or protection layer (6) in the devices described in Figures 1A, 1B and 2 has the purpose of protecting the OSC layer and the S/D or gate electrodes from further layers or devices that may be later provided thereon, and/or from environmental influence.

The distance between the source and drain electrodes (5), as indicated by the double arrow in Figures 1A, 1B and 2, is the channel area.

In case of formulations for use in OPV cells, the formulation preferably comprises or contains, more preferably consists essentially of, very preferably exclusively of, a p-type semiconductor and a n-type semiconductor, or an acceptor and a donor material. A preferred material of this type is a blend or mixture of poly(3-substituted thiophene) or P3AT with a $C_{60}$ or $C_{70}$ fullerene or modified $C_{60}$ molecule like PCBM [(6,6)-phenyl C61-butyric acid methyl ester], as disclosed for example in WO 94/05045 A1, wherein preferably the ratio of P3AT to fullerene is from 2:1 to 1:2 by weight, more preferably from 1.2:1 to 1:1.2 by weight.

Figure 3 and Figure 4 exemplarily and schematically depict typical and preferred OPV devices [see also Waldauf et al., Appl. Phys. Lett. 89, 233517 (2006)].

An OPV device as shown in Figure 3 preferably comprises:

- a low work function electrode (31) (for example a metal, such as aluminum), and a high work function electrode (32) (for example ITO), one of which is transparent,
- a layer (33) (also referred to as "active layer") comprising a hole transporting material and an electron transporting material, preferably selected from OSC materials, situated between the electrodes (31,32); the active layer can exist for example as a bilayer or two distinct layers or blend or mixture of p and n type semiconductor,

- an optional conducting polymer layer (34), for example comprising a blend of PEDOT:PSS (poly(3,4-ethylenedioxythiophene): poly(styrenesulfonate)), situated between the active layer (33) and the high work function electrode (32), to modify the work function of the high work function electrode to provide an ohmic contact for holes,
- an optional coating (35) (for example of LiF) on the side of the low workfunction electrode (31) facing the active layer (33), to provide an ohmic contact for electrons.

An inverted OPV device as shown in Figure 4 preferably comprises:

- a low work function electrode (41) (for example a metal, such as gold), and a high work function electrode (42) (for example ITO), one of which is transparent,
- a layer (43) (also referred to as "active layer") comprising a hole transporting material and an electron transporting material, preferably selected from OSC materials, situated between the electrodes (41,42); the active layer can exist for example as a bilayer or two distinct layers or blend or mixture of p and n type semiconductor,
- an optional conducting polymer layer (44), for example comprising a blend of PEDOT:PSS, situated between the active layer (43) and the low work function electrode (41) to provide an ohmic contact for electrons,
- an optional coating (45) (for example of $TiO_x$) on the side of the high workfunction electrode (42) facing the active layer (43), to provide an ohmic contact for holes.

The OPV devices typically may comprise a p-type (electron donor) semiconductor and an n-type (electron acceptor) semiconductor. Preferably, the p-type semiconductor is for example a polymer like poly(3-alkyl-thiophene) (P3AT), preferably poly(3-hexylthiophene) (P3HT), or alternatively another selected from the groups of preferred polymeric and monomeric OSC material as listed above. The n-type semiconductor can be an inorganic material such as zinc oxide or cadmium selenide, or an organic material such as a fullerene derivate, for example (6,6)-phenyl C61-butyric acid methyl ester, also known as "PCBM" or "$PC_{61}BM$", as disclosed for example in G. Yu, J. Gao, J.C. Hummelen, F. Wudl, A.J. Heeger, Science 1995, Vol. 270, p. 1789 ff and having the structure shown below, or an structural analogous compound with e.g. a $C_{71}$ fullerene group ($PC_{71}BM$), or a polymer (see for example Coakley, K. M. and McGehee, M. D. Chem. Mater. 2004, 16, 4533).

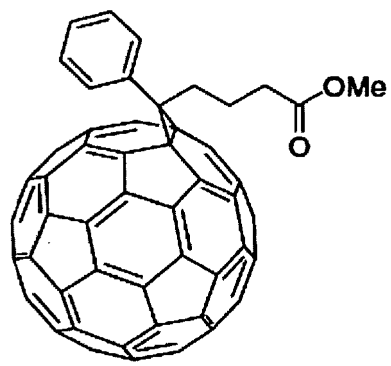

$PC_{61}BM$

A preferred material of this type is a blend or mixture of a polymer like P3HT or another polymer selected from the groups listed above, with a $C_{60}$ or $C_{70}$ fullerene or modified $C_{60}$ fullerene like $PC_{61}BM$ or $PC_{71}BM$. Preferably the ratio polymer:fullerene is from 2:1 to 1:2 by weight, more preferably from 1.2:1 to 1:1.2 by weight, most preferably 1:1 by weight. For the blended mixture, an optional annealing step may be necessary to optimize blend morpohology and consequently OPV device performance.

During the process of preparing an OE device, the OSC layer is deposited onto a substrate, followed by removal of the solvent together with any volatile additive(s) present, to form a film or layer.

Various substrates may be used for the fabrication of OE devices, for example glass, ITO coated glass, ITO glass with pre coated layers including PEDOT, PANI etc, or plastics, plastics materials being preferred, examples including alkyd resins, allyl esters, benzocyclobutenes, butadiene-styrene, cellulose, cellulose acetate, epoxide, epoxy polymers, ethylene-chlorotrifluoro ethylene, ethylene-tetra-fluoroethylene, fibre glass enhanced plastic, fluorocarbon polymers, hexafluoropropylenevinylidene-fluoride copolymer, high density polyethylene, parylene, polyamide, polyimide, polyaramid, polydimethylsiloxane, polyethersulphone, polyethylene, polyethylenenaphthalate, polyethyleneterephthalate, polyketone, polymethylmethacrylate, polypropylene, polystyrene, polysulphone, polytetrafluoroethylene, polyurethanes, polyvinylchloride, silicone rubbers, silicones, and flexible films with ITO, or other conducting layers and barrier

layers e.g. Vitex film.

Preferred substrate materials are polyethyleneterephthalate, polyimide, and polyethylenenaphthalate. The substrate may be any plastic material, metal or glass coated with the above materials. The substrate should preferably be homogeneous to ensure good pattern definition. The substrate may also be uniformly pre-aligned by extruding, stretching, rubbing or by photochemical techniques to induce the orientation of the organic semiconductor in order to enhance carrier mobility.

The electrodes can be deposited by liquid coating, such as spray-, dip-, web- or spin-coating, or by vacuum deposition or vapor deposition methods. Suitable electrode materials and deposition methods are known to the person skilled in the art. Suitable electrode materials include, without limitation, inorganic or organic materials, or composites of the two. Examples for suitable conductor or electrode materials include polyaniline, polypyrrole, PEDOT or doped conjugated polymers, further dispersions or pastes of graphite or particles of metal such as Au, Ag, Cu, Al, Ni or their mixtures as well as sputter coated or evaporated metals such as Cu, Cr, Pt/Pd or metal oxides such as indium tin oxide (ITO). Organometallic precursors may also be used deposited from a liquid phase.

Preferably, the substrate on surface on which the formulation according to the present invention is applied comprises a surface energy in the range of 100 to 35 mN $m^{-1}$ more preferably in the range of 80 to 40 mN $m^{-1}$ determined by measuring the contact angle of at least 2 solvents, e.g. water and methylene iodide, but other solvents can be used. These are typically measured using a contact angle goniometer such as a FTA 1000, at a temperature of 20 to 25°C (room temperature and at normal atmospheric pressure) the contact angle of the 2 solvents are then combined using a variety of mathematical models, typically Owens-Wendt geometric mean or Wu's harmonic mean. Preferably, the Owens-Wendt method is used.

Owens-Wendt formula

$$(1 + \cos\theta)\,\gamma LV = 2\sqrt{(\gamma^{D} SV\, \gamma^{D} LV)} + 2\sqrt{(\gamma^{P} SV\, \gamma^{P} LV)}$$

Wu's Harmonic mean formula

$$(1 + \cos\theta)\,\gamma LV = 4\{\gamma D\, SV \gamma D\, LV / (\gamma^{D} SV + \gamma^{D} LV) + \gamma^{P} SV \gamma^{P} LV / (\gamma^{P} SV + \gamma^{P} LV)\}$$

The printing can be performed preferably with droplets having a volume of at most 5 pl (pico liter), more preferably at most of 2 pi and especially preferably at most 1 pl. The droplet concerns the number average as can be determined by conventional methods, such as optical methods. Drop diameter measured and volume calculated, or volume can be calculated by jetting a known number of drops and weighing them.

As mentioned above and below, the present composition enables the printing of structures having a high resolution. Therefore, the present composition can be used in processes wherein the substrate is pixelated having a bank structure with a channel of ≤ 23µm (≥ 300ppi) and a bank width of ≤ 10µm. but having an overall width of (bank+ channel of ≤28µm). The bank is an elevation separating different channels which can be considered as recess. The bank structure of these substrates is well known and described in more detail, e. g. in US 7,160,633. Furthermore, such substrates are commercially available.

If a cross-linkable dielectric is used, it is preferably cross-linked after deposition by exposure to electron beam or electromagnetic (actinic) radiation, like for example X-ray, UV or visible radiation. For example, actinic radiation can be used having a wavelength of from 50 nm to 700 nm, preferably from 200 to 450 nm, most preferably from 300 to 400 nm. Suitable radiation dosages are typically in the range from 25 to 3,000 mJ/$cm^2$. Suitable radiation sources include mercury, mercury/xenon, mercury/halogen and xenon lamps, argon or xenon laser sources, x-ray, or e-beam. The exposure to actinic radiation will induce a cross-linking reaction in the cross-linkable groups of the dielectric material in the exposed regions. It is also possible for example to use a light source having a wavelength outside the absorption band of the cross-linkable groups, and to add a radiation sensitive photosensitizer to the cross-linkable material.

Optionally the dielectric material layer is annealed after exposure to radiation, for example at a temperature from 70°C to 130°C, for example for a period of from 1 to 30 minutes, preferably from 1 to 10 minutes. The annealing step at elevated temperature can be used to complete the cross-linking reaction that was induced by the exposure of the cross-linkable groups of the dielectric material to photoradiation.

Removal of the solvent and any volatile additive(s) is preferably achieved by evaporation, for example by exposing the deposited layer to high temperature and/or reduced pressure, preferably at -50°C to 300°C, more preferably 20°C to 250°C. According to a special aspect of the present invention, the solvent(s) and any volatile additive can be evaporated under reduced pressure. Preferably either atmospheric pressure or reduced pressure the pressure for solvent

evaporation ranges from $10^{-4}$ mbar to 1 bar, especially from $10^{-3}$ mbar to 100 mbar and more preferably from $10^{-2}$ mbar to 1 mbar. Moreover, the evaporation of the solvent can be preferably achieved below the boiling point of the solvent.

The thickness of the dried OSC layer is preferably from 1 nm to 50 μm, especially from 2 to 1000 nm and more preferably 3 to 500 nm. Preferred layers comprising organic light emitting materials and/or charge transporting materials can have a thickness in the range of 2 to 150 nm. Further to the materials and methods as described above and below, the OE device and its components can be prepared from standard materials and standard methods, which are known to the person skilled in the art and described in the literature.

It will be appreciated that variations to the foregoing embodiments of the invention can be made while still falling within the scope of the invention as defined in the claims.

Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

Unless the context clearly indicates otherwise, as used herein plural forms of the terms herein are to be construed as including the singular form and vice versa.

Throughout the description and claims of this specification, the words "comprise" and "contain" and variations of the words, for example "comprising" and "comprises", mean "including but not limited to", and are not intended to (and do not) exclude other components.

The term "polymer" includes homopolymers and copolymers, e.g. statistical, alternating or block copolymers. In addition, the term "polymer" as used hereinafter does also include oligomers and dendrimers. Dendrimers are typically branched macromolecular compounds consisting of a multifunctional core group onto which further branched monomers are added in a regular way giving a tree-like structure, as described e.g. in M. Fischer and F. Vögtle, Angew. Chem., Int. Ed. 1999, 38, 885.

The term "conjugated polymer" means a polymer containing in its backbone (or main chain) mainly C atoms with $sp^2$-hybridisation, or optionally sp-hybridisation, which may also be replaced by hetero atoms, enabling interaction of one π-orbital with another across an intervening σ-bond. In the simplest case this is for example a backbone with alternating carbon-carbon (or carbon-hetero atom) single and multiple (e.g. double or triple) bonds, but does also include polymers with units like 1,3-phenylene. "Mainly" means in this connection that a polymer with naturally (spontaneously) occurring defects, which may lead to interruption of the conjugation, is still regarded as a conjugated polymer. Also included in this meaning are polymers wherein the backbone comprises for example units like aryl amines, aryl phosphines and/or certain heterocycles (i.e. conjugation via N-, O-, P- or S-atoms) and/or metal organic complexes (i.e. conjugation via a metal atom). The term "conjugated linking group" means a group connecting two rings (usually aromatic rings) consisting of C atoms or hetero atoms with $sp^2$-hybridisation or sp-hybridisation. See also "IUPAC Compendium of Chemical terminology, Electronic version".

Unless stated otherwise, the molecular weight is given as the number average molecular weight $M_n$ or as weight average molecular weight $M_w$, which unless stated otherwise are determined by gel permeation chromatography (GPC) against polystyrene standards.

The degree of polymerization (n) means the number average degree of polymerization, unless stated otherwise given as $n = M_n/M_U$, wherein Mu is the molecular weight of the single repeating unit.

The term "small molecule" means a monomeric, i.e. a non-polymeric compound.

Unless stated otherwise, percentages of solids are per cent by weight ("wt. %"), percentages or ratios of liquids (like e.g. in solvent mixtures) are per cent by volume ("vol. %"), and all temperatures are given in degrees Celsius (°C).

Unless stated otherwise, concentrations or proportions of mixture components, given in percentages or ppm are related to the entire formulation including the solvents.

The invention will now be described in more detail by reference to the following examples, which are illustrative only and do not limit the scope of the present invention.

All process steps described above and below can be carried out using known techniques and standard equipment which are described in prior art and are well-known to the skilled person.

Comparative Example 1

A printing ink was prepared by mixing the compound H-1, the compound H-2 and the compound E-1 as mentioned below.

A mixture containing 97.5 % by weight of 3-phenoxy toluene, 1 % by weight of compound H-1, 1 % by weight of compound H-2 and 0.5 % by weight of compound E-1 was prepared in a glass vial. A small magnetic stirrer bar was

added and the glass vial was sealed. This was warmed to ~35 to 40°C and stirred for 2 hours to ensure complete dissolution of the solid materials. After dissolving the lid was removed and helium was bubbled through for 20 minutes in order to de-gas, after this the container was placed in a vacuum desicator and left overnight to remove the Helium.

Structures of the used OLED materials H-1, H-2 and E-1:

H-1:

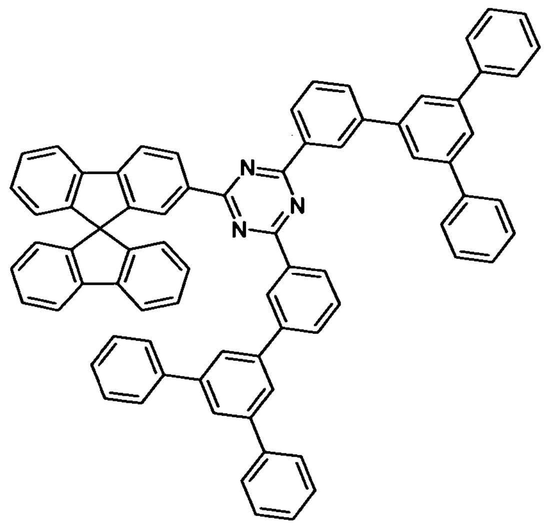

H-2:

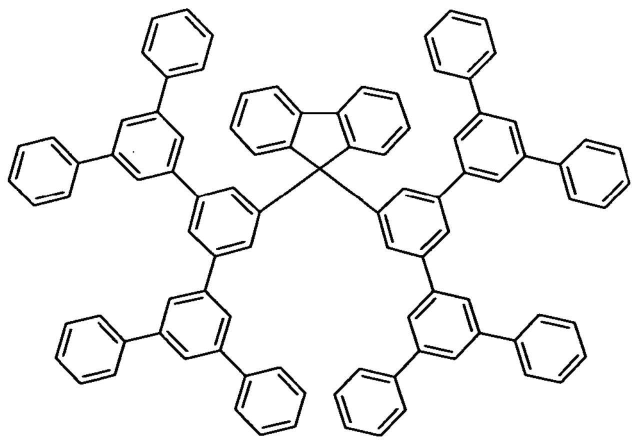

E-1:

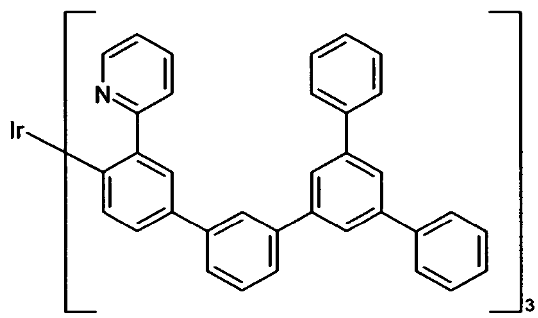

Viscosity was measured at 5.7 mPas using an AR G-2 rheometer parallel plate geometry using a Newtonian fit at a shear rate range of 10-1000 $s^{-1}$.

2 ml of the ink was filtered using a 0.22 μ filter (25 mm diameter ex Millipore) into a 1 pi Liquid Crystal Polymer (LCP) cartridge for use with a Dimatix DMP2831 printer. The head of the cartridge was put into position and then inserted into the ink-jet printer.

A full ink jet test was performed to assess the print performance of the ink, ink-jet behaviour was observed and commented on. Ink-jet waveform was optimised, and the effects of changing the voltage/frequency and pulse width on droplet velocity were also assessed.

20 ml of the same formulation was placed into the Litrex 70L printer with a 1 pi Konica Minolta (KM) print-head. For accurate and efficient printing a drop velocity of between 4-6m/s and a single drop is required. A maximum 40V is permitted to be applied the 1pl KM print-head, however KM recommended that 38V is not exceeded. In addition a linear increase in velocity with increasing voltage is required.

At 38V a drop velocity of between 2.8-3.5m/s was achievable dependant on nozzle.

Data shows that due to the high voltage applied it is at limit of printhead capabilities and it is not possible to obtain high print velocities.

Comparative Example 2

Essentially, Comparative Example 1 was repeated. However, a formulation comprising 3-phenoxy toluene + 20% anisole has been used.

A sample of formulation was prepared as follows:

| | |
|---|---|
| H-1: | 1.00% |
| H-2: | 1.00% |
| E-1: | 0.50% |
| 3-phenoxy toluene | 77.50% |
| anisole | 20.00%. |

Anisole exhibits a boiling point of 154°C, a RER (relative evaporation rate based on butyl acetate) of 17.063 and a vapour pressure at 25°C of 3.397 mm HG. Viscosity of the formulation was measured at 3.8 mPas using an AR G-2 rheometer parallel plate geometry using a Newtonian fit at a shear rate range of 10-1000 $s^{-1}$.

A typical ink-jet waveform involves applying a voltage for a certain time, an optimum time can be observed which gives the highest drop velocity. Here the same voltage is applied but the duration of that voltage is altered (pulse length). For this ink that was measured at 2.2μs.

When the voltage was decreased normally the ink-jet droplet decreases linearly. However in this case this did not occur. It was only possible to achieve a stable droplet between 5.5-7m/s. At lower voltages the droplets either failed to form a stable drop or 2 drops were formed. By modification of the waveform it was not possible to form a stable droplet between 3-5.5m/s.

Example 1

Essentially, Comparative Example 1 was repeated. However, a formulation comprising 3-phenoxy toluene + 20% ethyl benzoate has been used.

A sample of formulation was prepared as follows:

| | |
|---|---|
| H-1: | 1.00% |
| H-2: | 1.00% |
| E-1: | 0.50% |
| 3-phenoxy toluene | 77.50% |
| ethyl benzoate | 20.00%. |

Viscosity was measured at 3.9 mPas using an AR G-2 rheometer parallel plate geometry using a Newtonian fit at a shear rate range of 10-1000 $s^{-1}$.

Using the same pulse width (2.2μs) it was possible to obtain stable drop formation at velocities between 1-7m/s.

**Claims**

1. Composition comprising one or more organic semiconducting compounds, and a mixture of at least two different solvents wherein the first organic solvent has a boiling point in the range of 235 to 320°C and and a relative evaporation rate RER, based on butyl acetate = 100, of at most 0.60 and the second organic solvent has a relative evaporation rate RER, based on butyl acetate = 100, in the range of 0.65 to 10.0 and the solvent mixture comprises at least 50 % by weight of the first organic solvent, **characterized in that** the first organic solvent is an aromatic ether solvent and **in that** the second organic solvent is an aromatic ester compound.

2. Composition according to claim 1, **characterized in that** at least one of said organic semiconducting compounds has a molecular weight of at most 5,000 g/mol.

3. Composition according to claim 1 or 2, **characterized in that** at least one of said organic semiconducting compounds has a molecular weight in the range of 10,000 to 1,000,000 g/mol.

4. Composition according to one or more of claims 1 to 3, **characterized in that** the first organic solvent comprises a structure according to the following formula:

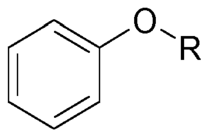

wherein R is selected from the group consisting of straight-chain alkyl or alkenyl groups having from 1 to 12 carbon atoms, branched-chain alkyl or alkenyl groups having from 3 to 12 carbon atoms and cyclic alkyl or alkenyl groups having from 3 to 12 carbon atoms, wherein one or more non-adjacent $CH_2$ groups may be optionally replaced by -O-, -(C=O)-, or -(C=O)-O-, and aryl or heteroaryl groups having from 4 to 6 carbon atoms, wherein one or more hydrogen atoms may be optionally replaced by a straight-chain alkyl group having from 1 to 12 carbon atoms or a branched-chain alkyl group having from 3 to 12 carbon atoms.

5. Composition according to one or more of claims 1 to 4, **characterized in that** the first organic solvent is 3-phenoxy toluene:

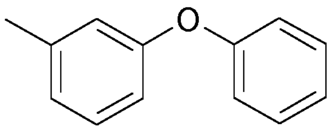

.

6. Composition according to one or more of claims 1 to 5, **characterized in that** the second organic solvent has a viscosity of at most 5 mPas and preferably at most 4 mPas and most preferably at most 3 mPas.

7. Composition according to one or more of claims 1 to 6, **characterized in that** the second organic solvent has a boiling point in the range of 170 to 300°C, preferably in the range of 180 to 270, more preferably in the range of 200 to 250°C.

8. Composition according to one or more of claims 1 to 7, **characterized in that** the boiling point of the first organic solvent is at least 10°C higher than the boiling point of the second organic solvent.

9. Composition according to one or more of claims 1 to 9, **characterized in that** the relative evaporation rate RER, based on butyl acetate = 100, of the second organic solvent is at least 0.65, preferably in the range from 0.7 to 10 and more preferably in the range from 1 to 7.

10. Composition according to one or more of claims 1 to 9, **characterized in that** the vapour pressure at 25°C of the second organic solvent is in the range from 9.33 to 133 Pa, preferably in the range from 8.00 to 40.0 Pa.

11. Composition according to one or more of claims 1 to 10, **characterized in that** the composition comprises 1 to 40,

preferably 3 to 30 and more preferably 10 to 25 % by weight of the second organic solvent.

**12.** Composition according to one or more of claims 1 to 11, **characterized in that** the second organic solvent is selected from the list consisting of: methyl benzoate, ethyl benzoate, and butyl phenylether.

**13.** Composition according to one or more of claims 1 to 12, **characterized in that** said composition has a viscosity at 25°C of at most 6 mPas, preferably at most 5 mPas.

**14.** Composition according to one or more of claims 1 to 13, **characterized in that** said composition comprises 0.01 to 10 % weight, preferably 0.5 to 7 % by weight of the organic semiconducting compound.

**15.** Composition according to one or more of claims 1 to 14, **characterized in that** the organic semiconducting compound is an organic light emitting material and/or charge transporting material.

**16.** Composition according to one or more of claims 1 to 15, **characterized in that** at least one of the organic semiconducting compound is selected from formula M1:

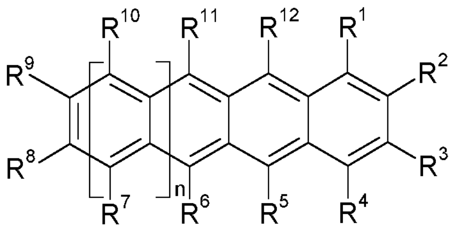

M1

wherein each of $R^1$, $R^2$, $R^3$, $R^4$, $R^5$, $R^6$, $R^7$, $R^8$, $R^9$, $R^{10}$, $R^{11}$ and $R^{12}$, which may be the same or different, independently represents:

hydrogen; an optionally substituted $C_1$-$C_{40}$ carbyl or hydrocarbyl group; an optionally substituted $C_1$-$C_{40}$ alkoxy group; an optionally substituted $C_6$-$C_{40}$ aryloxy group; an optionally substituted $C_7$-$C_{40}$ alkylaryloxy group; an optionally substituted $C_2$-$C_{40}$ alkoxycarbonyl group; an optionally substituted $C_7$-$C_{40}$ aryloxycarbonyl group; a cyano group (-CN); a carbamoyl group
(-C(=O)$NH_2$); a haloformyl group (-C(=O)-X, wherein X represents a halogen atom); a formyl group (-C(=O)-H); an isocyano group; an isocyanate group; a thiocyanate group or a thioisocyanate group; an optionally substituted amino group; a hydroxy group; a nitro group; a $CF_3$ group; a halo group (Cl, Br, F); or an optionally substituted silyl or alkynylsilyl group; and
wherein independently each pair of $R^1$ and $R^2$, $R^2$ and $R^3$, $R^3$ and $R^4$, $R^7$ and $R^8$, $R^8$ and $R^9$, $R^9$ and $R^{10}$, is optionally cross-bridged to form a $C_4$-$C_{40}$ saturated or unsaturated ring, which saturated or unsaturated ring may be intervened by an oxygen atom, a sulphur atom or a group of the formula -N($R^a$)-, wherein $R^a$ is a hydrogen atom or an optionally substituted hydrocarbon group, or may optionally be substituted; and
wherein one or more of the carbon atoms of the polyacene skeleton may optionally be substituted by a heteroatom selected from N, P, As, O, S, Se and Te; and
wherein independently any two or more of the substituents $R^1$-$R^{12}$ which are located on adjacent ring positions of the polyacene may, together, optionally constitute a further $C_4$-$C_{40}$ saturated or unsaturated ring optionally intervened by O, S or -N($R^a$), where $R^a$ is as defined above, or an aromatic ring system, fused to the polyacene; and
wherein n is 0, 1, 2, 3 or 4 preferably n is 0, 1 or 2, most preferably n is 0 or 2, meaning that the polyacene compound is a pentacene compound (if n = 2) or a "pseudo pentacene" compound (if n = 0).

**17.** Composition according to one or more of claims 1 to 16, **characterized in that** the organic semiconducting compound is a compound of the following formula

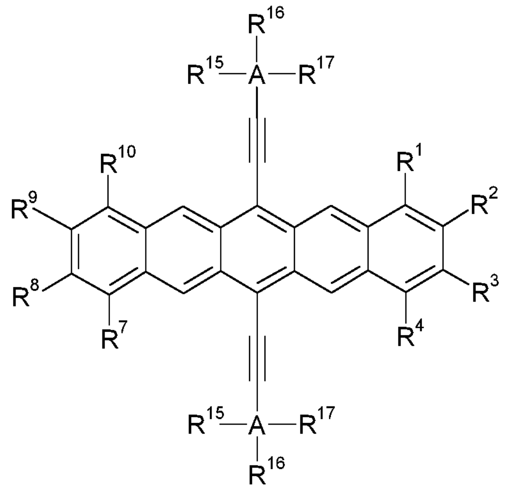

M1a

wherein $R^1$, $R^2$, $R^3$, $R^4$,$R^7$, $R^8$, $R^9$, $R^{10}$, $R^{15}$, $R^{16}$, $R^{17}$ each independently are the same or different and each independently represents: H; an optionally substituted $C_1$-$C_{40}$ carbyl or hydrocarbyl group; an optionally substituted $C_1$-$C_{40}$ alkoxy group; an optionally substituted $C_6$-$C_{40}$ aryloxy group; an optionally substituted $C_7$-$C_{40}$ alkylaryloxy group; an optionally substituted $C_2$-$C_{40}$ alkoxycarbonyl group; an optionally substituted $C_7$-$C_{40}$ aryloxycarbonyl group; a cyano group (-CN); a carbamoyl group ($-C(=O)NH_2$); a haloformyl group (-C(=O)-X, wherein X represents a halogen atom); a formyl group (-C(=O)-H); an isocyano group; an isocyanate group; a thiocyanate group or a thioisocyanate group; an optionally substituted amino group; a hydroxy group; a nitro group; a $CF_3$ group; a halo group (Cl, Br, F); or an optionally substituted silyl group; and A represents Silicon or Germanium; and

wherein independently each pair of $R^1$ and $R^2$, $R^2$ and $R^3$, $R^3$ and $R^4$, $R^7$ and $R^8$, $R^8$ and $R^9$, $R^9$ and $R^{10}$, $R^{15}$ and $R^{16}$, and $R^{16}$ and $R^{17}$ is optionally cross-bridged with each other to form a $C_4$-$C_{40}$ saturated or unsaturated ring, which saturated or unsaturated ring is optionally intervened by an oxygen atom, a sulphur atom or a group of the formula $-N(R^a)-$, wherein $R^a$ is a hydrogen atom or a hydrocarbon group, or is optionally substituted; and wherein one or more of the carbon atoms of the polyacene skeleton is optionally substituted by a heteroatom selected from N, P, As, O, S, Se and Te.

18. Composition according to one or more of claims 1 to 17, **characterized in that** the organic semiconducting compound is a compound of the following formula

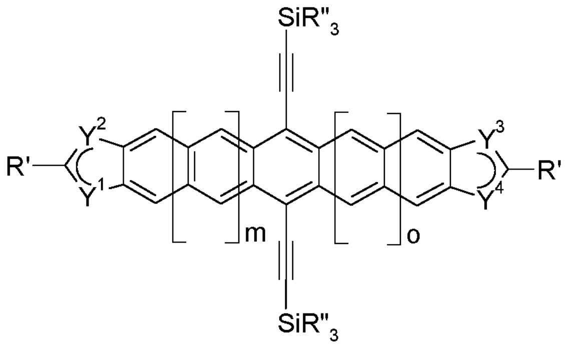

M1b1

wherein

one of $Y^1$ and $Y^2$ denotes -CH= or =CH- and the other denotes -X-;
one of $Y^3$ and $Y^4$ denotes -CH= or =CH- and the other denotes -X-;
X is -O-, -S-, -Se- or -NR‴-;
R' is H, F, Cl, Br, I, CN, straight-chain or branched alkyl or alkoxy that have 1 to 20 C-atoms and are optionally fluorinated or perfluorinated, optionally fluorinated or perfluorinated aryl having 6 to 30 C-atoms, or $CO_2R'''$, with R″″ being H, optionally fluorinated alkyl having 1 to 20 C-atoms or optionally fluorinated aryl having 2 to 30 C-atoms;

R" is, in case of multiple occurrence independently of one another, cyclic, straight-chain or branched alkyl or alkoxy that have 1 to 20, preferably 1 to 8 C-atoms, or aryl having 2-30 C-atoms, all of which are optionally fluorinated or perfluorinated;
R'" is H or cyclic, straight-chain or branched alkyl with 1 to 10 C-atoms;
m is 0 or 1; and
o is 0 or 1.

**19.** Composition according to claim 15, **characterized in that** the organic light emitting material having a molecular weight of at most 5000 g/mol is an organic phosphorescent compound which emits light and in addition contains at least one atom having an atomic number greater than 38.

**20.** Composition according to claim 19, **characterized in that** the phosphorescent compounds are compounds of formulae (1) to (4):

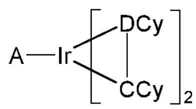
formula (1)

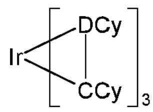
formula (2)

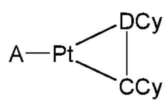
formula (3)

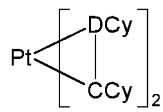
formula (4)

where

DCy is, identically or differently on each occurrence, a cyclic group which contains at least one donor atom, preferably nitrogen, carbon in the form of a carbene or phosphorus, via which the cyclic group is bonded to the metal, and which may in turn carry one or more substituents $R^{18}$; the groups DCy and CCy are connected to one another via a covalent bond;
CCy is, identically or differently on each occurrence, a cyclic group which contains a carbon atom via which the cyclic group is bonded to the metal and which may in turn carry one or more substituents $R^{18}$;
A is, identically or differently on each occurrence, a monoanionic, bidentate chelating ligand, preferably a diketonate ligand;
$R^{18}$ are identically or differently at each instance, and are F, Cl, Br, I, $NO_2$, CN, a straight-chain, branched or cyclic alkyl or alkoxy group having from 1 to 20 carbon atoms, in which one or more nonadjacent $CH_2$ groups may be replaced by -O-, -S-, $-NR^{19}-$, $-CONR^{19}-$, -CO-O-, -C=O-, -CH=CH- or -C≡C-, and in which one or more hydrogen atoms may be replaced by F, or an aryl or heteroaryl group which has from 4 to 14 carbon atoms and may be substituted by one or more nonaromatic $R^{18}$ radicals, and a plurality of substituents $R^{18}$, either on the same ring or on two different rings, may together in turn form a mono- or polycyclic, aliphatic or aromatic ring system; and
$R^{19}$ are identically or differently at each instance, and are a straight-chain, branched or cyclic alkyl or alkoxy group having from 1 to 20 carbon atoms, in which one or more nonadjacent $CH_2$ groups may be replaced by -O-, -S-, -CO-O-, -C=O-, -CH=CH- or -C≡C-, and in which one or more hydrogen atoms may be replaced by F, or an aryl or heteroaryl group which has from 4 to 14 carbon atoms and may be substituted by one or more nonaromatic $R^{18}$ radicals.

**21.** Use of a composition according to one or more of claims 1 to 20 as coating or printing ink for the preparation of organic electronic devices.

## Patentansprüche

**1.** Zusammensetzung enthaltend eine oder mehrere organische Halbleiterverbindungen und ein Gemisch aus mindestens zwei verschiedenen Lösungsmitteln, wobei das erste organische Lösungsmittel einen Siedepunkt im Bereich von 235 bis 320°C und eine relative Verdampfungsgeschwindigkeit RER (relative evaporation rate), bezogen auf

Butylacetat = 100, von höchstens 0,60 aufweist und das zweite organische Lösungsmittel eine relative Verdampfungsgeschwindigkeit RER, bezogen auf Butylacetat = 100, im Bereich von 0,65 bis 10,0 aufweist und das Lösungsmittelgemisch mindestens 50 Gew.-% des ersten organischen Lösungsmittels enthält, **dadurch gekennzeichnet, dass** das erste organische Lösungsmittel ein aromatisches Etherlösungsmittel ist und dass das zweite organische Lösungsmittel eine aromatische Esterverbindung ist.

**2.** Zusammensetzung nach Anspruch 1, **dadurch gekennzeichnet, dass** mindestens eine der genannten organischen Halbleiterverbindungen ein Molekulargewicht von höchstens 5.000 g/mol aufweist.

**3.** Zusammensetzung nach Anspruch 1 oder 2, **dadurch gekennzeichnet, dass** mindestens eine der genannten organischen Halbleiterverbindungen ein Molekulargewicht im Bereich von 10.000 bis 1.000.000 g/mol aufweist.

**4.** Zusammensetzung nach einem oder mehreren der Ansprüche 1 bis 3, **dadurch gekennzeichnet, dass** das erste organische Lösungsmittel eine Struktur gemäß der folgenden Formel enthält:

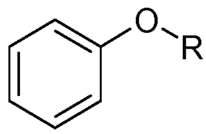

wobei R ausgewählt ist aus der Gruppe bestehend aus geradkettigen Alkyl- oder Alkenylgruppen mit 1 bis 12 Kohlenstoffatomen, verzweigtkettigen Alkyl- oder Alkenylgruppen mit 3 bis 12 Kohlenstoffatomen und cyclischen Alkyl- oder Alkenylgruppen mit 3 bis 12 Kohlenstoffatomen, wobei gegebenenfalls eine oder mehrere nicht benachbarte $CH_2$-Gruppen durch -O-, -(C=O)- oder -(C=O)-O- ersetzt sein können, und Aryl- oder Heteroarylgruppen mit 4 bis 6 Kohlenstoffatomen, wobei gegebenenfalls ein oder mehrere Wasserstoffatome durch eine geradkettige Alkylgruppe mit 1 bis 12 Kohlenstoffatomen oder eine verzweigtkettige Alkylgruppe mit 3 bis 12 Kohlenstoffatomen ersetzt sein können.

**5.** Zusammensetzung nach einem oder mehreren der Ansprüche 1 bis 4, **dadurch gekennzeichnet, dass** das erste organische Lösungsmittel 3-Phenoxytoluol ist:

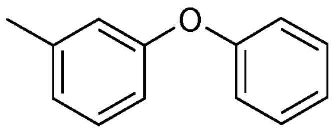

.

**6.** Zusammensetzung nach einem oder mehreren der Ansprüche 1 bis 5, **dadurch gekennzeichnet, dass** das zweite organische Lösungsmittel eine Viskosität von höchstens 5 mPas und vorzugsweise höchstens 4 mPas und am stärksten bevorzugt höchstens 3 mPas aufweist.

**7.** Zusammensetzung nach einem oder mehreren der Ansprüche 1 bis 6, **dadurch gekennzeichnet, dass** das zweite organische Lösungsmittel einen Siedepunkt im Bereich von 170 bis 300°C, vorzugsweise im Bereich von 180 bis 270, stärker bevorzugt im Bereich von 200 bis 250°C, besitzt.

**8.** Zusammensetzung nach einem oder mehreren der Ansprüche 1 bis 7, **dadurch gekennzeichnet, dass** der Siedepunkt des ersten organischen Lösungsmittels mindestens 10°C höher als der Siedepunkt des zweiten organischen Lösungsmittels ist.

**9.** Zusammensetzung nach einem oder mehreren der Ansprüche 1 bis 8, **dadurch gekennzeichnet, dass** die relative Verdampfungsgeschwindigkeit RER, bezogen auf Butylacetat = 100, des zweiten organischen Lösungsmittels mindestens 0,65 beträgt, vorzugsweise im Bereich von 0,7 bis 10 und stärker bevorzugt im Bereich von 1 bis 7 liegt.

**10.** Zusammensetzung nach einem oder mehreren der Ansprüche 1 bis 9, **dadurch gekennzeichnet, dass** der Dampfdruck des zweiten organischen Lösungsmittels bei 25°C im Bereich von 9,33 bis 133 Pa, vorzugsweise im Bereich von 8,00 bis 40,0 Pa, liegt.

**11.** Zusammensetzung nach einem oder mehreren der Ansprüche 1 bis 10, **dadurch gekennzeichnet, dass** die Zusammensetzung 1 bis 40, vorzugsweise 3 bis 30 und stärker bevorzugt 10 bis 25 Gew.-% des zweiten organischen Lösungsmittels enthält.

**12.** Zusammensetzung nach einem oder mehreren der Ansprüche 1 bis 11, **dadurch gekennzeichnet, dass** das zweite organische Lösungsmittel ausgewählt ist aus der Liste bestehend aus: Methylbenzoat, Ethylbenzoat und Butylphenylether.

**13.** Zusammensetzung nach einem oder mehreren der Ansprüche 1 bis 12, **dadurch gekennzeichnet, dass** die genannte Zusammensetzung eine Viskosität bei 25°C von höchstens 6 mPas, vorzugsweise höchstens 5 mPas, aufweist.

**14.** Zusammensetzung nach einem oder mehreren der Ansprüche 1 bis 13, **dadurch gekennzeichnet, dass** die genannte Zusammensetzung 0,01 bis 10 Gew.-%, vorzugsweise 0,5 bis 7 Gew.-%, der organischen Halbleiterverbindung enthält.

**15.** Zusammensetzung nach einem oder mehreren der Ansprüche 1 bis 14, **dadurch gekennzeichnet, dass** die organische Halbleiterverbindung ein organisches lichtemittierendes Material und/oder Ladungstransportmaterial ist.

**16.** Zusammensetzung nach einem oder mehreren der Ansprüche 1 bis 15, **dadurch gekennzeichnet, dass** mindestens eine der organischen Halbleiterverbindungen ausgewählt ist aus der Formel M1:

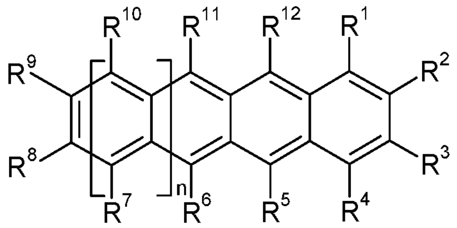

M1

wobei $R^1$, $R^2$, $R^3$, $R^4$, $R^5$, $R^6$, $R^7$, $R^8$, $R^9$, $R^{10}$, $R^{11}$ und $R^{12}$, die gleich oder verschieden sein können, jeweils unabhängig darstellen: Wasserstoff; eine gegebenenfalls substituierte $C_1$-$C_{40}$-Carbyl- oder -Hydrocarbylgruppe; eine gegebenenfalls substituierte $C_1$-$C_{40}$-Alkoxygruppe; eine gegebenenfalls substituierte $C_6$-$C_{40}$-Aryloxygruppe; eine gegebenenfalls substituierte $C_7$-$C_{40}$-Alkylaryloxygruppe; eine gegebenenfalls substituierte $C_2$-$C_{40}$-Alkoxycarbonylgruppe; eine gegebenenfalls substituierte $C_7$-$C_{40}$-Aryloxycarbonylgruppe; eine Cyanogruppe (-CN);

eine Carbamoylgruppe ($-C(=O)NH_2$); eine Halogenformylgruppe (-C(=O)-X, wobei X ein Halogenatom darstellt); eine Formylgruppe (-C(=O)-H); eine Isocyanogruppe; eine Isocyanatgruppe; eine Thiocyanatgruppe oder eine Thioisocyanatgruppe; eine gegebenenfalls substituierte Aminogruppe; eine Hydroxygruppe; eine Nitrogruppe; eine $CF_3$-Gruppe; eine Halogengruppe (Cl, Br, F); oder eine gegebenenfalls substituierte Silyl- oder Alkinylsilylgruppe; und

wobei jedes Paar von $R^1$ und $R^2$, $R^2$ und $R^3$, $R^3$ und $R^4$, $R^7$ und $R^8$, $R^8$ und $R^9$, $R^9$ und $R^{10}$ gegebenenfalls unabhängig zu einem gesättigten oder ungesättigten $C_4$-$C_{40}$-Ring querverbrückt ist, wobei der gesättigte oder ungesättigte Ring durch ein Sauerstoffatom, ein Schwefelatom oder eine Gruppe der Formel $-N(R^a)-$, wobei $R^a$ ein Wasserstoffatom oder eine gegebenenfalls substituierte Kohlenwasserstoffgruppe ist, unterbrochen sein kann, oder gegebenenfalls substituiert sein kann; und

wobei ein oder mehrere der Kohlenstoffatome des Polyacengerüsts gegebenenfalls durch ein aus N, P, As, O, S, Se und Te ausgewähltes Heteroatom substituiert sein können; und

wobei beliebige zwei oder mehr der Substituenten $R^1$-$R^{12}$, die sich in benachbarten Ringpositionen des Polyacens befinden, unabhängig gegebenenfalls zusammen einen weiteren gesättigten oder ungesättigten $C_4$-$C_{40}$-Ring, der gegebenenfalls durch O, S oder $-N(R^a)$, wo $R^a$ wie vorstehend definiert ist, unterbrochen ist, oder ein an das Polyacen anelliertes aromatisches Ringsystem bilden können; und wobei n 0, 1, 2, 3 oder 4 ist, vorzugsweise n 0, 1 oder 2 ist, am stärksten bevorzugt n 0 oder 2 ist, was bedeutet, dass es sich bei der Polyacenverbindung um eine Pentacenverbindung (wenn n=2) oder eine "Pseudopentacen"-Verbindung (wenn n=0) handelt.

**17.** Zusammensetzung nach einem oder mehreren der Ansprüche 1 bis 16, **dadurch gekennzeichnet, dass** die organische Halbleiterverbindung eine Verbindung der folgenden Formel

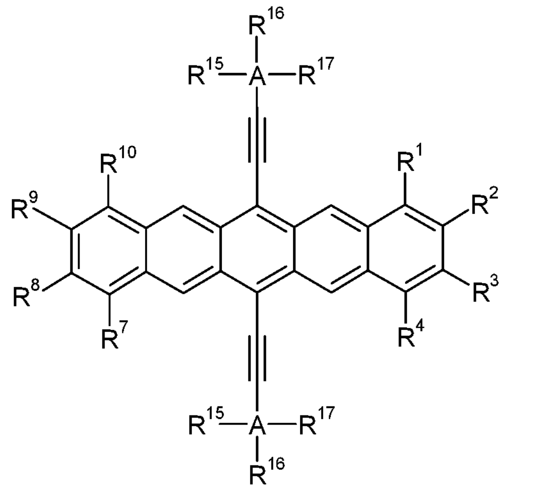

M1a

ist, wobei $R^1$, $R^2$, $R^3$, $R^4$,$R^7$, $R^8$, $R^9$, $R^{10}$, $R^{15}$, $R^{16}$, $R^{17}$ jeweils unabhängig gleich oder verschieden sind und jeweils unabhängig darstellen:

H; eine gegebenenfalls substituierte $C_1$-$C_{40}$-Carbyl- oder -Hydrocarbylgruppe; eine gegebenenfalls substituierte $C_1$-$C_{40}$-Alkoxygruppe; eine gegebenenfalls substituierte $C_6$-$C_{40}$-Aryloxygruppe; eine gegebenenfalls substituierte $C_7$-$C_{40}$-Alkylaryloxygruppe; eine gegebenenfalls substituierte $C_2$-$C_{40}$-Alkoxycarbonylgruppe; eine gegebenenfalls substituierte $C_7$-$C_{40}$-Aryloxycarbonylgruppe; eine Cyanogruppe (-CN); eine Carbamoylgruppe (-C(=O)$NH_2$); eine Halogenformylgruppe (-C(=O)-X, wobei X ein Halogenatom darstellt); eine Formylgruppe (-C(=O)-H); eine Isocyanogruppe; eine Isocyanatgruppe; eine Thiocyanatgruppe oder eine Thioisocyanatgruppe; eine gegebenenfalls substituierte Aminogruppe; eine Hydroxygruppe; eine Nitrogruppe; eine $CF_3$-Gruppe; eine Halogengruppe (Cl, Br, F); oder eine gegebenenfalls substituierte Silylgruppe; und A Silicium oder Germanium darstellt; und

wobei jedes Paar von $R^1$ und $R^2$, $R^2$ und $R^3$, $R^3$ und $R^4$, $R^7$ und $R^8$, $R^8$ und $R^9$, $R^9$ und $R^{10}$, $R^{15}$ und $R^{16}$, und $R^{16}$ und $R^{17}$ gegebenenfalls unabhängig miteinander zu einem gesättigten oder ungesättigten $C_4$-$C_{40}$-Ring querverbrückt ist, wobei der gesättigte oder ungesättigte Ring gegebenenfalls durch ein Sauerstoffatom, ein Schwefelatom oder eine Gruppe der Formel -N($R^a$)-, wobei $R^a$ ein Wasserstoffatom oder eine Kohlenwasserstoffgruppe ist, unterbrochen ist, oder gegebenenfalls substituiert ist; und

wobei ein oder mehrere der Kohlenstoffatome des Polyacengerüsts gegebenenfalls durch ein aus N, P, As, O, S, Se und Te ausgewähltes Heteroatom substituiert sind.

18. Zusammensetzung nach einem oder mehreren der Ansprüche 1 bis 17, **dadurch gekennzeichnet, dass** die organische Halbleiterverbindung eine Verbindung der folgenden Formel

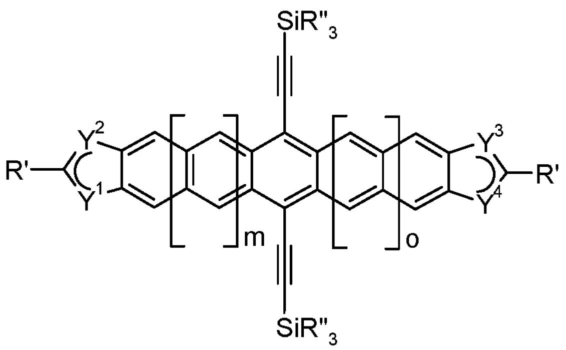

M1b1

ist, wobei

einer von $Y^1$ und $Y^2$ -CH= oder =CH- bedeutet und der andere -X-bedeutet;

einer von $Y^3$ und $Y^4$ -CH= oder =CH- bedeutet und der andere -X-bedeutet;
X -O-, -S-, -Se- oder -NR‴- ist;
R' H, F, Cl, Br, I, CN, geradkettiges oder verzweigtes Alkyl oder Alkoxy, die 1 bis 20 C-Atome aufweisen und gegebenenfalls fluoriert oder perfluoriert sind, gegebenenfalls fluoriertes oder perfluoriertes Aryl mit 6 bis 30 C-Atomen oder $CO_2$R″″ ist, wo R″″ H, gegebenenfalls fluoriertes Alkyl mit 1 bis 20 C-Atomen oder gegebenenfalls fluoriertes Aryl mit 2 bis 30 C-Atomen ist;
R", bei mehrfachem Auftreten unabhängig voneinander, cyclisches, geradkettiges oder verzweigtes Alkyl oder Alkoxy, die 1 bis 20, vorzugsweise 1 bis 8, C-Atome aufweisen, oder Aryl mit 2-30 C-Atomen ist, die alle gegebenenfalls fluoriert oder perfluoriert sind;
R'" H oder cyclisches, geradkettiges oder verzweigtes Alkyl mit 1 bis 10 C-Atomen ist;
m 0 oder 1 ist; und
o 0 oder 1 ist.

**19.** Zusammensetzung nach Anspruch 15, **dadurch gekennzeichnet, dass** es sich bei dem organischen lichtemittierenden Material mit einem Molekulargewicht von höchstens 5000 g/mol um eine organische phosphoreszierende Verbindung handelt, die Licht emittiert und zusätzlich mindestens ein Atom mit einer Ordnungszahl größer als 38 enthält.

**20.** Zusammensetzung nach Anspruch 19, **dadurch gekennzeichnet, dass** es sich bei den phosphoreszierenden Verbindungen um Verbindungen der Formeln (1) bis (4) handelt:

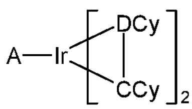

Formel (1)

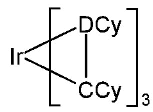

Formel (2)

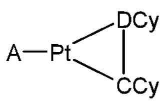

Formel (3)

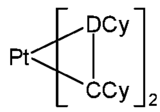

Formel (4)

wo

DCy gleich oder verschieden bei jedem Auftreten eine cyclische Gruppe ist, die mindesten ein Donoratom, vorzugsweise Stickstoff, Kohlenstoff in Form eines Carbens oder Phosphor, enthält, über welches die cyclische Gruppe an das Metall gebunden ist, und die wiederum einen oder mehrere Substituenten $R^{18}$ tragen kann; die Gruppen DCy und CCy sind über eine kovalente Bindung miteinander verbunden;
CCy gleich oder verschieden bei jedem Auftreten eine cyclische Gruppe ist, die ein Kohlenstoffatom enthält, über welches die cyclische Gruppe an das Metall gebunden ist und die wiederum einen oder mehrere Substituenten $R^{18}$ tragen kann;
A gleich oder verschieden bei jedem Auftreten ein monoanionischer, zweizähniger chelatisierender Ligand, vorzugsweise ein Diketonatligand, ist;
$R^{18}$ bei jedem Auftreten gleich oder verschieden sind und F, Cl, Br, I, $NO_2$, CN, eine geradkettige, verzweigte oder cyclische Alkyl- oder Alkoxygruppe mit 1 bis 20 Kohlenstoffatomen, worin eine oder mehrere nicht benachbarte $CH_2$-Gruppen durch -O-, -S-, -$NR^{19}$-, -$CONR^{19}$-, -CO-O-, -C=0-, -CH=CH- oder -C≡C- ersetzt sein können und worin ein oder mehrere Wasserstoffatome durch F ersetzt sein können, oder eine Aryl- oder Heteroarylgruppe, die 4 bis 14 Kohlenstoffatome aufweist und durch einen oder mehrere nichtaromatische Reste $R^{18}$ substituiert sein kann, sind, und mehrere Substituenten $R^{18}$, entweder am selben Ring oder an zwei verschiedenen Ringen, zusammen wiederum ein mono- oder polycyclisches, aliphatisches oder aromatisches Ringsystem bilden können; und
$R^{19}$ bei jedem Auftreten gleich oder verschieden sind und eine geradkettige, verzweigte oder cyclische Alkyl- oder Alkoxygruppe mit 1 bis 20 Kohlenstoffatomen, worin eine oder mehrere nicht benachbarte $CH_2$-Gruppen durch -O-, -S-, -CO-O-, -C=O-, -CH=CH- oder -C≡C- ersetzt sein können und worin ein oder mehrere Wasserstoffatome durch F ersetzt sein können, oder eine Aryl- oder Heteroarylgruppe, die 4 bis 14 Kohlenstoffatome aufweist und durch einen oder mehrere nichtaromatische Reste $R^{18}$ substituiert sein kann, sind.

21. Verwendung einer Zusammensetzung nach einem oder mehreren der Ansprüche 1 bis 20 als Beschichtung oder Druckfarbe für die Herstellung von organischen elektronischen Vorrichtungen.

**Revendications**

1. Composition comprenant un ou plusieurs composés semi-conducteurs organiques, et un mélange d'au moins deux solvants différents, où le premier solvant organique présente un point d'ébullition dans la plage allant de 235 à 320°C et un taux d'évaporation relatif RER, basé sur l'acétate de butyle = 100, d'au plus 0,60 et le deuxième solvant organique présente un taux d'évaporation relatif, RER, basé sur l'acétate de butyle = 100, dans la plage allant de 0,65 à 10,0 et le mélange de solvants comprend au moins 50% en poids du premier solvant organique, **caractérisée en ce que** le premier solvant organique est un solvant à base d'éther aromatique et **en ce que** le deuxième solvant organique est un composé d'ester aromatique.

2. Composition selon la revendication 1, **caractérisée en ce qu'**au moins l'un parmi lesdits composés semi-conducteurs organiques présente un poids moléculaire d'au plus 5000 g/mol.

3. Composition selon la revendication 1 ou 2, **caractérisée en ce qu'**au moins l'un parmi lesdits composés semi-conducteurs organiques présente un poids moléculaire dans la plage allant de 10 000 à 1 000 000 g/mol.

4. Composition selon l'une ou plusieurs parmi les revendications 1 à 3, **caractérisée en ce que** le premier solvant organique comprend une structure répondant à la formule suivante :

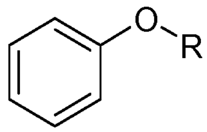

dans laquelle R est choisi dans le groupe constitué par des groupements alkyle ou alcényle à chaîne linéaire ayant de 1 à 12 atomes de carbone, des groupements alkyle ou alcényle à chaîne ramifiée ayant de 3 à 12 atomes de carbone et des groupements alkyle ou alcényle cycliques ayant de 3 à 12 atomes de carbone, où un ou plusieurs groupements $CH_2$ non adjacents peuvent éventuellement être remplacés par -O-, -(C=O)-, ou -(C=O)-O-, et des groupements aryle ou hétéroaryle ayant de 4 à 6 atomes de carbone, où un ou plusieurs atomes d'hydrogène peuvent éventuellement être remplacés par un groupement alkyle à chaîne linéaire ayant de 1 à 12 atomes de carbone ou un groupement alkyle à chaîne ramifiée ayant de 3 à 12 atomes de carbone.

5. Composition selon l'une ou plusieurs parmi les revendications 1 à 4, **caractérisée en ce que** le premier solvant organique est le 3-phénoxy toluène :

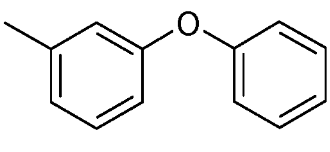

.

6. Composition selon l'une ou plusieurs parmi les revendications 1 à 5, **caractérisée en ce que** le deuxième solvant organique présente une viscosité d'au plus 5 mPa.s et préférablement d'au plus 4 mPa.s et tout préférablement d'au plus 3 mPa.s.

7. Composition selon l'une ou plusieurs parmi les revendications 1 à 6, **caractérisée en ce que** le deuxième solvant organique présente un point d'ébullition dans la plage allant de 170 à 300°C, préférablement dans la plage allant de 180 à 270°C, plus préférablement dans la plage allant de 200 à 250°C.

8. Composition selon l'une ou plusieurs parmi les revendications 1 à 7, **caractérisée en ce que** le point d'ébullition du premier solvant organique est d'au moins 10°C plus élevé que le point d'ébullition du deuxième solvant organique.

9. Composition selon l'une ou plusieurs parmi les revendications 1 à 8, **caractérisée en ce que** le taux d'évaporation

relatif RER, basé sur l'acétate de butyle = 100, du deuxième solvant organique est d'au moins 0,65, préférablement dans la plage allant de 0,7 à 10 et plus préférablement dans la plage allant de 1 à 7.

**10.** Composition selon l'une ou plusieurs parmi les revendications 1 à 9, **caractérisée en ce que** la pression de vapeur à 25°C du deuxième solvant organique est dans la plage allant de 9,33 à 133 Pa, préférablement dans la plage allant de 8,00 à 40,0 Pa.

**11.** Composition selon l'une ou plusieurs parmi les revendications 1 à 10, **caractérisée en ce que** la composition comprend de 1 à 40, préférablement de 3 à 30 et plus préférablement de 10 à 25% en poids du deuxième solvant organique.

**12.** Composition selon l'une ou plusieurs parmi les revendications 1 à 11, **caractérisée en ce que** le deuxième solvant organique est choisi dans la liste constituée par : le benzoate de méthyle, le benzoate d'éthyle, et le butyl phényléther.

**13.** Composition selon l'une ou plusieurs parmi les revendications 1 à 12, **caractérisée en ce que** ladite composition présente une viscosité à 25°C d'au plus 6 mPa.s, préférablement d'au plus 5 mPa.s.

**14.** Composition selon l'une ou plusieurs parmi les revendications 1 à 13, **caractérisée en ce que** ladite composition comprend de 0,01 à 10% en poids, préférablement de 0,5 à 7% en poids du composé semi-conducteur organique.

**15.** Composition selon l'une ou plusieurs parmi les revendications 1 à 14, **caractérisée en ce que** le composé semi-conducteur organique est un matériau organique émetteur de lumière et/ou un matériau transporteur de charge.

**16.** Composition selon l'une ou plusieurs parmi les revendications 1 à 15, **caractérisée en ce qu'**au moins l'un parmi les composés semi-conducteurs organiques est choisi parmi la formule M1 :

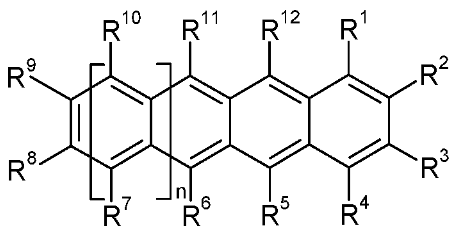

M1

dans laquelle chacun parmi $R^1$, $R^2$, $R^3$, $R^4$, $R^5$, $R^6$, $R^7$, $R^8$, $R^9$, $R^{10}$, $R^{11}$ et $R^{12}$, qui peuvent être identiques ou différents, représente indépendamment : hydrogène ; un groupement $C_1$-$C_{40}$ carbyle ou hydrocarbyle éventuellement substitué ; un groupement $C_1$-$C_{40}$ alcoxy éventuellement substitué ; un groupement $C_6$-$C_{40}$ aryloxy éventuellement substitué ; un groupement $C_7$-$C_{40}$ alkylaryloxy éventuellement substitué ; un groupement $C_2$-$C_{40}$ alcoxycarbonyle éventuellement substitué ; un groupement $C_7$-$C_{40}$ aryloxycarbonyle éventuellement substitué ; un groupement cyano (-CN) ; un groupement carbamoyle (-C(=O)$NH_2$) ; un groupement halogénoformyle (-C(=O)-X, où X représente un atome d'halogène) ; un groupement formyle (-C(=O)-H) ; un groupement isocyano ; un groupement isocyanate ; un groupement thiocyanate ou un groupement thioisocyanate ; un groupement amino éventuellement substitué ; un groupement hydroxy ; un groupement nitro ; un groupement $CF_3$ ; un groupement halogéno (Cl, Br, F) ; ou un groupement silyle ou alcynylsilyle éventuellement substitué ; et

où indépendamment chaque paire de $R^1$ et $R^2$, $R^2$ et $R^3$, $R^3$ et $R^4$, $R^7$ et $R^8$, $R^8$ et $R^9$, $R^9$ et $R^{10}$, est éventuellement à pontage croisé pour former un cycle saturé ou insaturé en $C_4$-$C_{40}$, lequel cycle saturé ou insaturé peut être interrompu par un atome d'oxygène, un atome de soufre ou un groupement de formule -N($R^a$)-, où $R^a$ est un atome d'hydrogène ou un groupement hydrocarboné éventuellement substitué, ou peut éventuellement être substitué ; et
où un ou plusieurs parmi les atomes de carbone du squelette polyacène peuvent éventuellement être substitués par un hétéroatome choisi parmi N, P, As, O, S, Se et Te ; et
où indépendamment deux, ou plus, quelconques parmi les substituants $R^1$-$R^{12}$ qui sont situés sur des positions de cycle adjacentes du polyacène peuvent, ensemble, constituer éventuellement un autre cycle en $C_4$-$C_{40}$ saturé ou insaturé éventuellement interrompu par O, S ou -N($R^a$), où $R^a$ est tel que défini ci-dessus, ou un noyau aromatique, condensé au polyacène ; et
où n vaut 0, 1, 2, 3 ou 4 préférablement n vaut 0, 1 ou 2, tout préférablement n vaut 0 ou 2, signifiant que le

composé de polyacène est un composé de pentacène (si n = 2) ou un composé de « pseudo pentacène » (si n = 0).

**17.** Composition selon l'une ou plusieurs parmi les revendications 1 à 16, **caractérisée en ce que** le composé semi-conducteur organique est un composé de formule suivante

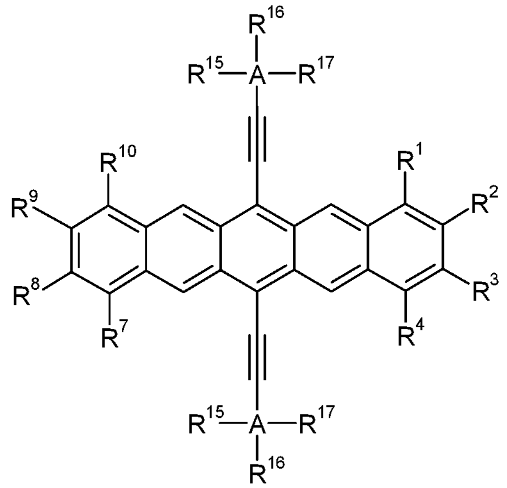

M1a

dans laquelle $R^1$, $R^2$, $R^3$, $R^4$,$R^7$, $R^8$, $R^9$, $R^{10}$, $R^{15}$, $R^{16}$, $R^{17}$ sont chacun indépendamment identiques ou différents et représentent chacun indépendamment : H ; un groupement $C_1$-$C_{40}$ carbyle ou hydrocarbyle éventuellement substitué ; un groupement $C_1$-$C_{40}$ alcoxy éventuellement substitué ; un groupement $C_6$-$C_{40}$ aryloxy éventuellement substitué ; un groupement $C_7$-$C_{40}$ alkylaryloxy éventuellement substitué ; un groupement $C_2$-$C_{40}$ alcoxycarbonyle éventuellement substitué ; un groupement $C_7$-$C_{40}$ aryloxycarbonyle éventuellement substitué ; un groupement cyano (-CN) ; un groupement carbamoyle ($-C(=O)NH_2$) ; un groupement halogénoformyle (-C(=O)-X, où X représente un atome d'halogène) ; un groupement formyle (-C(=O)-H) ; un groupement isocyano ; un groupement isocyanate ; un groupement thiocyanate ou un groupement thioisocyanate ; un groupement amino éventuellement substitué ; un groupement hydroxy ; un groupement nitro ; un groupement $CF_3$ ; un groupement halogéno (Cl, Br, F) ; ou un groupement silyle éventuellement substitué ; et A représente silicium ou germanium ; et
où indépendamment chaque paire de $R^1$ et $R^2$, $R^2$ et $R^3$, $R^3$ et $R^4$, $R^7$ et $R^8$, $R^8$ et $R^9$, $R^9$ et $R^{10}$, $R^{15}$ et $R^{16}$, et $R^{16}$ et $R^{17}$ est éventuellement à pontage croisé les unes avec les autres pour former un cycle en $C_4$-$C_{40}$ saturé ou insaturé, lequel cycle saturé ou insaturé est éventuellement interrompu par un atome d'oxygène, un atome de soufre ou un groupement de formule $-N(R^a)-$, où $R^a$ est un atome d'hydrogène ou un groupement hydrocarboné, ou est éventuellement substitué ; et
où un ou plusieurs parmi les atomes de carbone du squelette polyacène sont éventuellement substitué par un hétéroatome choisi parmi N, P, As, O, S, Se et Te.

**18.** Composition selon l'une ou plusieurs parmi les revendications 1 à 17, **caractérisée en ce que** le composé semi-conducteur organique est un composé de formule suivante

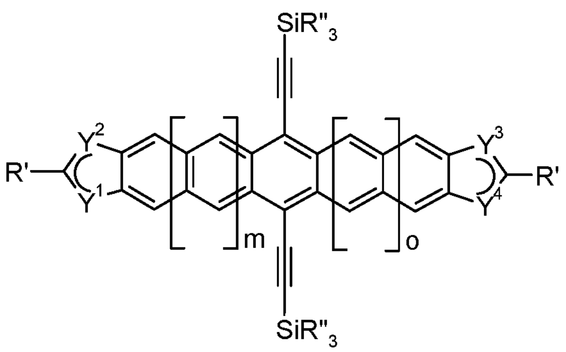

M1b1

dans laquelle

l'un parmi $Y^1$ et $Y^2$ désigne -CH= ou =CH- et l'autre désigne -X- ;
l'un parmi $Y^3$ et $Y^4$ désigne -CH= ou =CH- et l'autre désigne -X- ;
X est -O-, -S-, -Se- ou -NR‴- ;
R' est H, F, Cl, Br, I, CN, alkyle ou alcoxy à chaîne linéaire ou ramifiée ayant de 1 à 20 atomes de C et étant éventuellement fluoré ou perfluoré, aryle éventuellement fluoré ou perfluoré ayant de 6 à 30 atomes de C, ou $CO_2R''''$, R'''' étant H, alkyle éventuellement fluoré ayant de 1 à 20 atomes de C ou aryle éventuellement fluoré ayant de 2 à 30 atomes de C ;
R" est, dans le cas d'une occurrence multiple, indépendamment les uns des autres, alkyle ou alcoxy cyclique, à chaîne linéaire ou ramifiée ayant de 1 à 20, préférablement de 1 à 8 atomes de C, ou aryle ayant de 2-30 atomes de C, l'ensemble de ceux-ci étant éventuellement fluorés ou perfluorés ;
R'" est H ou alkyle cyclique, à chaîne linéaire ou ramifiée ayant de 1 à 10 atomes de C ;
m vaut 0 ou 1 ; et
o vaut 0 ou 1.

**19.** Composition selon la revendication 15, **caractérisée en ce que** le matériau organique émetteur de lumière ayant un poids moléculaire d'au plus 5000 g/mol est un composé phosphorescent organique qui émet de la lumière et qui contient en outre au moins un atome ayant un numéro atomique supérieur à 38.

**20.** Composition selon la revendication 19, **caractérisée en ce que** les composés phosphorescents sont des composés de formules (1) à (4) :

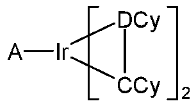

formule (1)

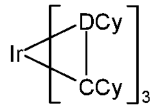

formule (2)

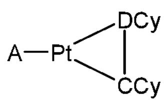

formule (3)

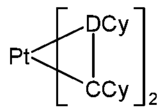

formule (4)

dans lesquelles

DCy est, de manière identique ou différente à chaque occurrence, un groupement cyclique qui contient au moins un atome donneur, préférablement de l'azote, du carbone sous la forme de carbène ou du phosphore, via lequel le groupement cyclique est lié au métal, et qui peut à son tour porter un ou plusieurs substituants $R^{18}$ ; les groupements DCy et CCy sont reliés l'un à l'autre via une liaison covalente ;
CCy est, de manière identique ou différente à chaque occurrence, un groupement cyclique qui contient un atome de carbone via lequel le groupement cyclique est lié au métal, et qui peut à son tour porter un ou plusieurs substituants $R^{18}$ ;
A est, de manière identique ou différente à chaque occurrence, un ligand chélateur mono-anionique, bidenté, préférablement un ligand de type dicétonate ;
$R^{18}$ sont identiques ou différents dans chaque cas, et sont F, Cl, Br, I, $NO_2$, CN, un groupement alkyle ou alcoxy à chaîne linéaire, ramifiée ou cyclique ayant de 1 à 20 atomes de carbone, où un ou plusieurs groupements $CH_2$ non adjacents peuvent être remplacés par -O-, -S-, $-NR^{19}-$, $-CONR^{19}-$, -CO-O-, -C=O-, -CH=CH-ou -C≡C-, et où un ou plusieurs atomes d'hydrogène peuvent être remplacés par F, ou un groupement aryle ou hétéroaryle ayant de 4 à 14 atomes de carbone et pouvant être substitué par un ou plusieurs radicaux $R^{18}$ non aromatiques, et une pluralité de substituants $R^{18}$, sur le même cycle ou bien sur deux cycles différents, peuvent former ensemble à leur tour un noyau mono- ou polycyclique, aliphatique ou aromatique ; et
$R^{19}$ sont identiques ou différents dans chaque cas, et sont un groupement alkyle ou alcoxy à chaîne linéaire, ramifiée ou cyclique ayant de 1 à 20 atomes de carbone, où un ou plusieurs groupements $CH_2$ non adjacents peuvent être remplacés par -O-, -S-, -CO-O-, -C=O-, -CH=CH- ou -C≡C-, et où un ou plusieurs atomes d'hydrogène peuvent être remplacés par F, ou un groupement aryle ou hétéroaryle ayant de 4 à 14 atomes de carbone et pouvant être substitué par un ou plusieurs radicaux $R^{18}$ non aromatiques.

**21.** Utilisation d'une composition selon l'une ou plusieurs parmi les revendications 1 à 20, comme revêtement ou encre d'impression pour la préparation de dispositifs électroniques organiques.

Figure 1a

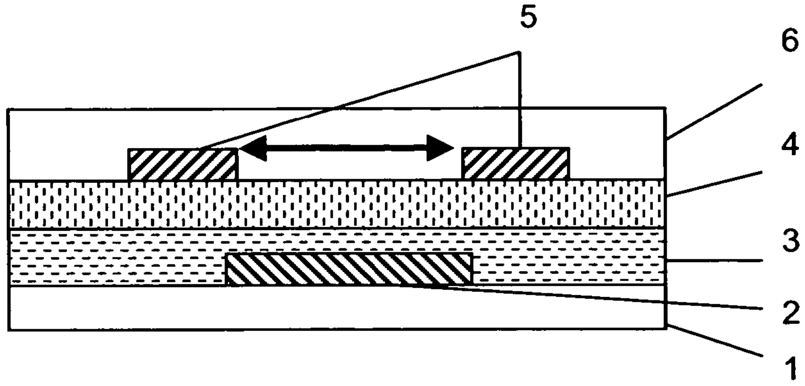


Figure 1b

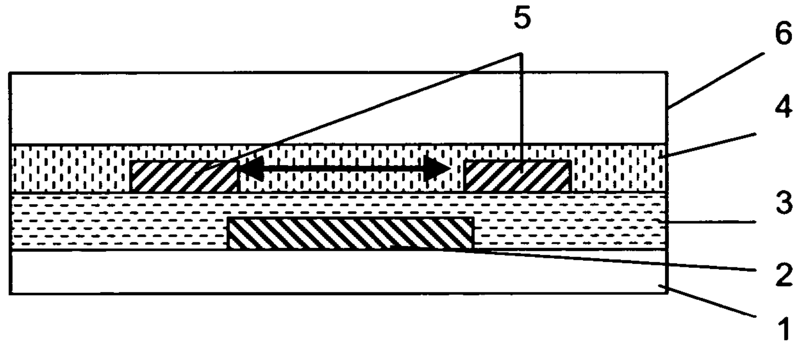


Figure 2

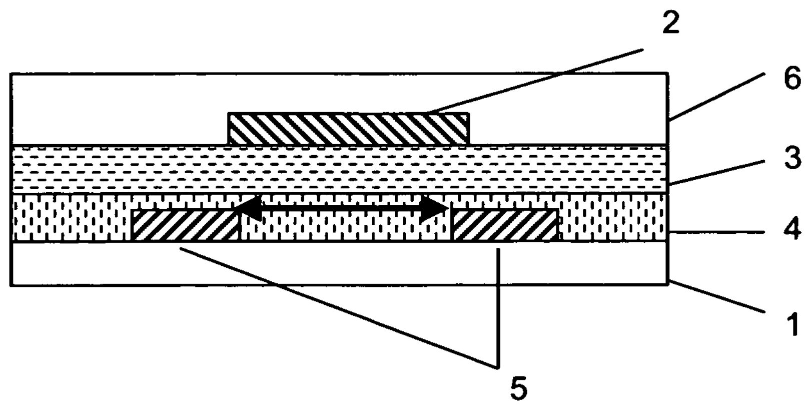

Figure 3

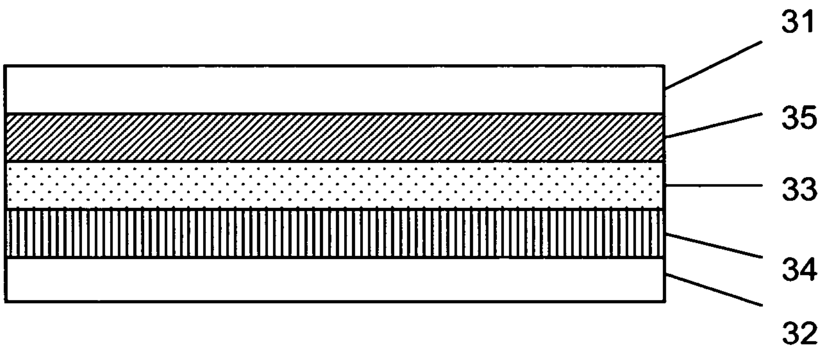


Figure 4

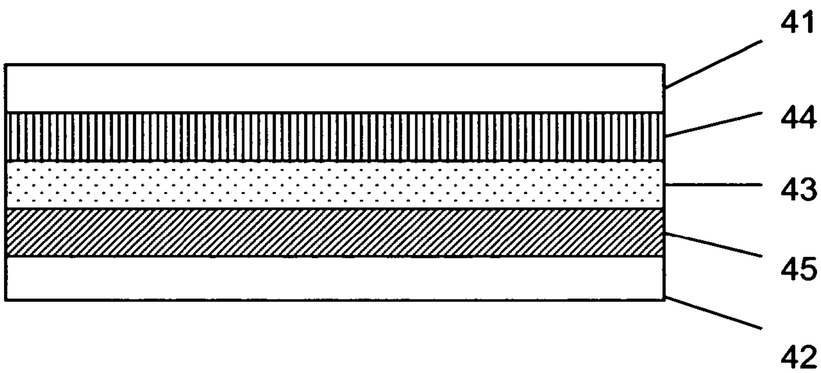

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6690029 B
- WO 2005055248 A1
- WO 2008107089 A1
- US 7385221 B
- WO 2011076325 A
- WO 0070655 A
- WO 0141512 A
- WO 0202714 A
- WO 0215645 A
- EP 1191613 A
- EP 1191612 A
- EP 1191614 A
- WO 04081017 A
- WO 05033244 A
- WO 05042550 A
- WO 05113563 A
- WO 06008069 A
- WO 06061182 A
- WO 06081973 A
- DE 102008027005
- WO 06122630 A
- WO 08006449 A
- WO 07140847 A
- WO 06000388 A
- WO 06058737 A
- WO 061000389 A
- WO 07065549 A
- WO 07115610 A
- DE 102008035413
- JP 6001973 A
- WO 04047499 A
- WO 06098080 A
- WO 07065678 A
- US 20050260442 A
- WO 04092111 A
- EP 676461 A
- WO 04058911 A
- WO 05084081 A
- WO 05084082 A
- WO 06048268 A
- WO 06117052 A
- WO 08145239 A
- WO 04018587 A
- US 5935721 A
- US 20050181232 A
- JP 2000273056 A
- EP 681019 A
- US 20040247937 A
- US 20050211958 A
- EP 1476881 A
- EP 1596445 A
- WO 06100896 A
- EP 1661888 A
- WO 01049806 A
- US 5061569 A
- WO 9509147 A
- JP 2001226331 A
- EP 650955 A
- US 4780536 A
- WO 9830071 A
- EP 891121 A
- JP 2006253445 A
- WO 06073054 A
- JP 2000053957 A
- WO 03060956 A
- WO 04028217 A
- WO 04080975 A
- WO 04013080 A
- WO 04093207 A
- WO 06005627 A
- DE 102008033943
- WO 05039246 A
- US 20050069729 A
- JP 2004288381 A
- EP 1205527 A
- WO 08086851 A
- WO 07063754 A
- WO 08056746 A
- EP 1617710 A
- EP 1617711 A
- EP 1731584 A
- JP 2005347160 A
- WO 07137725 A
- WO 05111172 A
- DE 102008036982
- DE 102007053771
- WO 02077060 A1
- WO 2005014689 A2
- WO 2010136110 A2
- WO 02068435 A1
- WO 02081488 A1
- EP 1239526 A2
- WO 2005042548 A1
- WO 2004070772 A2
- WO 2004113468 A1
- WO 2005040302 A1
- WO 2005030827 A1

- WO 2005030828 A1
- WO 2004084260 A2
- WO 9405045 A1
- US 7160633 B

**Non-patent literature cited in the description**

- Hansen Solubility Parameters in Practice HSPiP
- **C. M. HANSEN.** Hansen Solubility Parameters: A User's Handbook. Taylor and Francis Group, 2007
- **Y. SHIROTA et al.** *Chem. Rev.,* 2007, vol. 107 (4), 953-1010
- **ROGER P. WOODWARD.** *Surface Tension Measurements Using the Drop Shape Method*
- **PEI ; HEEGER.** *Science,* 1995, vol. 269, 1086-1088
- **WALDAUF et al.** *Appl. Phys. Lett.,* 2006, vol. 89, 233517
- **G. YU ; J. GAO ; J.C. HUMMELEN ; F. WUDL ; A.J. HEEGER.** *Science,* 1995, vol. 270, 1789
- **COAKLEY, K. M. ; MCGEHEE, M. D.** *Chem. Mater.,* 2004, vol. 16, 4533
- **M. FISCHER ; F. VÖGTLE.** *Angew. Chem., Int. Ed.,* 1999, vol. 38, 885